(19) Europäisches Patentamt
European Patent Office
Office européen des brevets

(11) EP 4 778 974 A1

(12) **EUROPEAN PATENT APPLICATION**
published in accordance with Art. 153(4) EPC

(43) Date of publication:
**22.07.2026 Bulletin 2026/30**

(21) Application number: **24865524.3**

(22) Date of filing: **12.09.2024**

(51) International Patent Classification (IPC):
***C08L 25/02*** $^{(2006.01)}$ ***B32B 15/08*** $^{(2006.01)}$
***C08F 257/00*** $^{(2006.01)}$ ***C08F 290/06*** $^{(2006.01)}$
***C08F 299/02*** $^{(2006.01)}$ ***C08G 65/48*** $^{(2006.01)}$
***C08J 5/24*** $^{(2006.01)}$ ***C08L 53/02*** $^{(2006.01)}$
***C08L 101/00*** $^{(2006.01)}$ ***H05K 1/03*** $^{(2006.01)}$

(52) Cooperative Patent Classification (CPC):
**B32B 15/08; C08F 257/00; C08F 290/06; C08F 299/02; C08G 65/48; C08J 5/24; C08L 25/02; C08L 53/02; C08L 101/00; H05K 1/03**

(86) International application number:
**PCT/JP2024/032722**

(87) International publication number:
**WO 2025/058024 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **13.09.2023 JP 2023148176**
**22.04.2024 JP 2024069049**
**31.07.2024 JP 2024124393**

(71) Applicant: **MITSUBISHI GAS CHEMICAL COMPANY, INC.**
**Chiyoda-ku**
**Tokyo 100-8324 (JP)**

(72) Inventors:
- **MIYAMOTO Makoto**
  **Tokyo 125-8601 (JP)**
- **FUTAMURA Keisuke**
  **Tokyo 125-8601 (JP)**
- **HIGASHITA Kazuyuki**
  **Tokyo 125-8601 (JP)**
- **HIDA Kenji**
  **Tokyo 125-8601 (JP)**

(74) Representative: **Müller-Boré & Partner Patentanwälte PartG mbB**
**Friedenheimer Brücke 21**
**80639 München (DE)**

(54) **RESIN COMPOSITION, CURED PRODUCT, PREPREG, METAL FOIL-CLAD LAMINATED SHEET, COMPOSITE RESIN SHEET, PRINTED WIRING BOARD, AND SEMICONDUCTOR DEVICE**

(57) Disclosed is a resin composition including a resin (A) represented by Formula (T1-1), a thermoplastic elastomer (B), and a thermosetting compound (C) other than the resin (A), in which, in the resin (A), a parameter β calculated from Equation (β) is 0.20 or more and 3.00 or less. In Formula (T1-1), R is a group including a structural unit represented by Formula (Tx). Expressions in parentheses in Equation (β) indicate integral values between corresponding chemical shift values in $^1$H-NMR. Disclosed are a cured product using the resin composition, a prepreg, a metal foil-clad laminate, a resin composite sheet, a printed wiring board, and a semiconductor device.

EP 4 778 974 A1

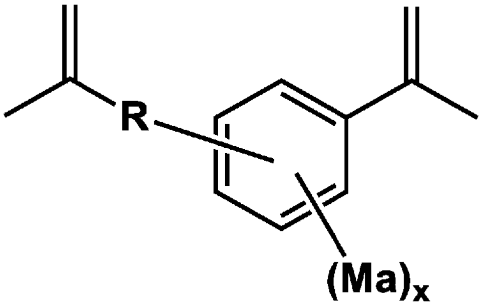

**(T1-1)**

$$\text{PARAMETER } \beta = \frac{\{(5.49ppm \text{ to } 4.89ppm)-(4.89ppm \text{ to } 4.45ppm)\}\times 1.5}{(2.31ppm \text{ to } 1.96ppm)-(2.55ppm \text{ to } 2.31ppm)} \quad (\beta)$$

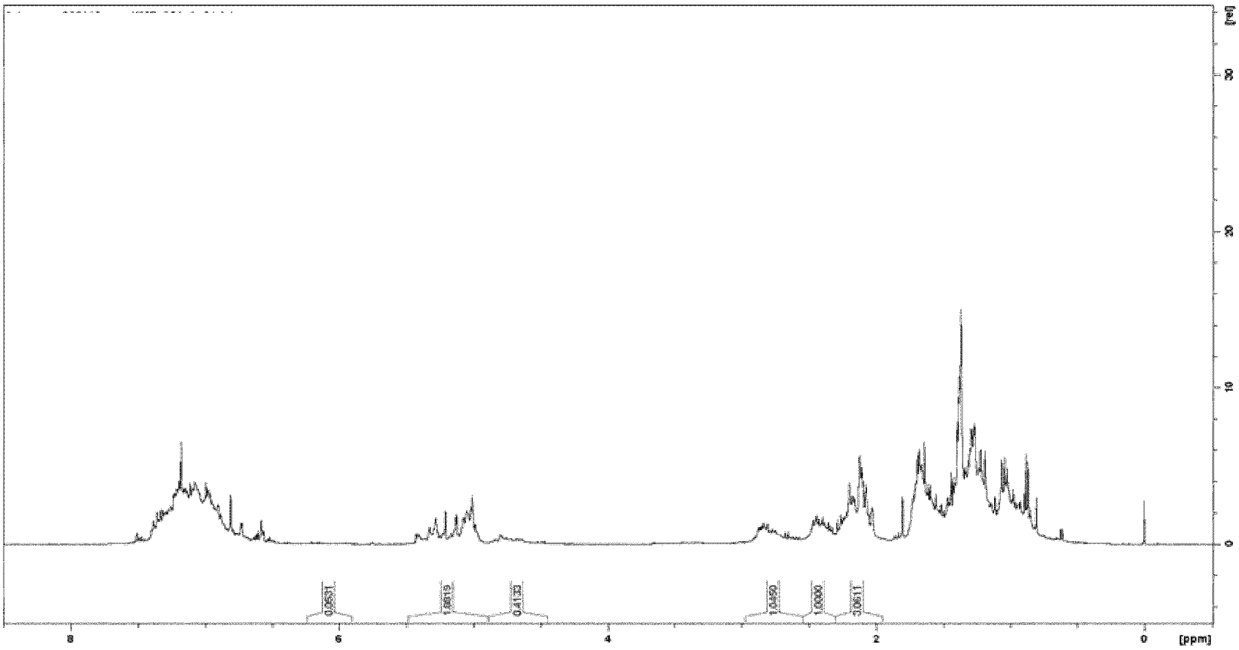


FIG. 1

## Description

### Technical Field

The present invention relates to a resin composition, a cured product, a prepreg, a metal foil-clad laminate, a resin composite sheet, a printed wiring board, and a semiconductor device.

### Background Art

In recent years, a trend for higher integration and finer configuration has been accelerated for semiconductor devices that are used in electronic devices and communication devices, including mobile terminals. Along with this trend, a technology that enables high-density mounting of semiconductor devices is required, and an improvement is also required for printed wiring boards, which hold an important role in the technology.

On the other hand, applications of electronic devices are diversified and continuously expanding. Accordingly, properties required for printed wiring boards, and metal foil-clad laminates, prepregs, and the like used in the printed wiring boards have also been diversified, and the requirements have become more demanding. To obtain improved printed wiring boards in consideration of such requirements, various materials and processing methods have been proposed. One of these includes development to improve a resin material included in a prepreg or a resin composite sheet.

Patent Document 1 discloses a resin having an isopropenylphenyl group at a terminal and an indane skeleton as a material suitable for a semiconductor sealing material and a printed wiring board.

### Citation List

### Patent Document

Patent Document 1: JP 2021-143333 A

### Summary of Invention

### Technical Problem

However, when the resin having an indane skeleton described in Patent Document 1 is used as it is, the resin is not sufficiently cured, and there is a problem in moldability of a cured product. Thus, it is desired to blend another thermosetting compound. When a resin composition containing such a resin having an indane skeleton and another thermosetting compound is used for an insulating layer of a printed wiring board, low dielectric properties (Dk and/or Df) are required. In addition, peel strength is also required.

Under such circumstances, an object of the present invention is to provide a resin composition containing such a resin having an indane skeleton and another thermosetting compound, the resin composition being excellent in moldability and capable of providing a cured product having excellent low dielectric properties (Dk and/or Df) and high peel strength, and a cured product, a prepreg, a metal foil-clad laminate, a resin composite sheet, a printed wiring board, and a semiconductor device.

### Solution to Problem

In view of the above problems, the present inventor has conducted studies, and resultantly found that the above problems can be solved by blending a thermoplastic elastomer in a resin composition containing a resin having an indane skeleton and another thermosetting compound.

Specifically, the above-described problems have been solved by the following means.

<1> A resin composition including:

a resin (A) represented by Formula (T1-1);
a thermoplastic elastomer (B); and
a thermosetting compound (C) other than the resin (A),
where, in the resin (A), a parameter $\beta$ calculated from Equation ($\beta$) is 0.20 or more and 3.00 or less,

[Chem.1]

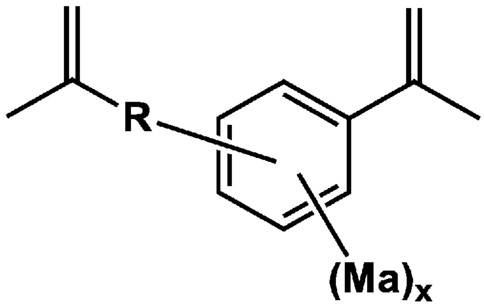

(T1-1)

(where R is a group including a structural unit represented by Formula (Tx), each Ma independently represents a hydrocarbon group having from 1 to 12 carbon atoms, each carbon atom being optionally substituted with a halogen atom, x is an integer of from 0 to 4.)

[Chem.2]

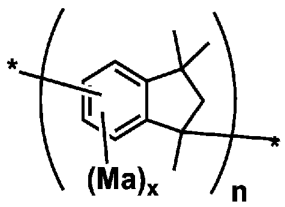

(a)

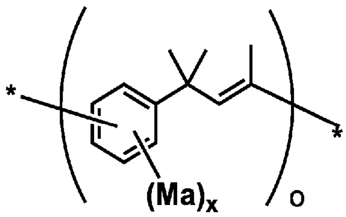

(b)

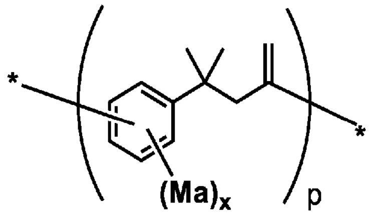

(c)

(Tx)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, and the structural units (a), (b), and (c) are each bonded to the structural unit (a), (b), or (c), or an additional group by *, and structural units are optionally randomly bonded.)

[Num.1]

$$\text{PARAMETER } \beta = \frac{\{(5.49ppm \text{ to } 4.89ppm) - (4.89ppm \text{ to } 4.45ppm)\} \times 1.5}{(2.31ppm \text{ to } 1.96ppm) - (2.55ppm \text{ to } 2.31ppm)} \qquad (\beta)$$

(where expressions in parentheses indicate integral values between corresponding chemical shift values in $^1$H-NMR.)

<2> The resin composition according to <1>, where, in the resin (A), a parameter $\alpha$ calculated from Equation ($\alpha$) is 0.55 or more and 1.00 or less,

[Num.2]

$$\text{PARAMETER } \alpha = \frac{(2.55ppm \text{ to } 2.31ppm)}{(6.24ppm \text{ to } 5.91ppm) + (2.98ppm \text{ to } 2.55ppm)/2 + (2.55ppm \text{ to } 2.31ppm)} \qquad (\alpha)$$

(where expressions in parentheses indicate integral values between corresponding chemical shift values in $^1$H-NMR.)

<3> The resin composition according to <1> or <2>, where, in the resin (A), the parameter $\alpha$ calculated from Equation ($\alpha$) is 0.60 or more and 1.00 or less, and the parameter $\beta$ calculated from Equation ($\beta$) is 0.40 or more and 3.00 or less.

<4> The resin composition according to any one of <1> to <3>, where the structural unit represented by Formula (Tx) satisfies $1.1 \leq n + o + p \leq 20.0$.

<5> The resin composition according to any one of <1> to <4>, where a number average molecular weight of the resin (A) is from 400 to 3000.

<6> The resin composition according to any one of <1> to <5>, where a weight average molecular weight of the resin (A) is from 500 to 6000.

<7> The resin composition according to any one of <1> to <6>, where Mw/Mn is a ratio of a weight average molecular weight of the resin (A) to a number average molecular weight of the resin (A), and is from 1.1 to 3.0.

<8> The resin composition according to any one of <1> to <7>, where the thermoplastic elastomer (B) includes at least one selected from the group consisting of a styrene monomer unit, a butadiene monomer unit, an isoprene monomer unit, a hydrogenated butadiene monomer unit, and a hydrogenated isoprene monomer unit.

<9> The resin composition according to any one of <1> to <8>, where the thermoplastic elastomer (B) includes a styrene monomer unit, a hydrogenated butadiene monomer unit, and/or a hydrogenated isoprene monomer unit.

<10> The resin composition according to any one of <1> to <9>, where a number average molecular weight of the thermoplastic elastomer (B) is 2000 or more.

<11> The resin composition according to any one of <1> to <10>, where the thermoplastic elastomer (B) is included in a proportion of from 2.5 to 50 parts by mass with respect to 100 parts by mass of a resin solid content in the resin composition.

<12> The resin composition according to any one of <1> to <11>, where the thermosetting compound (C) includes at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, a compound having an indane skeleton having a carbon-carbon unsaturated double bond at a terminal other than the resin (A), an epoxy compound, a phenolic compound, an oxetane compound, a benzoxazine compound, a cyanate ester compound, and a compound having a vinylene group,

[Chem.3]

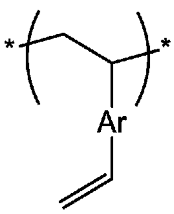

(V)

(where Ar represents an aromatic hydrocarbon linking group; and * represents a bonding position.)

<13> The resin composition according to any one of <1> to <12>, where the thermosetting compound (C) includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP),

[Chem.4]

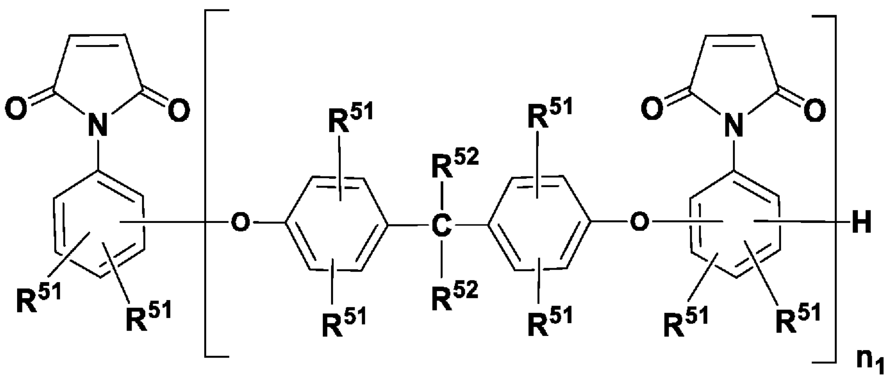

(M0)

(where each $R^{51}$ independently represents a hydrogen atom, an alkyl group having from 1 to 8 carbon atoms, or a phenyl group; and each $R^{52}$ independently represents a hydrogen atom or a methyl group; and $n_1$ represents an integer of 1 or more.)

[Chem.5]

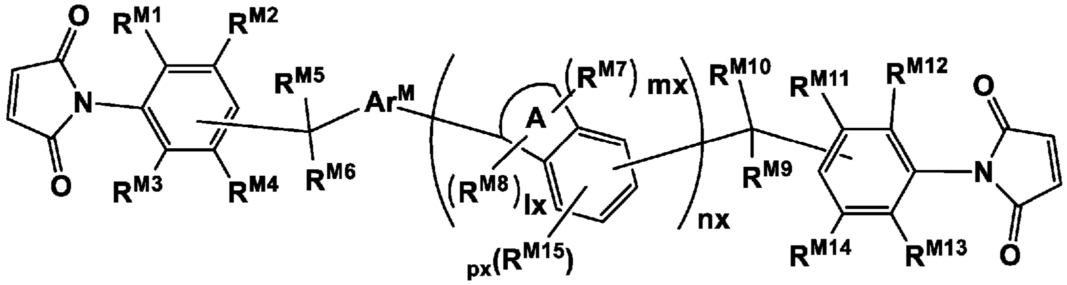

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.6]

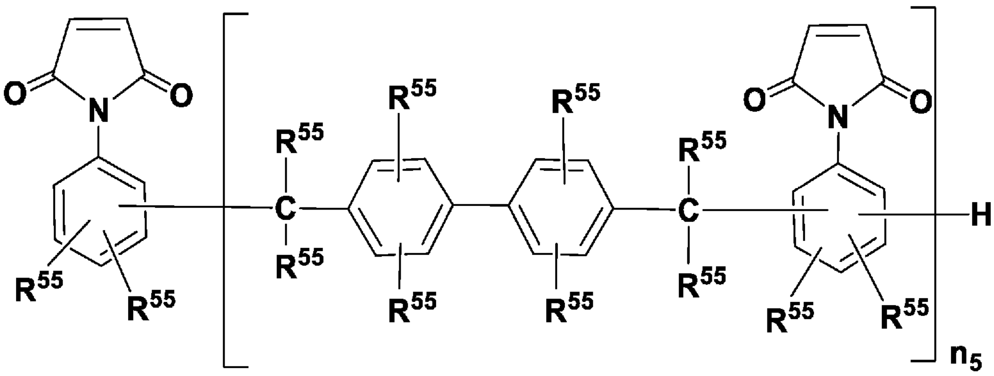

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.7]

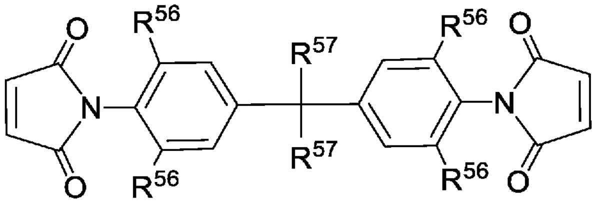

(M4)

(where each $R^{56}$ independently represents a hydrogen atom, a methyl group, or an ethyl group, and each $R^{57}$ independently represents a hydrogen atom or a methyl group.)

[Chem.8]

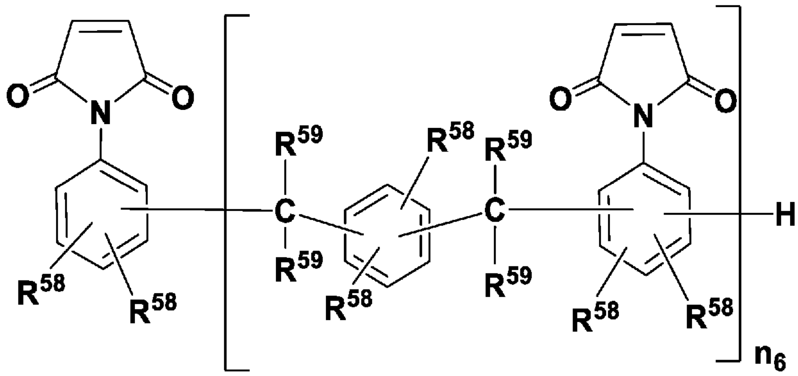

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.9]

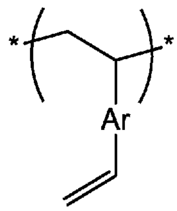

(V)

(where Ar represents an aromatic hydrocarbon linking group, and * represents a bonding position.)

[Chem.10]

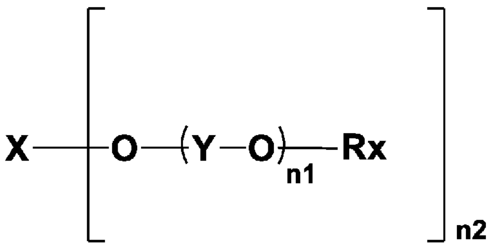

(OP)

(where X represents an aromatic group; $-(Y-O)_{n1}-$ represents a polyphenylene ether structure; n1 represents an integer of from 1 to 100; n2 represents an integer of from 1 to 4, Rx is a group represented by Formula (Rx-1) or Formula (Rx-2).)

[Chem.11]

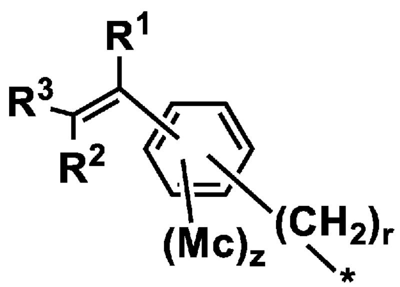

(Rx-1)

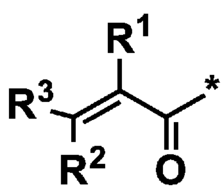

(Rx-2)

(where $R^1$, $R^2$, and $R^3$ each independently represent a hydrogen atom, an alkyl group, an alkenyl group, or an alkynyl

group, * is a bonding position for an oxygen atom, each Mc independently represents a hydrocarbon group having from 1 to 12 carbon atoms, z represents an integer of from 0 to 4, and r represents an integer of from 0 to 6.)

<14> The resin composition according to any one of <1> to <13>, where from 1 to 90 parts by mass of the resin (A) and from 5 to 90 parts by mass of the thermosetting compound (C) are included with respect to 100 parts by mass of the resin solid content in the resin composition.

<15> The resin composition according to any one of <1> to <14>, where, in the resin (A), the parameter $\alpha$ calculated from the Equation ($\alpha$) is 0.60 or more and 1.00 or less,

the parameter $\beta$ calculated from the Equation ($\beta$) is 0.40 or more and 3.00 or less,
the structural unit represented by the Formula (Tx)satisfies $1.1 \leq n + o + p \leq 20.0$,
a number average molecular weight of the resin (A) is from 400 to 3000,
a weight average molecular weight of the resin (A) is from 500 to 6000,
Mw/Mnh is a ratio of the weight average molecular weight of the resin (A) to the number average molecular weight of the resin (A), and is from 1.1 to 3.0,
the thermoplastic elastomer (B) includes a styrene monomer unit, a hydrogenated butadiene monomer unit, and/or a hydrogenated isoprene monomer unit,
a number average molecular weight of the thermoplastic elastomer (B) is 2000 or more,
the thermoplastic elastomer (B) is included in a proportion of from 2.5 to 50 parts by mass with respect to 100 parts by mass of the resin solid content in the resin composition,
the thermosetting compound (C) includes at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, a compound having an indane skeleton having a carbon-carbon unsaturated double bond at a terminal other than the resin (A), an epoxy compound, a phenolic compound, an oxetane compound, a benzoxazine compound, a cyanate ester compound, and a compound having a vinylene group, and
from 1 to 90 parts by mass of the resin (A) and from 5 to 90 parts by mass of the thermosetting compound (C) are included with respect to 100 parts by mass of the resin solid content in the resin composition,
[Num.3]

$$\text{PARAMETER}\ \alpha = \frac{(2.55ppm\ \text{to}\ 2.31ppm)}{(6.24ppm\ \text{to}\ 5.91ppm)+(2.98ppm\ \text{to}\ 2.55ppm)/2+(2.55ppm\ \text{to}\ 2.31ppm)} \quad (\alpha)$$

(where expressions in parentheses indicate integral values between corresponding chemical shift values in $^1$H-NMR.)
[Num.4]

$$\text{PARAMETER}\ \beta = \frac{\{(5.49ppm\ \text{to}\ 4.89ppm)-(4.89ppm\ \text{to}\ 4.45ppm)\}\times 1.5}{(2.31ppm\ \text{to}\ 1.96ppm)-(2.55ppm\ \text{to}\ 2.31ppm)} \quad (\beta)$$

(where expressions in parentheses indicate integral values between corresponding chemical shift values in $^1$H-NMR.)

[Chem.12]

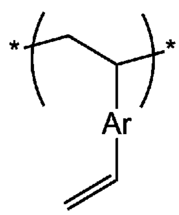

(V)

(where Ar represents an aromatic hydrocarbon linking group; and * represents a bonding position.)

<16> The resin composition according to <15>, where the thermosetting compound (C) includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by

Formula (OP),

[Chem.13]

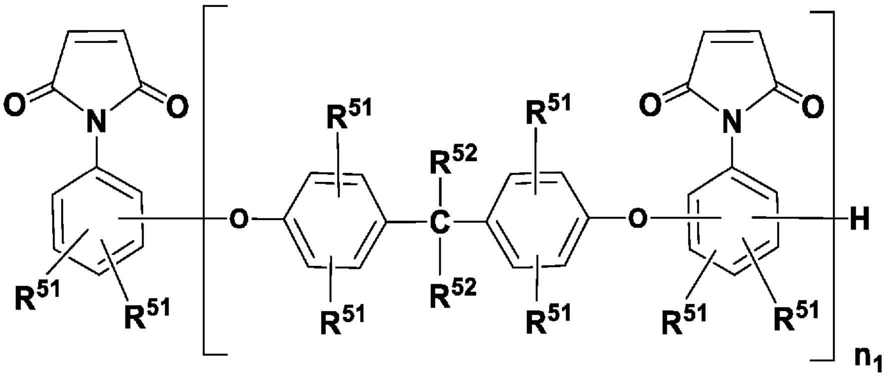

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.14]

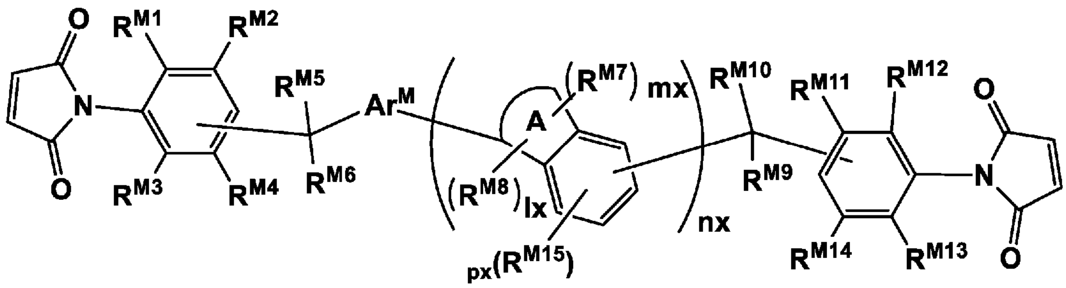

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.15]

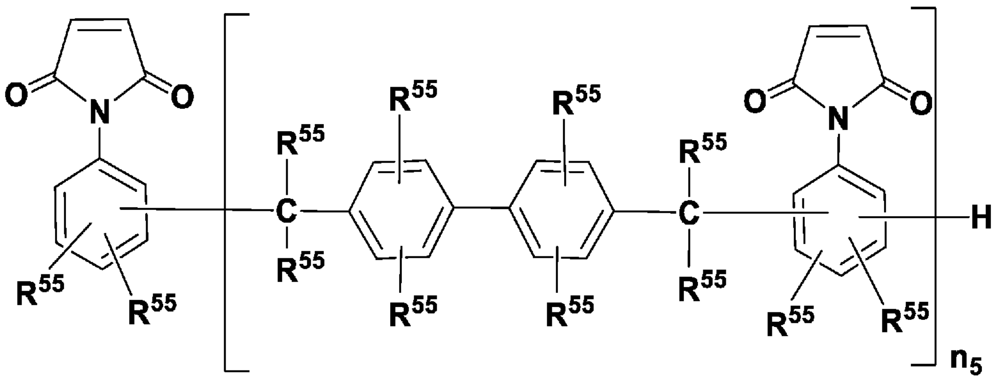

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.16]

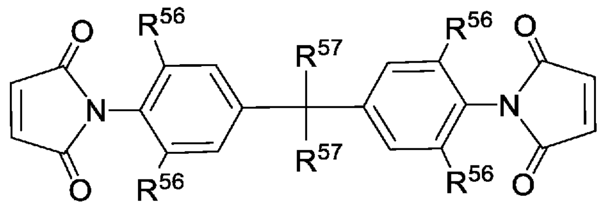

(M4)

(where each $R^{56}$ independently represents a hydrogen atom, a methyl group, or an ethyl group, and each $R^{57}$ independently represents a hydrogen atom or a methyl group.)

[Chem.17]

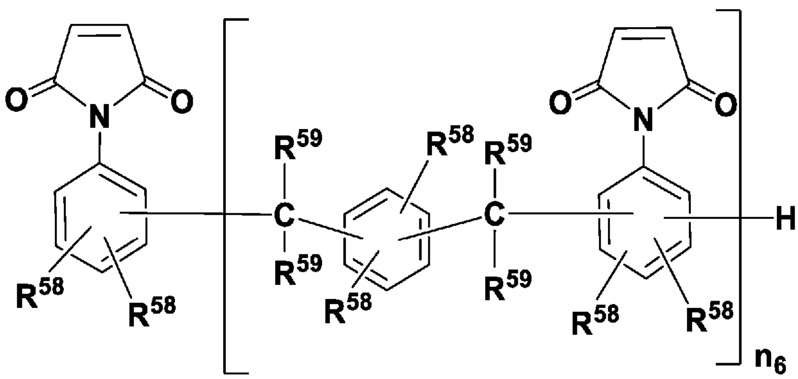

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.18]

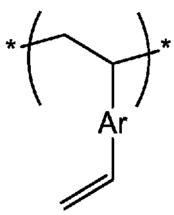

(V)

(where Ar represents an aromatic hydrocarbon linking group, and * represents a bonding position.)

[Chem.19]

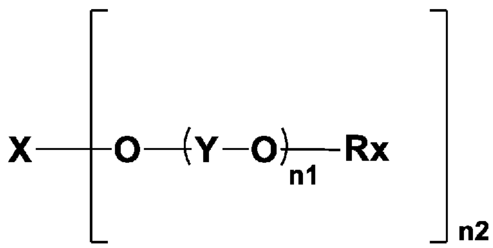

(OP)

(where X represents an aromatic group; $-(Y-O)_{n1}-$ represents a polyphenylene ether structure; n1 represents an

integer of from 1 to 100; and n2 represents an integer of from 1 to 4, Rx is a group represented by Formula (Rx-1) or Formula (Rx-2).)

[Chem.20]

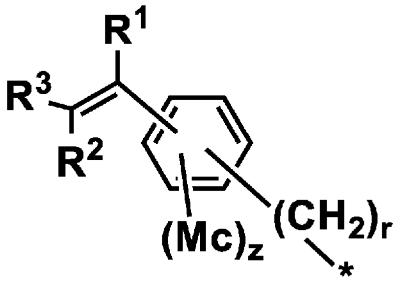

(Rx-1)

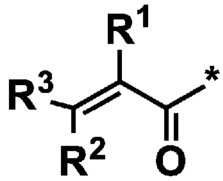

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

<17> The resin composition according to any one of <1> to <16>, further including a flame retardant.

<18> The resin composition according to any one of <1> to <17>, further including a filler.

<19> The resin composition according to <18>, where a content of the filler is from 10 to 1600 parts by mass with respect to 100 parts by mass of the resin solid content in the resin composition.

<20> The resin composition according to any one of <1> to <19>, further including a curing accelerator.

<21> The resin composition according to <20>, where a content of the curing accelerator is from 0.1 to 0.8 parts by mass with respect to 100 parts by mass of a resin solid content in the resin composition.

<22> A cured product of the resin composition described in any one of <1> to <21>.

<23> A prepreg including a substrate and the resin composition described in any one of <1> to <21>.

<24> A metal foil-clad laminate including at least one layer formed from the prepreg described in <23> and a metal foil disposed on one side or both sides of the layer formed from the prepreg.

<25> A resin composite sheet including: a support; and a layer disposed on a surface of the support, the layer being formed from the resin composition described in any one of <1> to <21>.

<26> A printed wiring board including an insulating layer and a conductor layer disposed on a surface of the insulating layer, where the insulating layer includes a layer formed from the resin composition described in any one of <1> to <21>.

<27> A semiconductor device including the printed wiring board described in <26>.

Advantageous Effects of Invention

The present invention has made it possible to provide a resin composition excellent in moldability and capable of providing a cured product excellent in low dielectric properties (Dk and/or Df) and having high peel strength, a cured product, a prepreg, a metal foil-clad laminate, a resin composite sheet, a printed wiring board, and a semiconductor device.

Brief Description of Drawings

[FIG. 1] illustrates an NMR chart of a resin obtained in Synthesis Example 1.

Description of Embodiments

Embodiments for carrying out the present invention (hereinafter referred to simply as "the present embodiment") will next be described in detail. The present embodiment described below is an example for describing the present invention, and the present invention is not limited only to the present embodiment.

In the present specification, numerical values described before and after the term "to" are respectively the lower limit and the upper limit of a range including the numerical values.

In the present specification, various physical property values and characteristic values are those at 23°C unless otherwise noted.

In a description of a group (atomic group) in the present specification, a description not specifying whether the group is a substituted group or an unsubstituted group is meant to include a group (atomic group) having a substituent as well as a group (atomic group) having no substituent. For example, an "alkyl group" includes not only an alkyl group having

no substituent (unsubstituted alkyl group) but also an alkyl group having a substituent (substituted alkyl group). In the present specification, a description not specifying whether the group is a substituted group or an unsubstituted group means that the group is preferably an unsubstituted group.

In the present specification, a (meth)allyl group represents both or either of allyl and methallyl, a "(meth)acrylate" represents both or either of acrylate and methacrylate, a "(meth)acryl" represents both or either of acryl and methacryl, and a "(meth)acryloyl" represents both or either of acryloyl and methacryloyl.

The term "step" as used herein includes not only an independent step but also a step that cannot be clearly distinguished from other steps as long as an intended action of the step is achieved.

When the measurement methods or the like described in the standards described in the present specification differ depending on the year, the measurement methods or the like are based on the standards as of January 1, 2023, unless otherwise noted.

In the present specification, a resin solid content refers to a component excluding a filler and a solvent and is intended to include a resin (A), a thermoplastic elastomer (B), a thermosetting compound (C), an additional compound blended as necessary, and a resin additive component (an additive such as a curing accelerator or a flame retardant).

As used herein, the terms "relative permittivity" and "permittivity" are used with the same meaning.

The resin composition of the present embodiment includes the resin (A) (in the present specification, it may be simply referred to as the "resin (A)") represented by Formula (T1-1), the thermoplastic elastomer (B), and the thermosetting compound (C) other than the resin (A), in which, in the resin (A), a parameter β calculated from Equation (β) is 0.20 or more and 3.00 or less.

[Chem.21]

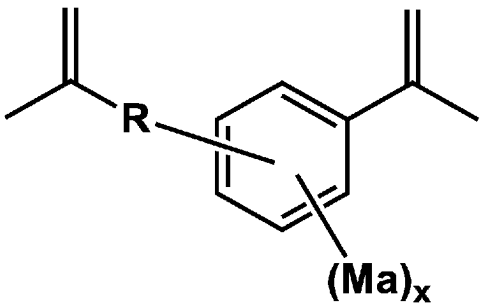

(T1-1)

(In Formula (T1-1), R is a group containing a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.22]

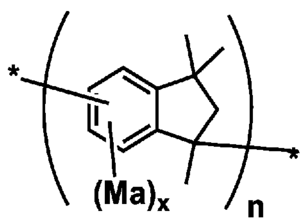

(a)

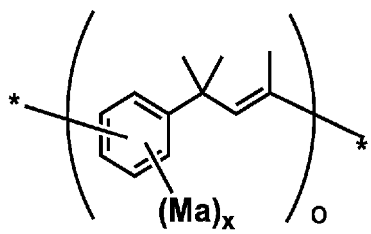

(b)

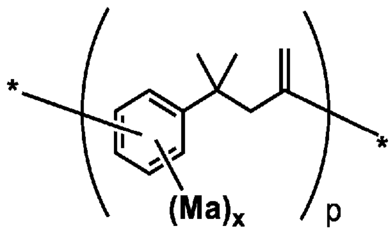

(c)

(Tx)

(In Formula (Tx), n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, the structural units (a), (b), and (c) are each bonded to the structural unit (a), (b), or (c), or an additional group by *, and structural units may be randomly bonded.)

[Num.5]

$$\text{PARAMETER } \beta = \frac{\{(5.49ppm \text{ to } 4.89ppm) - (4.89ppm \text{ to } 4.45ppm)\} \times 1.5}{(2.31ppm \text{ to } 1.96ppm) - (2.55ppm \text{ to } 2.31ppm)} \quad (\beta)$$

(Expressions in parentheses in Equation (β) indicate integral values between corresponding chemical shift values in $^1$H-NMR.)

Such a configuration makes it possible to provide a resin composition which is excellent in moldability and can provide a cured product having excellent low dielectric properties (Dk and/or Df) and high peel strength.

The present inventors have found the possibility that the resin (A) having an indane skeleton can provide a cured product excellent in low dielectric properties (Dk and/or Df), and have also found that the resin (A) having an indane skeleton alone is not sufficiently cured. In the present embodiment, by blending the thermosetting compound (C), the curing of the resin composition containing the resin (A) having an indane skeleton and the thermosetting compound (C) can be effectively progressed, and the moldability has been successfully improved. However, even when the resin composition containing the resin (A) having an indane skeleton and the thermosetting compound (C) can be cured, a cured product excellent in low dielectric properties (Dk and/or Df) and peel strength is further required.

In the present embodiment, in order to achieve low dielectric properties (Dk and/or Df) and high peel strength, a predetermined resin is used as the resin (A) having an indane skeleton, and one having a parameter β of 0.20 or more and 3.00 or less is used. The resin (A) thus configured has a large terminal double bond ratio, that is, a relatively large number of components having a small functional group equivalent. In the present embodiment, it is presumed that a component having a small functional group equivalent of the resin (A) reacts with an unreacted double bond in the resin (A) and/or the thermosetting compound (C) to sufficiently cure the cured product. As a result, it is presumed that a cured product excellent in low dielectric properties (Dk and/or Df) and peel strength is obtained regardless of the type of the thermosetting compound (C).

In addition, in the present embodiment, the thermoplastic elastomer (B) is blended. Since the thermoplastic elastomer has a soft component having high thermal mobility, it is assumed that a collision probability of the functional group remaining at a late stage of a curing reaction increases, and the functional group remaining in a final product (cured product) decreases, thereby improving the dielectric properties. In addition, since the thermoplastic elastomer (B) has good compatibility with the resin (A) having an indane skeleton and the thermosetting compound (C), it is presumed that the low dielectric properties can also be achieved by forming a so-called semi-IPN structure (semi-interpenetrating polymer network) in which the thermoplastic elastomer (B) penetrates into a network structure of the cured product of the resin (A) having an indane skeleton and the thermosetting compound (C).

<Resin (A) represented by Formula (T1-1)>

The resin composition of the present embodiment contains the resin (A) represented by Formula (T1-1), in which the parameter β calculated from Equation (β) is 0.20 or more and 3.00 or less. Formula (T1-1) is preferably represented by Formula (T1-2).

[Chem.23]

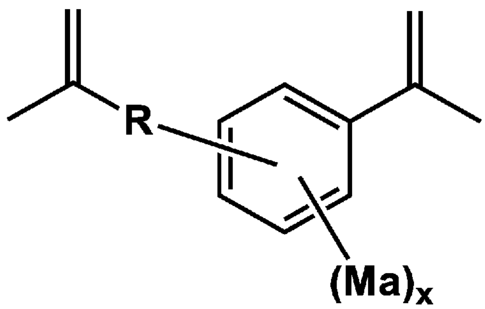

(T1-1)

(In Formula (T1-1), R is a group containing a structural unit represented by Formula (Tx). each Ma independently represents a hydrocarbon group having from 1 to 12 carbon atoms, each carbon atom being optionally substituted with a halogen atom. x is an integer of from 0 to 4.)

[Chem.24]

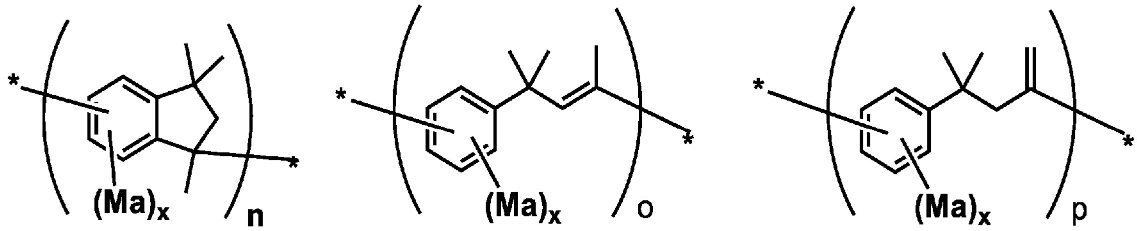

(Tx)

(a) (b) (c)

(In Formula (Tx), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded to the structural unit (a), (b), or (c), or an additional group by *, and structural units may be randomly bonded.)

[Num.6]

$$\text{PARAMETER } \beta = \frac{\{(5.49ppm \text{ to } 4.89ppm) - (4.89ppm \text{ to } 4.45ppm)\} \times 1.5}{(2.31ppm \text{ to } 1.96ppm) - (2.55ppm \text{ to } 2.31ppm)} \qquad (\beta)$$

(Expressions in parentheses in Equation (β) indicate integral values between corresponding chemical shift values in $^1$H-NMR.)

In Formula (T1-1), each Ma is independently preferably a hydrocarbon group having from 1 to 10 carbon atoms, each carbon atom being optionally substituted with a halogen atom, more preferably a hydrocarbon group having from 1 to 5 carbon atoms, each carbon atom being optionally substituted with a halogen atom, and still more preferably a hydrocarbon group having from 1 to 3 carbon atoms, each carbon atom being optionally substituted with a halogen atom. Examples of the halogen atom include a fluorine atom, a chlorine atom, and a bromine atom. A fluorine atom or a chlorine atom is preferred. Each Ma is preferably independently a hydrocarbon group having from 1 to 12 carbon atoms, which are not substituted with halogen atoms. The hydrocarbon group is preferably an alkyl group, and more preferably a linear alkyl group. Ma is particularly preferably a methyl group or an ethyl group.

In Formula (T1-1), x is preferably an integer of from 0 to 3, more preferably an integer of from 0 to 2, still more preferably 0 or 1, and even more preferably 0.

[Chem.25]

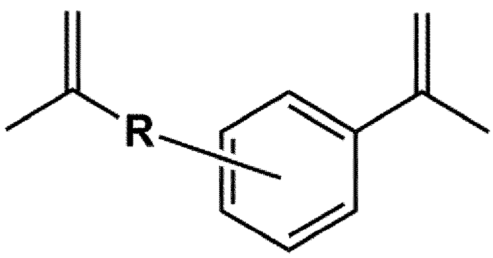

(T1-1-2)

(In Formula (T1-1-2), R is a group containing a structural unit represented by Formula (Tx).)

[Chem.26]

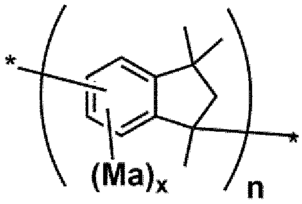
(a)

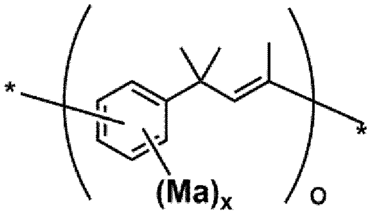
(b)

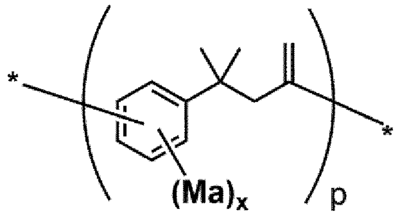
(c)

(Tx)

(In Formula (Tx), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded to the structural unit (a), (b), or (c), or an additional group by *, and structural units may be randomly bonded.)

In Formula (Tx), n, o, and p each mean an average number of repeating units in all molecules in the resin.

In Formula (Tx), the sum of n, o, and p is preferably $1.1 \leq n + o + p$, more preferably $1.2 \leq n + o + p$, still more preferably $1.5 \leq n + o + p$, even more preferably $2.0 \leq n + o + p$, further more preferably $2.5 \leq n + o + p$, still further more preferably $3.0 \leq n + o + p$, and particularly preferably $3.3 \leq n + o + p$. In Formula (Tx), the sum of n, o, and p is preferably $n + o + p \leq 20.0$, more preferably $n + o + p \leq 10.0$, still more preferably $n + o + p \leq 8.0$, even more preferably $n + o + p \leq 7.0$, and further more preferably $n + o + p \leq 6.4$. The sum of n, o, and p can be calculated by the method described in Examples described later.

In Formula (Tx), Ma and x have the same meanings as Ma and x in Formula (T1-1), respectively, and preferred ranges thereof are also the same.

The resin (A) may contain a structural unit represented by Formula (Ty).

[Chem.27]

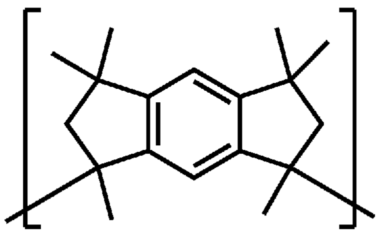

(Ty)

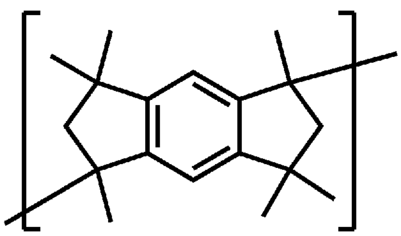

As the resin (A), in addition to the above, the resin described in paragraphs 0011 to 0025 of WO 2023/176766, the resin described in paragraphs 0012 to 0033 of WO 2023/176763, the resin described in paragraphs 0026 to 0043 of WO 2023/176765, the compound described in JP 2023-104785 A, and the composition described in JP 2024-007493 A can be taken into consideration, the contents of which are incorporated herein by reference.

The resin represented by Formula (T1-1) (preferably, the resin represented by Formula (T1-1-2)) preferably has a parameter $\alpha$ calculated from Equation ($\alpha$) of 0.30 or more and 1.00 or less. By setting the parameters $\alpha$ and $\beta$ within the above ranges, the resulting cured product tends to have excellent low dielectric properties (Dk and/or Df) and excellent

thermal resistance.
[Num.7]

$$\text{PARAMETER } \alpha = \frac{(2.55ppm \text{ to } 2.31ppm)}{(6.24ppm \text{ to } 5.91ppm)+(2.98ppm \text{ to } 2.55ppm)/2+(2.55ppm \text{ to } 2.31ppm)} \quad (\alpha)$$

(Expressions in parentheses in Equation ($\alpha$) indicate integral values between corresponding chemical shift values in $^1$H-NMR.)

Here, $\alpha$ represents a proportion of the structural unit having an indane skeleton (the structural unit (a) in Formula (Tx)) in the resin represented by Formula (T1-1) (preferably, the resin represented by Formula (T1-1-2)). More specifically, it is presumed that rigidity of the resulting resin molecule is high and a glass transition temperature can be increased by adjusting the structural unit having an indane skeleton so as to satisfy the range of the parameter $\alpha$. In addition, it is presumed that since a molecule having high rigidity has lower mobility than a molecule having low rigidity, a relaxation time at the time of dielectric relaxation becomes longer, and Df can be lowered. When the resin represented by Formula (T1-1) is synthesized, $\alpha$ can be increased by conditions such as decreasing the concentration of a raw material, using a high-polarity solvent, increasing the catalyst amount, and increasing reaction temperature.

Meanwhile, $\beta$ defines the proportion of terminal double bonds in the resin represented by Formula (T1-1) (preferably, the resin represented by Formula (T1-1-2)). More specifically, for example, it is presumed that the number of crosslinking points with a functional group of the thermosetting compound (C) described in detail below increases, a network is easily formed at the time of thermal curing, and a cured product having a high glass transition temperature and a low Df is obtained. When the resin represented by Formula (T1-1) is synthesized, $\beta$ can be increased by controlling conditions, such as decreasing the catalyst amount, decreasing reaction temperature, and using a low-polarity solvent.

In synthesizing the resin represented by Formula (T1-1) (preferably, the resin represented by Formula (T1-1-2)), the parameters $\alpha$ and $\beta$ of the resin represented by Formula (T1-1) (preferably, the resin represented by Formula (T1-1-2)) can be adjusted using the method of increasing the parameters $\alpha$ and $\beta$ described above. Needless to say, the parameters $\alpha$ and $\beta$ may be adjusted by a method other than that described above.

The parameter $\alpha$ is preferably 0.35 or more, more preferably 0.40 or more, still more preferably 0.45 or more, even more preferably 0.50 or more, further more preferably 0.55 or more, and may be 0.57 or more, 0.59 or more, 0.60 or more, 0.62 or more, 0.65 or more, 0.70 or more, 0.75 or more, or 0.80 or more. When the parameter $\alpha$ is the above lower limit or more, the thermal resistance of the resulting cured product tends to be further improved. The parameter $\alpha$ is preferably large because the resulting cured product tends to have substantially excellent low dielectric properties (Dk and/or Df) and thermal resistance. However, the parameter $\alpha$ may be 1.00 or less, 0.95 or less, 0.90 or less, 0.85 or less, 0.82 or less, 0.80 or less, 0.77 or less, 0.75 or less, or 0.74 or less.

The parameter $\beta$ is preferably 0.25 or more, more preferably 0.30 or more, still more preferably 0.35 or more, yet still more preferably 0.40 or more, yet still more preferably 0.43 or more, and yet still more preferably 0.50 or more, and may be 0.60 or more, 0.65 or more, 0.70 or more, 0.77 or more, 0.80 or more, 0.90 or more, or 0.95 or more. When the parameter is the above lower limit or more, the thermal resistance of the resulting cured product tends to be improved, and Df tends to be lowered. The parameter $\beta$ is preferably 2.80 or less, more preferably 2.50 or less, still more preferably 2.00 or less, further more preferably 1.50 or less, even more preferably 1.30 or less, still further more preferably 1.20 or less, and yet still more preferably 1.10 or less, and may further be 1.00 or less, 0.95 or less, 0.90 or less, 0.85 or less, 0.83 or less, or 0.80 or less. When the parameter $\beta$ is the above upper limit or less, the resulting cured product tends to have improved thermal resistance and a low Df.

The resin (A) has an indane skeleton. There is no particular limitation as long as at least one molecule among the resin molecules contained in the resin (A) has at least one indane skeleton, and the number of indane skeletons in the resin molecule of the resin (A) is preferably 1 or more, and more preferably from 1 to 20 per molecule. With such a structure, the effect of the present invention tends to be more effectively exhibited.

The number average molecular weight (Mn) of the resin (A) measured by the GPC (gel permeation chromatography) method calibrated with polystyrene standards (the details are according to the method described in Examples described later) is preferably 400 or more, more preferably 500 or more, still more preferably 550 or more, yet still more preferably 600 or more, and yet still more preferably 650 or more. When the number average molecular weight is the above lower limit or more, the thermal resistance of the resulting cured product tends to be improved, and Df tends to be lowered. The upper limit of the number average molecular weight (Mn) of the resin (A) in terms of polystyrene by the GPC (gel permeation chromatography) method is preferably 3000 or less, more preferably 2500 or less, still more preferably 2000 or less, even more preferably 1500 or less, and further more preferably 1250 or less, and the upper limit may be 1000 or less or 800 or less depending on the intended use and the like. When the number average molecular weight is the above upper limit or less, the thermal resistance of the resulting cured product tends to be improved, and the relative permittivity (Dk) and the dielectric loss tangent (Df) tend to be lowered.

The weight average molecular weight (Mw) of the resin (A) in terms of polystyrene by the GPC (the details are according to the method described in Examples described later) is preferably 500 or more, more preferably 800 or more, still more preferably 900 or more, and even more preferably 1000 or more. When the weight average molecular weight is the above lower limit or more, the thermal resistance of the resulting cured product tends to be improved, and Df tends to be lowered. The upper limit of the weight average molecular weight (Mw) of the resin (A) in terms of polystyrene by the GPC (the details are according to the method described in Examples described later) is preferably 6000 or less, more preferably 5000 or less, still more preferably 4000 or less, even more preferably 3000 or less, and further more preferably 2800 or less, and the upper limit may be 2500 or less, 2000 or less, or 1500 or less depending on the intended use and the like. When the weight average molecular weight is the above upper limit or less, the resulting cured product tends to have improved thermal resistance, a low relative permittivity (Dk), and a low dielectric loss tangent (Df).

The resin (A) preferably has a Mw/Mn is the ratio of the weight average molecular weight to the number average molecular weight, and is from 1.1 to 3.0. The Mw/Mn of the resin (A) is more preferably 1.2 or more, still more preferably 1.3 or more, even more preferably 1.4 or more, further more preferably 1.5 or more, and still further more preferably 1.6 or more. The Mw/Mn of the resin (A) is more preferably 2.5 or less, still more preferably 2.4 or less, and may be 2.3 or less, 2.0 or less, or 1.8 or less.

The weight average molecular weight and the number average molecular weight are measured in accordance with methods described in Examples described later.

In the present embodiment, the functional group equivalent (isopropenyl group equivalent) of the resin (A) is preferably 100 g/eq. or more, more preferably 150 g/eq. or more, still more preferably 200 g/eq. or more, yet still more preferably 250 g/eq. or more, yet still more preferably 275 g/eq. or more, yet still more preferably 300 g/eq. or more, and is preferably 7500 eq. or less, more preferably 5000 eq. or less, still more preferably 4000 eq. or less, yet still more preferably 3000 g/eq. or less, yet still more preferably 2000 g/eq. or less, yet still more preferably 1500 g/eq. or less, particularly preferably 1000 g/eq., and further, it may be 800 g/eq. or less, 750 g/eq. or less, 700 g/eq. or less, or 500 g/eq or less. When the functional group equivalent of the resin (A) is the above lower limit or more, the resulting cured product tends to have more excellent low dielectric properties (Dk and/or Df, in particular Df), and the resulting cured product tends to have more excellent peel strength. When the functional group equivalent of the resin (A) is the above upper limit or less, the resulting cured product tends to have more excellent low dielectric properties (Dk and/or Df, in particular Df) and more excellent thermal resistance (in particular, the glass transition temperature). The functional group equivalent (isopropenyl group equivalent) of the resin (A) is determined according to the method described in Examples described later.

The content of the resin (A) in the resin composition of the present embodiment is preferably 1 part by mass or more, more preferably 5 parts by mass or more, and may be 10 parts by mass or more, with respect to 100 parts by mass of the resin solid content in the resin composition, or may be 12 parts by mass or more or 15 parts by mass or more, depending on the intended use and the like. When the content of the resin (A) is the above lower limit or more, the resulting cured product tends to have a low Df. The upper limit of the content of the resin (A) is preferably 90 parts by mass or less, more preferably 70 parts by mass or less, still more preferably 50 parts by mass or less, even more preferably 45 parts by mass or less, further more preferably 40 parts by mass or less, and particularly preferably 35 parts by mass or less, with respect to 100 parts by mass of the resin solid content in the resin composition, and may be 30 parts by mass or less or 25 parts by mass or less depending on the intended use and the like. When the content of the resin (A) is the above upper limit or less, the moldability of the resin composition and the thermal resistance of the resulting cured product tend to improve.

The resin composition of the present embodiment may contain only one type of resin (A) or may contain two or more types of resins (A). When two or more types of resins (A) are contained, the total amount is preferably in the range described above.

The method for producing the resin (A) of the present embodiment is not particularly limited, and a resin produced by a known production method can be used. When the resin (A) is synthesized, the raw material, the reaction temperature, the catalyst type, the catalyst amount, the reaction solvent, and the raw material concentration are not particularly limited, and they can be appropriately selected or controlled depending on the desired physical properties described above.

In the present embodiment, the raw material that can be used for synthesizing the resin (A) is, for example, m-bis($\alpha$-hydroxyisopropyl) benzene, p-bis($\alpha$-hydroxyisopropyl)benzene, 1,3-diisopropenylbenzene, and 1,4-diisopropenylbenzene.

<Thermoplastic elastomer (B)>

The resin composition of the present embodiment contains the thermoplastic elastomer (B). By containing the thermoplastic elastomer (B), the resulting cured product is excellent in low dielectric properties (Dk and/or Df) and excellent in peel strength.

The type and the like of the thermoplastic elastomer (B) used in the present embodiment are not particularly limited, and known thermoplastic elastomers can be widely used.

Examples of the thermoplastic elastomer (B) used in the present embodiment include at least one selected from

the group consisting of polyisoprene, polybutadiene, styrene-butadiene, butyl rubber, ethylene-propylene rubber, styrene-butadiene-ethylene, styrene-butadiene-styrene, styrene-isoprene-styrene, styrene-ethylene-butylene-styrene, styrene-propylene-styrene, styrene-ethylene-propylene-styrene, fluororubber, silicone rubber, their hydrogenated compounds, their alkyl compounds, and their copolymers, and two or more copolymers thereof are preferred.

The thermoplastic elastomer (B) used in the present embodiment may be a homopolymer or a copolymer. Examples of the thermoplastic elastomer (B) include oligomers or polymers having a curable vinyl functional group described in paragraphs 0044 and 0045 of JP 2019-194312 A, polybutadiene resins, a compound described in JP 2022-085610 A, and 1,2-SBS-L42 (liquid 1,2-SBS), 1,2-SBS-P35 (solid 1,2-SBS), and 1,2-H-SBS-partial hydrogenation available from Nippon Soda Co., Ltd., the contents of which are incorporated herein by reference.

When the thermoplastic elastomer (B) used in the present embodiment is a copolymer, it may be a random copolymer, a block copolymer, or a block copolymer having a random block.

More specifically, the thermoplastic elastomer (B) used in the present embodiment is preferably a thermoplastic elastomer containing at least one selected from the group consisting of a styrene monomer unit, a butadiene monomer unit, an isoprene monomer unit, a hydrogenated butadiene monomer unit, and a hydrogenated isoprene monomer unit, and more preferably an elastomer containing a styrene monomer unit and a hydrogenated butadiene monomer unit and/or a hydrogenated isoprene monomer unit.

As described above, the thermoplastic elastomer (B) in the present embodiment preferably contains a styrene monomer unit. When the styrene monomer unit is contained, the compatibility with the resin (A) and the thermosetting compound (C) tends to be excellent. Examples of the styrene monomer include styrene, $\alpha$-methylstyrene, p-methylstyrene, divinylbenzene (vinylstyrene), N,N-dimethyl-p-aminoethylstyrene, and N,N-diethyl-p-aminoethylstyrene. Of these, styrene, $\alpha$-methylstyrene, and p-methylstyrene are preferable from the viewpoint of availability and productivity. Among these, styrene is particularly preferred.

The content of the styrene monomer unit in the thermoplastic elastomer (B) in the present embodiment is preferably 0 mass% or more, more preferably 10 mass% or more, still more preferably 20 mass% or more, and even more preferably 30 mass% or more, and is preferably 90 mass% or less, more preferably 80 mass% or less, and still more preferably 70 mass% or less of all the monomer units of the thermoplastic elastomer (B). When the content of the styrene monomer unit is the above upper limit or less, adhesion and tackiness to a substrate or the like are further improved. When the content of the styrene monomer unit is the above lower limit or more, an increase in adhesiveness can be suppressed, an adhesive residue or a stop mark is less likely to occur, and easy release between adhesive faces tend to be improved, which is preferable.

The thermoplastic elastomer (B) may contain only one type of styrene monomer unit, or may contain two or more types of styrene monomer units. When two or more types are contained, a total amount thereof is preferably in the above range.

As for a method for measuring the content of the styrene monomer unit in the thermoplastic elastomer (B) used in the present embodiment, reference can be made to WO 2017/126469, the contents of which are incorporated in the present specification. The same shall apply to the butanediene monomer unit to be described later.

The thermoplastic elastomer (B) used in the present embodiment has a hydrogen-addition rate of preferably 50% or more, more preferably 70% or more, still more preferably 80% or more, even more preferably 85% or more, further more preferably 90% or more, and still further more preferably 95% or more. By using the thermoplastic elastomer having a high hydrogen-addition rate, the resulting cured product tends to have more excellent low dielectric properties (Dk and/or Df).

The thermoplastic elastomer having a high hydrogen-addition rate preferably contains a hydrogenated butadiene monomer unit and/or a hydrogenated isoprene monomer unit.

The thermoplastic elastomer (B) used in the present embodiment preferably also has a random copolymerization block (hereinafter, it may be simply referred to as a "random copolymerization block") containing a styrene monomer unit and at least one selected from the group consisting of a butadiene monomer unit, an isoprene monomer unit, a hydrogenated butadiene monomer unit, and a hydrogenated isoprene monomer unit. It is presumed that the random arrangement of such monomer units reduces a self-aggregation force of the styrene monomer unit in the molecular chain of the thermoplastic elastomer (B), thereby improving the flexibility of the thermoplastic elastomer (B).

The random copolymerization means that the arrangement of monomer units is disordered, and in the random copolymerization block, a styrene monomer unit and at least one selected from the group consisting of a butadiene monomer unit, an isoprene monomer unit, a hydrogenated butadiene monomer unit, and a hydrogenated isoprene monomer unit are randomly copolymerized.

The thermoplastic elastomer (B) used in the present embodiment may have, in addition to a random copolymerization block of a styrene monomer unit and at least one selected from the group consisting of a butadiene monomer unit, an isoprene monomer unit, a hydrogenated butadiene monomer unit, and a hydrogenated isoprene monomer unit, a polymerization block mainly composed of a styrene monomer unit and/or a polymerization block mainly composed of at least one selected from the group consisting of a butadiene monomer unit, an isoprene monomer unit, a hydrogenated butadiene monomer unit, and a hydrogenated isoprene monomer unit. Here, "mainly composed of" means that in the case

of a polymerization block mainly composed of a styrene monomer unit, the proportion of the styrene monomer unit in the polymerization block is 60 mass% or more, preferably 70 mass% or more, more preferably 80 mass% or more, still more preferably 90 mass% or more, and even more preferably 95 mass% or more. The same applies to a polymerization block mainly composed of at least one selected from the group consisting of a butadiene monomer unit, an isoprene monomer unit, a hydrogenated butadiene monomer unit, and a hydrogenated isoprene monomer unit.

In the thermoplastic elastomer (B) used in the present embodiment, a total of the styrene monomer unit, the butadiene monomer unit, the isoprene monomer unit, the hydrogenated butadiene monomer unit, and the hydrogenated isoprene monomer unit is preferably 90 mass% or more, more preferably 95 mass% or more, still more preferably 97 mass% or more, and even more preferably 99 mass% or more of all the monomer units. Here, it is sufficient that at least one of the butadiene monomer unit, the isoprene monomer unit, the hydrogenated butadiene monomer unit, and the hydrogenated isoprene monomer unit is contained, and it is not essential that all of these are contained.

In the present embodiment, a thermoplastic elastomer is more preferable in which the total of the styrene monomer unit, the butadiene monomer unit, the isoprene monomer unit, the hydrogenated butadiene monomer unit, and the hydrogenated isoprene monomer unit is 90 mass% or more of all monomer units, and the styrene monomer unit and the hydrogenated butadiene monomer unit and/or the hydrogenated isoprene monomer unit are essential.

A first specific example of the thermoplastic elastomer (B) used in the present embodiment is an elastomer in which the total of the styrene monomer unit and the hydrogenated butadiene monomer unit and/or the hydrogenated isoprene monomer unit accounts for 90 mass% or more of all monomer units.

A second specific example of the thermoplastic elastomer (B) used in the present embodiment is an elastomer in which the total of the styrene monomer unit and the hydrogenated butadiene monomer unit and/or the hydrogenated isoprene monomer unit accounts for 50 mass% or more of all monomer units and the butadiene monomer unit and/or the isoprene monomer unit are contained.

The number average molecular weight of the thermoplastic elastomer (B) used in the present embodiment is preferably 2000 or more, preferably 2500 or more, more preferably 3000 or more, still more preferably 5000 or more, even more preferably 10000 or more, and further more preferably 20000 or more, and preferably 600000 or less, more preferably 500000 or less, still more preferably 400000 or less, even more preferably 300000 or less, and further more preferably 250000 or less. When the number average molecular weight is the above lower limit or more, the resulting cured product tends to have more excellent low dielectric properties (Dk and/or Df) and more excellent peel strength. When the number average molecular weight is the above upper limit or less, the moldability tends to further improve.

When the resin composition according to the present embodiment contains two or more thermoplastic elastomers (B), the number average molecular weight of a mixture thereof preferably satisfies the above range.

In the thermoplastic elastomer (B) used in the present embodiment, the glass transition temperature (Tan$\delta$) measured in accordance with JIS K 7244-1:1996 is preferably from -20°C to 30°C. When the glass transition temperature is the above lower limit or more, the thermal resistance of the resin composition and the resulting cured product tends to be further improved. When the glass transition temperature is the above upper limit or less, the flexibility, the low dielectric loss tangent, and the crack resistance of the resin composition or the resulting cured product tend to be further improved. The glass transition temperature is preferably -15°C or higher, more preferably -12°C or higher, and further may be -5°C or higher, 0°C or higher, or 5°C or higher. The upper limit of the glass transition temperature is preferably 27°C or lower, more preferably 25°C or lower, and still more preferably 23°C or lower.

When the resin composition of the present embodiment contains two or more thermoplastic elastomers (B), the glass transition temperature of the thermoplastic elastomer (B) is the sum of values obtained by multiplying the glass transition temperature of each of the thermoplastic elastomers (B) by a mass fraction (however, the glass transition temperature of each of the thermoplastic elastomers (B) is in the range of from - 20°C to 30°C). For example, when 30 mass% of the thermoplastic elastomer (B) having a glass transition temperature of 0°C and 70 mass% of the thermoplastic elastomer (B) having a glass transition temperature of 10°C are blended, the temperature is set to $0 \times 0.3 + 10 \times 0.7 = 7$°C.

Examples of the composition of the thermoplastic elastomer (B) used in the present embodiment include SBS (S: styrene, B: butadiene), SIS (I: isoprene), SEBS (E: ethylene, B: butylene) obtained by hydrogenating these, and SEPS (E: ethylene, P: propylene), at least one selected from the group consisting of SBS, SEBS, and SEPS is preferable, and SEPS and/or SEBS is more preferable.

Here, SEPS and SEBS include partial hydrogenation.

Examples of commercially available products of the thermoplastic elastomer (B) used in the present embodiment include S.O.E. (trade name) S1605, S1606, S1609, and S1613 and Tuftec H1043 available from Asahi Kasei Corporation, SEPTON (trade name) 2104 available from Kuraray Co., Ltd., and DYNARON (trade name) 9901P available from JSR Corporation.

Examples of the elastomer used in the present embodiment include a resin containing a polybutadiene structure. The polybutadiene structure may be partially or fully hydrogenated. Specific examples thereof include B-1000, B-2000, B-3000, BI-2000, and BI-3000 available from Nippon Soda Co., Ltd., and Ricon 100, Ricon 130, Ricon 131, Ricon 142, Ricon 150, Ricon 181, and Ricon 184 available from CRAY VALLEY.

The content of the thermoplastic elastomer (B) in the resin composition of the present embodiment is preferably 2.5 parts by mass or more, more preferably 5 parts by mass or more, still more preferably 7.5 parts by mass or more, even more preferably 10 parts by mass or more, further more preferably 12.5 parts by mass or more, still further more preferably 15 parts by mass or more, with respect to 100 parts by mass of the resin solid content, and may be 20 parts by mass or more or 25 parts by mass or more depending on the intended use and the like. When the content is the above lower limit or more, the low dielectric loss tangent, the crack resistance, the low thermal expansion, particularly the low thermal expansion tend to be further improved. The upper limit of the content of the thermoplastic elastomer (B) is preferably 50 parts by mass or less, and more preferably 40 parts by mass or less, with respect to 100 parts by mass of the resin solid content, and may be 30 parts by mass or less, 25 parts by mass or less, 21 parts by mass or less, 18 parts by mass or less, or 15 parts by mass or less, depending on the intended use and the like. When the content is the above upper limit or less, the crack resistance tends to be further improved.

The resin composition according to the present embodiment may contain only one type of thermoplastic elastomer (B), or may contain two or more types of thermoplastic elastomers (B). When two or more aliphatic polyamide resins are contained, the total amount is preferably in the range described above.

<Thermosetting compound (C) other than resin (A)>

The resin composition of the present embodiment contains the thermosetting compound (C) other than the resin (A). Although the type and the like of the thermosetting compound (C) are not particularly limited, a compound containing two or more thermosetting groups (functional groups capable of performing a polymerization reaction with heat as a trigger) is preferable. The polymerization reaction here is intended to include a reaction in which a molecule is bonded to the same type and/or another type of molecule to increase the molecular weight of the molecule.

The thermosetting compound (C) preferably contains at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, an additional compound (compound (XC) which will be described in detail later) having a carbon-carbon unsaturated double bond at a terminal other than the resin (A), an epoxy compound, a phenolic compound, an oxetanecompound, a benzoxazine compound, a cyanate ester compound, an aryl cyclobutene compound, a polyamide compound, a polyimide compound, and a compound having a vinylene group, more preferably contains at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, a compound having an indane skeleton having a carbon-carbon unsaturated double bond at a terminal other than the resin (A), an epoxy compound, a phenolic compound, an oxetane compound, a benzoxazine compound, a cyanate ester compound, and a compound having a vinylene group, still more preferably contains at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, and a cyanate ester compound, even more preferably contains at least one selected from the group consisting of a maleimide compound, a polymer having a structural unit represented by Formula (V), and a polyphenylene ether compound having a carbon-carbon unsaturated double bond at a terminal, and still further more preferably contains at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP), which will be described in detail later.

[Chem.28]

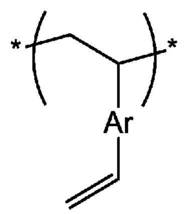

(V)

(In Formula (V), Ar represents an aromatic hydrocarbon linking group; and * represents a bonding position.)

The content of the thermosetting compound (C) in the resin composition of the present embodiment is preferably 5 parts by mass or more, more preferably 10 parts by mass or more, still more preferably 20 parts by mass or more, even more preferably 30 parts by mass or more, and further more preferably 45 parts by mass or more, and is preferably 90 parts

by mass or less, more preferably 80 parts by mass or less, and still more preferably 75 parts by mass or less, with respect to 100 parts by mass of the resin solid content in the resin composition. When the content is the above lower limit or more, the peel strength tends to be more excellent, and the thermal resistance tends to be more excellent. When the content is the above upper limit or less, the resulting cured product tends to be more excellent in low dielectric properties (Dk and/or Df).

The resin composition of the present embodiment may contain only one, or two or more thermosetting compounds (C). When two or more aliphatic polyamide resins are contained, the total amount is preferably in the range described above.

<<Maleimide compound>>

The resin composition of the present embodiment may contain a maleimide compound. In the present embodiment, the maleimide compound is preferably a compound having 1 or more (preferably 2 or more, more preferably from 2 to 12, still more preferably from 2 to 6, even more preferably from 2 to 4, further more preferably from 2 or 3, and still further more preferably 2) maleimide groups per molecule.

More specifically, the maleimide compound preferably includes one or more selected from the group consisting of compounds represented by Formulas (M0) to (M7), more preferably includes one or more selected from the group consisting of: a compound represented by Formula (M0); a compound represented by Formula (M1); a compound represented by Formula (M3); a compound represented by Formula (M4); and a compound represented by Formula (M5), still more preferably includes one or more selected from the group consisting of: a compound represented by Formula (M0); a compound represented by Formula (M1); a compound represented by Formula (M3); and a compound represented by Formula (M5), and even more preferably includes a compound represented by Formula (M1).

[Chem.29]

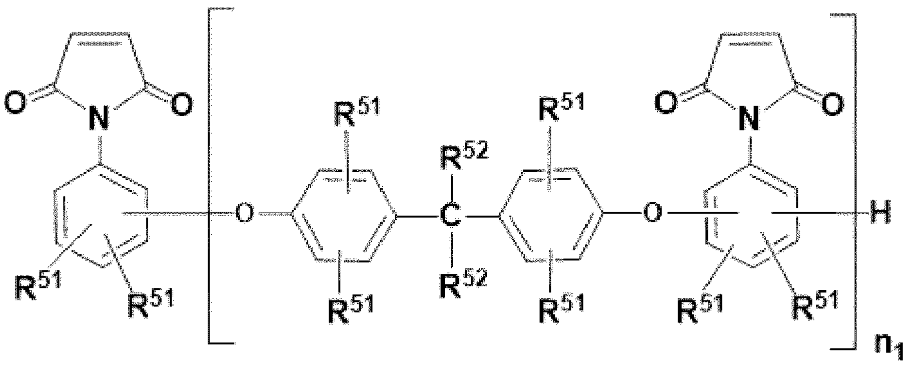

(M0)

(In Formula (M0), each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

Each $R^{51}$ is preferably independently a hydrogen atom, a methyl group, an ethyl group, a n-propyl group, an isopropyl group, a n-butyl group, an isobutyl group, a t-butyl group, a n-pentyl group, or a phenyl group, more preferably either one of a hydrogen atom or a methyl group, and still more preferably a hydrogen atom.

$R^{52}$ is preferably a methyl group.

$n_1$ is preferably an integer of from 1 to 10, more preferably an integer of from 1 to 5, still more preferably an integer of from 1 to 3, even more preferably 1 or 2, and further more preferably 1.

The compound represented by Formula (M0) may be one type, or a mixture of two or more types. Examples of the mixture include: a mixture of compounds having different $n_1$; a mixture of compounds having different types of substituents of $R^{51}$ and/or $R^{52}$; a mixture of compounds in which maleimide groups and oxygen atoms are bonded to benzene rings at different positions (meta positions, para positions, and ortho positions); and a mixture of compounds in which two or more different points described above are combined. Hereinafter, the same applies to the compounds represented by Formulas (M1) to (M7).

[Chem.30]

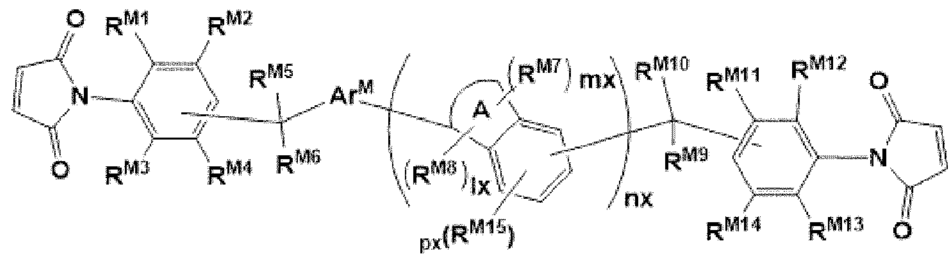

(M1)

(In Formula (M1), $R^{M1}$, $R^{M2}$, $R^{M3}$, and $R^{M4}$ each independently represent a hydrogen atom or an organic group; $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, nx represents an integer of from 1 to 20.)

$R^{M1}$, $R^{M2}$, $R^{M3}$, and $R^{M4}$ in the formula each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group among them. $R^{M1}$ and $R^{M3}$ each independently are preferably alkyl groups, and $R^{M2}$ and $R^{M4}$ are preferably hydrogen atoms.

$R^{M5}$ and $R^{M6}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$Ar^M$ represents a divalent aromatic group and is preferably a phenylene group, a naphthalenediyl group, a phenanthrenediyl group, or an anthracenediyl group, more preferably a phenylene group, and still more preferably a m-phenylene group. $Ar^M$ may have a substituent, and the substituent is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group. However, $Ar^M$ is preferably unsubstituted.

A is a four- to six-membered alicyclic group and more preferably a five-membered alicyclic group (preferably a group to form an indane ring with a benzene ring). $R^{M7}$ and $R^{M8}$ each independently are alkyl groups, preferably alkyl groups having from 1 to 6 carbon atoms, more preferably alkyl groups having from 1 to 3 carbon atoms, and particularly preferably methyl groups.

mx is 1 or 2 and preferably 2.

lx is 0 or 1 and preferably 1.

$R^{M9}$ and $R^{M10}$ each independently represent a hydrogen atom or an alkyl group and are more preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M11}$, $R^{M12}$, $R^{M13}$, and $R^{M14}$ each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group among them. $R^{M12}$ and $R^{M13}$ each independently are preferably alkyl groups, and $R^{M11}$ and $R^{M14}$ are preferably hydrogen atoms.

each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, and is preferably an alkyl group having from 1 to 4 carbon atoms, a cycloalkyl group having from 3 to 6 carbon atoms, or an aryl group having from 6 to 10 carbon atoms.

px represents an integer of from 0 to 3, and is preferably an integer of from 0 to 2, more preferably 0 or 1, and still more preferably 0.

nx represents an integer of from 1 to 20. nx may be an integer of 10 or less.

The resin composition of the present embodiment may contain only one compound represented by Formula (M1) differing in the value of at least nx or may contain two or more of such compounds. When the resin composition contains the two or more compounds, the average value (average number of repeating units) n of nx in the compound represented by Formula (M1) in the resin composition is preferably 0.92 or more, more preferably 0.95 or more, still more preferably 1.0 or more, and still further more preferably 1.1 or more in order to lower the melting point (softening point), reduce the melt viscosity, and provide excellent handling properties. Also, n is preferably 10.0 or less, more preferably 8.0 or less, still more preferably 7.0 or less, and even more preferably 6.0 or less, and may be 5.0 or less. The same applies to Formula (M1-1) and the like described later.

The compound represented by Formula (M1) is preferably a compound represented by the following Formula (M1-1).

[Chem.31]

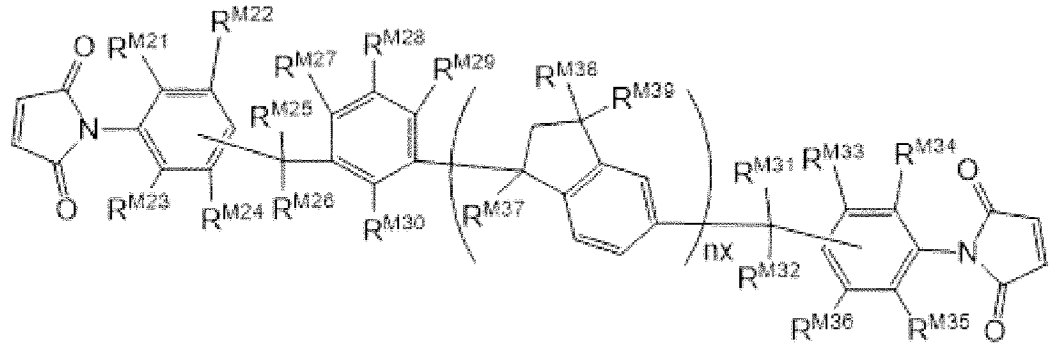

(M1-1)

(In Formula (M1-1), $R^{M21}$, $R^{M22}$, $R^{M23}$, and $R^{M24}$ each independently represent a hydrogen atom or an organic group. $R^{M25}$ and $R^{M26}$ each independently represent a hydrogen atom or an alkyl group. $R^{M27}$, $R^{M28}$, $R^{M29}$, and $R^{M30}$ each independently represent a hydrogen atom or an organic group. $R^{M31}$ and $R^{M32}$ each independently represent a hydrogen atom or an alkyl group. $R^{M33}$, $R^{M34}$, $R^{M35}$, and $R^{M36}$ each independently represent a hydrogen atom or an organic group. $R^{M37}$, $R^{M38}$, and $R^{M39}$ each independently represent a hydrogen atom or an alkyl group. nx represents an integer of 1 or more and 20 or less.)

$R^{M21}$, $R^{M22}$, $R^{M23}$, and $R^{M24}$ in the formula each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group. $R^{M21}$ and $R^{M23}$ are preferably an alkyl group, and $R^{M22}$ and $R^{M24}$ are preferably a hydrogen atom.

$R^{M25}$ and $R^{M26}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M27}$, $R^{M28}$, $R^{M29}$, and $R^{M30}$ each independently represent a hydrogen atom or an organic group and are preferably hydrogen atoms. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group.

$R^{M31}$ and $R^{M32}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and particularly preferably a methyl group.

$R^{M33}$, $R^{M34}$, $R^{M35}$, and $R^{M36}$ each independently represent a hydrogen atom or an organic group. The organic group here is preferably an alkyl group, more preferably an alkyl group having from 1 to 12 carbon atoms, still more preferably an alkyl group having from 1 to 6 carbon atoms, even more preferably a methyl group, an ethyl group, a propyl group, or a butyl group, and particularly preferably a methyl group.

$R^{M33}$ and $R^{M36}$ are preferably hydrogen atoms, and $R^{M34}$ and $R^{M35}$ are preferably alkyl groups.

$R^{M37}$, $R^{M38}$, and $R^{M39}$ each independently represent a hydrogen atom or an alkyl group and are preferably alkyl groups. The alkyl group here is preferably an alkyl group having from 1 to 12 carbon atoms, more preferably an alkyl group having from 1 to 6 carbon atoms, still more preferably a methyl group, an ethyl group, a propyl group, or a butyl group, and

particularly preferably a methyl group.

nx represents an integer of 1 or more and 20 or less. nx may be an integer of 10 or less.

The compound represented by Formula (M1-1) is preferably a compound represented by Formula (M1-2) below.

[Chem.32]

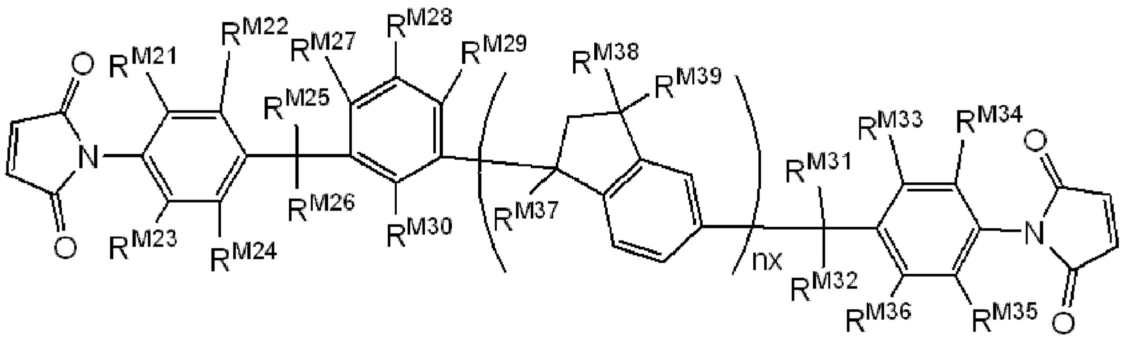

(M1-2)

(In Formula (M1-2), $R^{M21}$, $R^{M22}$, $R^{M23}$, and $R^{M24}$ each independently represent a hydrogen atom or an organic group. $R^{M25}$ and $R^{M26}$ each independently represent a hydrogen atom or an alkyl group. $R^{M27}$, $R^{M28}$, $R^{M29}$, and $R^{M30}$ each independently represent a hydrogen atom or an organic group. $R^{M31}$ and $R^{M32}$ each independently represent a hydrogen atom or an alkyl group. $R^{M33}$, $R^{M34}$, $R^{M35}$, and $R^{M36}$ each independently represent a hydrogen atom or an organic group. $R^{M37}$, $R^{M38}$, and $R^{M39}$ each independently represent a hydrogen atom or an alkyl group. nx represents an integer of 1 or more and 20 or less.)

In Formula (M1-2), $R^{M21}$, $R^{M22}$, $R^{M23}$, $R^{M24}$, $R^{M25}$, $R^{M26}$, $R^{M27}$, $R^{M28}$, $R^{M29}$, $R^{M30}$, $R^{M31}$, $R^{M32}$, $R^{M33}$, $R^{M34}$, $R^{M35}$, $R^{M36}$, $R^{M37}$, $R^{M38}$, $R^{M39}$, and nx have the same meanings as those of $R^{M21}$, $R^{M22}$, $R^{M23}$, $R^{M24}$, $R^{M25}$, $R^{M26}$, $R^{M27}$, $R^{M28}$, $R^{M29}$, $R^{M30}$, $R^{M31}$, $R^{M32}$, $R^{M33}$, $R^{M34}$, $R^{M35}$, $R^{M36}$, $R^{M37}$, $R^{M38}$, $R^{M39}$, and nx in Formula (M1-1), respectively, and preferred ranges thereof are also the same.

Moreover, the compound represented by Formula (M1-1) is preferably a compound represented by Formula (M1-3) below, and more preferably a compound represented by Formula (M1-4) below.

[Chem.33]

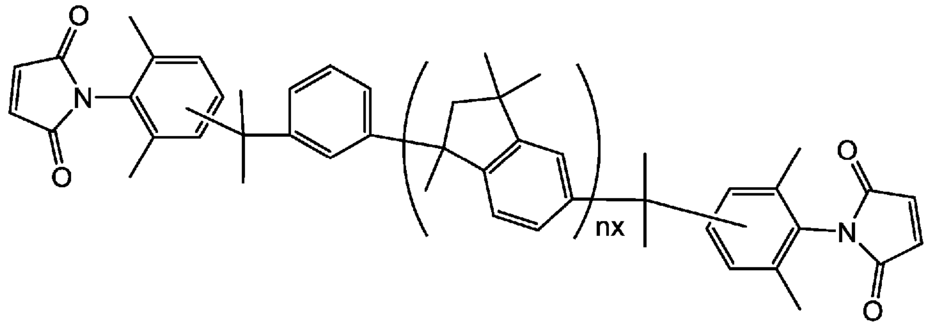

**(M1-3)**

(In Formula (M1-3), nx represents an integer of 1 or more and 20 or less.)

nx may be an integer of 10 or less.

[Chem.34]

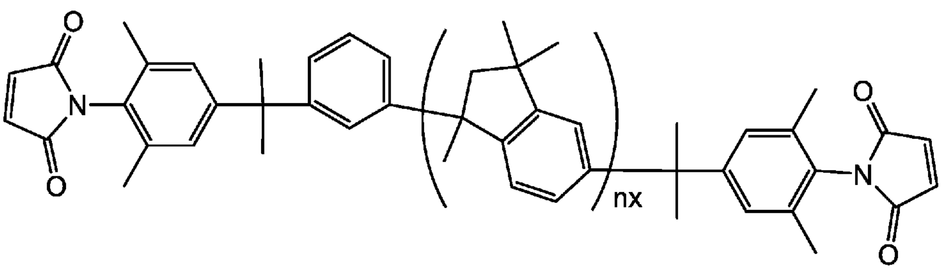

**(M1-4)**

(In Formula (M1-4), nx represents an integer of 1 or more and 20 or less.)

The molecular weight of the compound represented by Formula (M1) is preferably 500 or more, more preferably 600 or more, and still more preferably 700 or more. When the total amount of the compound (A) and the compound (B) is the above lower limit or more, the low dielectric properties and low water absorption of the resulting cured product tend to further improve. The molecular weight of the compound represented by Formula (M1) is preferably 10000 or less, more preferably 9000 or less, still more preferably 7000 or less, even preferably 5000 or less, and further more preferably 4000 or less. When the molecular weight is the above upper limit or less, the resulting cured product tends to have further improved thermal resistance and handleability.

[Chem.35]

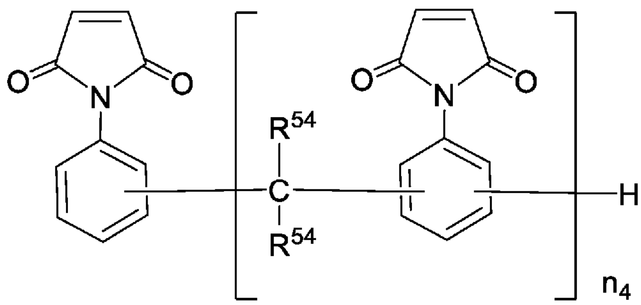

(M2)

(In Formula (M2), each $R^{54}$ independently represents a hydrogen atom or a methyl group; and $n_4$ represents an integer of 1 or more.)

$n_4$ is preferably an integer of from 1 to 10, more preferably an integer of from 1 to 5, still more preferably an integer of from 1 to 3, further preferably 1 or 2, and it may be 1.

The compound represented by Formula (M2) may be a mixture of compounds differing in $n_4$, and is preferably a mixture. In addition, as described in the section of the compound represented by Formula (M0), a mixture of compounds having different other moieties may be used.

[Chem.36]

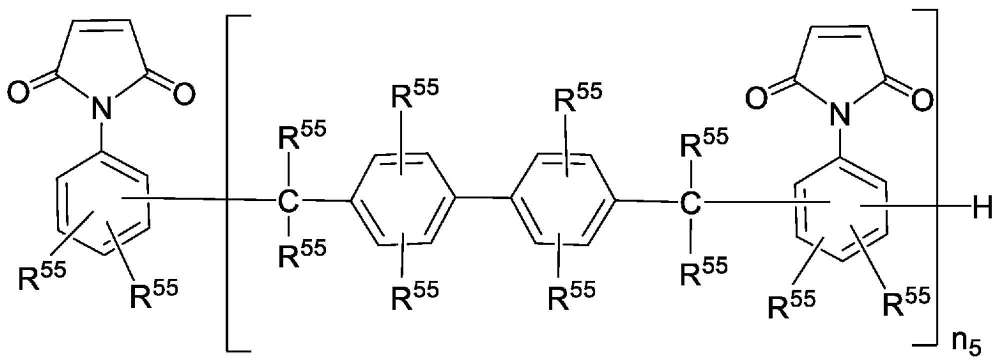

(M3)

(In Formula (M3), each $R^{55}$ independently represents a hydrogen atom, an alkyl group having from 1 to 8 carbon atoms, or a phenyl group; and $n_5$ represents an integer of 1 or more and 10 or less.)

each $R^{55}$ is preferably independently a hydrogen atom, a methyl group, an ethyl group, a n-propyl group, an isopropyl group, a n-butyl group, an isobutyl group, a t-butyl group, a n-pentyl group, or a phenyl group, more preferably either one of a hydrogen atom or a methyl group, and still more preferably a hydrogen atom.

$n_5$ is preferably an integer of 1 or more and 5 or less, more preferably an integer of from 1 to 3, and still more preferably 1 or 2.)

The compound represented by Formula (M3) may be a mixture of compounds differing in $n_5$, and is preferably a mixture. In addition, as described in the section of the compound represented by Formula (M0), a mixture of compounds having different other moieties may be used.

[Chem.37]

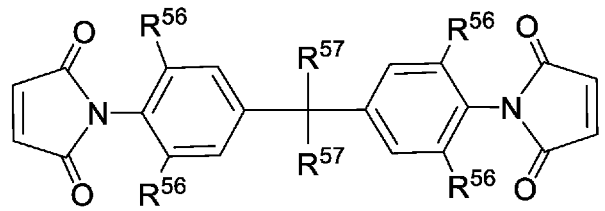

(M4)

(In Formula (M4), each $R^{56}$ independently represents a hydrogen atom, a methyl group, or an ethyl group, and each $R^{57}$ independently represents a hydrogen atom or a methyl group.)

[Chem.38]

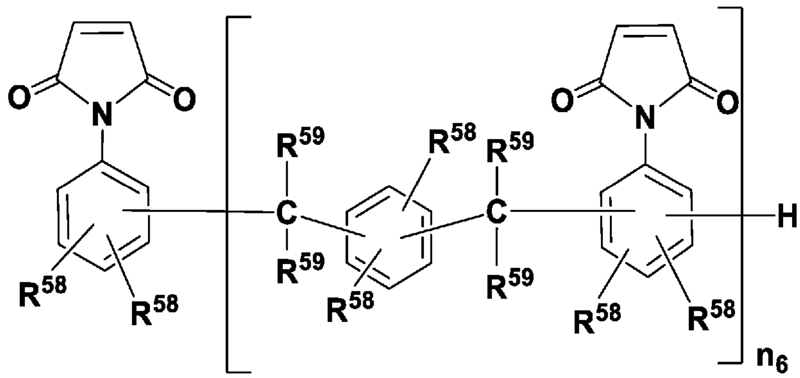

(M5)

(In Formula (M5), each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

each $R^{58}$ is preferably independently a hydrogen atom, a methyl group, an ethyl group, a n-propyl group, an isopropyl group, a n-butyl group, an isobutyl group, a t-butyl group, a n-pentyl group, or a phenyl group, more preferably either one of a hydrogen atom or a methyl group, and still more preferably a hydrogen atom.

$R^{59}$ is preferably a methyl group.

$n_6$ is preferably an integer of from 1 to 10, more preferably an integer of from 1 to 5, still more preferably an integer of from 1 to 3, and even more preferably 1 or 2, and may be 1.)

The compound represented by Formula (M5) may be a mixture of compounds differing in $n_6$, and is preferably a mixture. In addition, as described in the section of the compound represented by Formula (M0), a mixture of compounds having different other moieties may be used.

The maleimide compound (M6) is a compound having a structural unit represented by Formula (M6) and maleimide groups at both terminals of the molecular chain.

[Chem.39]

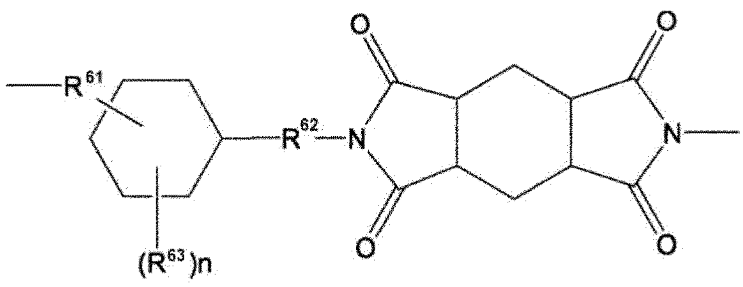

(M6)

(In Formula (M6), $R^{61}$ represents a linear or branched alkylene group having from 1 to 16 carbon atoms, or a linear or branched alkenylene group having from 2 to 16 carbon atoms. $R^{62}$ represents a linear or branched alkylene group having from 1 to 16 carbon atoms, or a linear or branched alkenylene group having from 2 to 16 carbon atoms. each $R^{63}$ independently represents a linear or branched alkyl group having from 1 to 16 carbon atoms or a linear or branched alkenyl group having from 2 to 16 carbon atoms. each n independently represents an integer of from 0 to 10.)

For the details of the maleimide compound (M6) and a method for producing the maleimide compound, reference can be made to the description of paragraphs [0061] to [0066] of WO 2020/262577, the contents of which are incorporated herein by reference.

The maleimide compound (M7) is a maleimide compound formed from reaction raw materials (1), that are, an aromatic amine compound (a1) having one or more and three or less alkyl groups in an aromatic ring, an aromatic divinyl compound (a2) having two ethenyl groups, and maleic anhydride.

The maleimide compound (M7) is preferably a compound represented by Formula (M7).

[Chem.40]

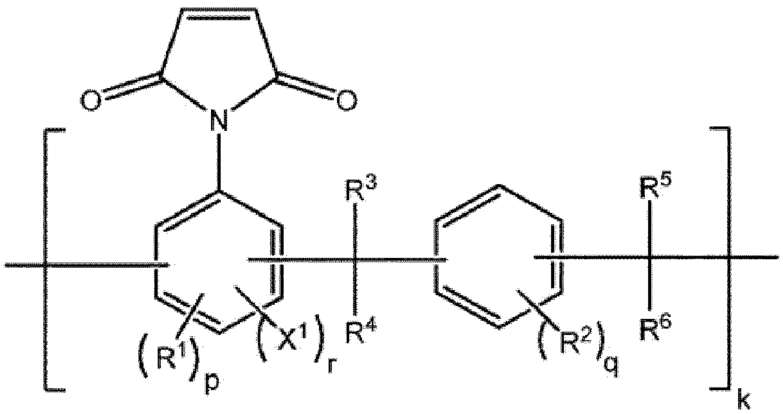

(M7)

(In Formula (M7) above, each $R^1$ independently represents an alkyl group having from 1 to 10 carbon atoms, each $R^2$ independently represents an alkyl group, an alkoxy group, or an alkylthio group each having from 1 to 10 carbon atoms; an aryl group, an aryloxy group, or an arylthio group each having from 6 to 10 carbon atoms; a cycloalkyl group having from 3 to 10 carbon atoms; a halogen atom; a hydroxyl group; or a mercapto group,

$R^3$, $R^4$, $R^5$, and $R^6$ each independently represent a hydrogen atom or a methyl group, for $R^3$ and $R^4$, one is a hydrogen atom and the other is a methyl group, for $R^5$ and $R^6$, one is a hydrogen atom and the other is a methyl group.)
$X^1$ represents a substituent represented by Formula (x) described below:

[Chem.41]

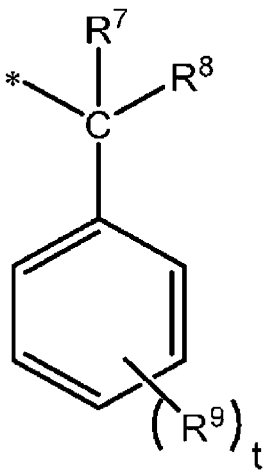

(x)

(In Formula (x), $R^7$ and $R^8$ each independently represent a hydrogen atom or a methyl group, for $R^7$ and $R^8$, one is a hydrogen atom and the other is a methyl group, $R^9$ each independently represents an alkyl group, an alkoxy group, or an alkylthio group each having from 1 to 10 carbon atoms; an aryl group, an aryloxy group, or an arylthio group each having from 6 to 10 carbon atoms; a cycloalkyl group having from 3 to 10 carbon atoms; a halogen atom; a hydroxyl group; or a mercapto group, and t represents an integer of from 0 to 4), and
r is an average value of the numbers of $X^1$ substituents per benzene ring to which $X^1$ is bonded and represents a

number from 0 to 4, p represents an integer of from 1 to 3, q represents an integer of from 0 to 4, and k represents an integer of from 1 to 100.)

For details of the maleimide compound (M7) used in the present embodiment, reference can be made to the description of JP 7160151 B, the contents of which are incorporated herein by reference.

The maleimide compound may be produced by a known method, or a commercially available product may be used. For the commercially available product, examples of the compound represented by Formula (M0) include "BMI-80" available from K·I Chemical Industry Co., Ltd., examples of the compound represented by Formula (M1) include "NE-X-9470S" and "NE-X-9480S" available from DIC Corporation, examples of the compound represented by Formula (M2) include "BMI-2300" available from Daiwa Kasei Industry Co., Ltd., examples of the compound represented by Formula (M3) include "MIR-3000-70MT" available from Nippon Kayaku Co., Ltd., examples of the compound represented by Formula (M4) include "BMI-70" available from K·I Chemical Industry Co., Ltd., examples of the compound represented by Formula (M5) include "MIR-5000" available from Nippon Kayaku Co., Ltd., examples of the maleimide compound (M6) include "MIZ-001" available from Nippon Kayaku Co., Ltd., and examples of the maleimide compound (M7) include "NE-X-9500" available from DIC Corporation.

In addition to the above, for the maleimide compound, reference can be made to the compounds described in paragraphs [0061] to [0066] of WO 2020/262577 and JP 7160151 B, the contents of which are incorporated herein by reference.

Examples of the maleimide compound other than those described above include compounds having two or more maleimide groups, and specific examples thereof include m-phenylene bismaleimide, 2,2-bis(4-(4-maleimidophenoxy)-phenyl)propane, 4-methyl-1,3-phenylene bismaleimide, 1,6-bismaleimide-(2,2,4-trimethyl) hexane, 4,4'-diphenylether bismaleimide, 4,4'-diphenylsulfone bismaleimide, 1,3-bis(3-maleimidophenoxy)benzene, 1,3-bis(4-maleimidophenoxy)benzene, and prepolymers of these, and prepolymers of these maleimides and an amine.

The maleimide group equivalent of the maleimide compound is preferably 130 g/eq. or more, more preferably 150 g/eq. or more, still more preferably 170 g/eq. or more, yet still more preferably 180 g/eq. or more, yet still more preferably 200 g/eq. or more, and is preferably 1000 g/eq. or less, more preferably 800 g/eq. or less, still more preferably 700 g/eq. or less, yet still more preferably 600 g/eq. or less, yet still more preferably 500 g/eq or less. When the maleimide group equivalent is the above lower limit or more, the resulting cured product tends to have further improved low dielectric properties (Dk and/or Df, in particular Df). When the maleimide group equivalent is the above upper limit or less, the resulting cured product tends to have more excellent peel strength.

The lower limit of the content of the maleimide compound in the resin composition of the present embodiment is preferably 1 part by mass or more, more preferably 5 parts by mass or more, still more preferably 10 parts by mass or more, even more preferably 15 parts by mass or more, and further more preferably 18 parts by mass or more, with respect to 100 parts by mass of the resin solid content in the resin composition. When the content of the maleimide compound is 1 part by mass or more, the flame resistance of the resulting cured product tends to improve. The upper limit of the content of the maleimide compound is preferably 90 parts by mass or less, more preferably 80 parts by mass or less, still more preferably 70 parts by mass or less, even more preferably 60 parts by mass or less, further more preferably 50 parts by mass or less, with respect to 100 parts by mass of the resin solid content in the resin composition, and may be 40 parts by mass or less, 30 parts by mass or less, or 25 parts by mass or less, depending on the intended use and the like. When the content of the maleimide compound is 90 parts by mass or less, the peel strength and low water absorption tend to be improved.

The resin composition of the present embodiment may contain only one of, or two or more of the maleimide compounds. When two or more maleimide compounds are contained, the total amount is preferably in the range described above.

<<Polymer having structural unit represented by Formula (V)>>

The resin composition of the present embodiment may contain a polymer having a structural unit represented by Formula (V). Inclusion of the resin composition contains a polymer having a structural unit represented by Formula (V) can provide a resin composition excellent in low dielectric properties (low permittivity and low dielectric loss tangent).

[Chem.42]

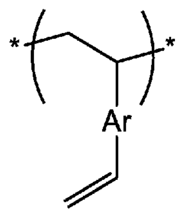

(V)

(In Formula (V), Ar represents an aromatic hydrocarbon linking group. * represents a bonding position.)

The aromatic hydrocarbon linking group may be a group including only an aromatic hydrocarbon that may have a substituent, or a group inducing a combination of an aromatic hydrocarbon that may have a substituent and any other linking group. The aromatic hydrocarbon linking group is preferably a group consisting only of an aromatic hydrocarbon that may have a substituent. Examples of the substituent which may be possessed by the aromatic hydrocarbon include a substituent Z (for example, an alkyl group having from 1 to 6 carbon atoms, an alkenyl group having from 2 to 6 carbon atoms, an alkynyl group having from 2 to 6 carbon atoms, an alkoxy group having from 1 to 6 carbon atoms, a hydroxy group, an amino group, a carboxy group, or a halogen atom). In addition, the aromatic hydrocarbon preferably has no substituent.

The aromatic hydrocarbon linking group is typically a divalent linking group.

Examples of the aromatic hydrocarbon linking group specifically include a phenylene group, a naphthalenediyl group, an anthracenediyl group, a phenanthrenediyl group, a biphenyldiyl group, and a fluorenediyl group, all of which may have a substituent. Among these, a phenylene group that may have a substituent is preferred. The substituent is exemplified by the substituent Z described above, while the group described above such as a phenylene group preferably has no substituent.

The polymer having the structural unit represented by Formula (V) more preferably contains at least one selected from a structural unit represented by Formula (V1) below, a structural unit represented by Formula (V2) below, and a structural unit represented by Formula (V3) below. In formulas below, * represents a bonding position. Hereinafter, structural units represented by Formulas (V1) to (V3) may be collectively referred to as "structural unit (a)".

[Chem.43]

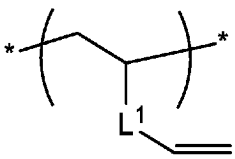

(V1)

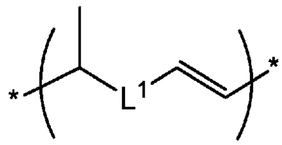

(V2)

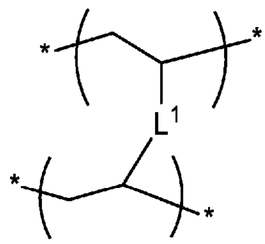

(V3)

In Formulas (V1) to (V3), $L^1$ is an aromatic hydrocarbon linking group (having preferably from 6 to 22, more preferably from 6 to 18, and still more preferably from 6 to 10 carbon atoms). Specifically, examples of the aromatic hydrocarbon linking group include a phenylene group, a naphthalenediyl group, an anthracenediyl group, a phenanthrenediyl group, a biphenyldiyl group, and a fluorenediyl group, all of which may have a substituent. Among these, a phenylene group that may have a substituent is preferred. The substituent is exemplified by the substituent Z described above, while the group described above such as a phenylene group preferably has no substituent.

A compound for forming the structural unit (a) is preferably a divinyl aromatic compound. That is, the polymer having the structural unit represented by Formula (V) preferably includes the structural unit (a) derived from a divinyl aromatic compound. Examples of the divinyl aromatic compound include divinylbenzene, bis(1-methylvinyl)benzene, divinylnaphthalene, divinylanthracene, divinylbiphenyl, and divinylphenanthrene. Among these, divinylbenzene is particularly preferred. One type of these divinyl aromatic compounds may be used, and two or more types thereof may be used as necessary.

As described above, the polymer having a structural unit represented by Formula (V) may be a homopolymer of the structural unit (a), or may be a copolymer with a structural unit derived from another monomer.

When the polymer having a structural unit represented by Formula (V) is a copolymer, the copolymerization percentage of the structural unit (a) is preferably 3 mol% or higher, more preferably 5 mol% or higher, still more preferably

10 mol% or higher, and may be 15 mol% or higher. The upper limit is preferably 90 mol% or less, more preferably 85 mol% or less, still more preferably 80 mol% or less, yet still more preferably 70 mol% or less, yet still more preferably 60 mol% or less, yet still more preferably 50 mol% or less, yet still more preferably 40 mol% or less, particularly preferably 30 mol% or less, and may be 25 mol% or less or 20 mol% or less.

Examples of the structural unit derived from another monomer include a structural unit (b) derived from an aromatic compound having one vinyl group (monovinyl aromatic compound).

The structural unit (b) derived from the monovinyl aromatic compound preferably includes a structural unit represented by Formula (V4) below.

[Chem.44]

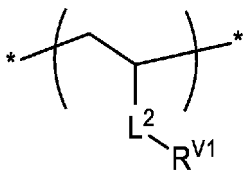

(V4)

In Formula (V4), $L^2$ is an aromatic hydrocarbon linking group, and specific preferred examples include the above-exemplified ones for $L^1$. * represents a bonding position.

$R^{V1}$ is a hydrogen atom or a hydrocarbon group having from 1 to 12 carbon atoms (preferably an alkyl group). When $R^{V1}$ is a hydrocarbon group, the number of its carbon atoms is preferably from 1 to 6 and more preferably from 1 to 3. $R^{V1}$ and $L^2$ may have the substituent Z described above.

When the polymer having the structural unit represented by Formula (V) is a copolymer containing the structural unit (b) derived from a monovinyl aromatic compound, examples of the monovinyl aromatic compound include: vinyl aromatic compounds such as styrene, vinylnaphthalene, and vinylbiphenyl; and nucleophilic alkyl-substituted vinyl aromatic compounds such as o-methylstyrene, m-methylstyrene, p-methylstyrene, o,p-dimethylstyrene, o-ethylvinylbenzene, m-ethylvinylbenzene, p-ethylvinylbenzene, methylvinylbiphenyl, and ethylvinylbiphenyl. The monovinyl aromatic compound exemplified here may have the substituent Z described above as appropriate. In addition, one, or two or more of these monovinyl aromatic compounds may be used. Among them, the structural unit (b) preferably includes a structural unit derived from at least one selected from the group consisting of o-ethylvinylbenzene, m-ethylvinylbenzene, and p-ethylvinylbenzene, and more preferably further includes a structural unit derived from styrene in addition to the structural unit derived from at least one selected from the group consisting of o-ethylvinylbenzene, m-ethylvinylbenzene, and p-ethylvinylbenzene.

When the polymer having the structural unit represented by Formula (V) is a copolymer containing the structural unit (b), the copolymerization percentage of the structural unit (b) is preferably 10 mol% or higher, and more preferably 15 mol% or higher, and further, may be 20 mol% or higher, 30 mol% or higher, 40 mol% or higher, 50 mol% or higher, 60 mol% or higher, 70 mol% or higher, or 75 mol% or higher. The upper limit thereof is preferably 98 mol% or less, more preferably 90 mol% or less, and still more preferably 85 mol% or less.

The polymer having the structural unit represented by Formula (V) may have an additional structural unit other than the structural unit (a) or the structural unit (b). Examples of the additional structural unit include a structural unit (c) derived from a cycloolefin compound. Examples of the cycloolefin compound include hydrocarbon atoms having a double bond in the ring structure. Specifically, examples include monocyclic olefins, such as cyclobutene, cyclopentene, cyclohexene, and cyclooctene; additionally, compounds having a norbornene ring structure, such as norbornene and dicyclopentadiene; and cycloolefin compounds in which an aromatic ring is fused, such as indene and acenaphthylene. Examples of the norbornene compounds include those described in paragraphs [0037] to [0043] of JP 2018-039995 A, the contents of which are incorporated herein by reference. The cycloolefin compounds exemplified here may further include the substituent Z described above.

When the polymer having the structural unit represented by Formula (V) is a copolymer containing the structural unit (c), the copolymerization percentage of the structural unit (c) is preferably 10 mol% or higher, more preferably 20 mol% or higher, and still more preferably 30 mol% or higher. The upper limit thereof is preferably 90 mol% or less, more preferably 80 mol% or less, still more preferably 70 mol% or less, and may be 50 mol% or less or 30 mol% or less.

The polymer having the structural unit represented by Formula (V) may further contain a structural unit (d) derived from yet another polymerizable compound (hereinafter may be referred to as the additional polymerizable compound). Examples of the additional polymerizable compound (monomer) include compounds containing three vinyl groups. Specific examples include 1,3,5-trivinylbenzene, 1,3,5-trivinylnaphthalene, and 1,2,4-trivinylcyclohexane. Alternatively, examples thereof include ethylene glycol diacrylate, 1,3-butadiene, and isoprene. A copolymerization percentage (d) of the structural unit (d) derived from the additional polymerizable compound is preferably 30 mol% or less, more preferably

20 mol% or less, and still more preferably 10 mol% or less.

An embodiment of the polymer having the structural unit represented by Formula (V) is exemplified by a polymer containing the structural unit (a) as an essential unit and at least one of the structural units (b) to (d). Furthermore, an aspect in which the total of the structural units (a) to (d) accounts for 95 mol% or higher or even 98 mol% or higher of all the structural units is exemplified.

Another embodiment of the polymer having the structural unit represented by Formula (V) is preferably a polymer having the structural unit (a) as an essential unit, in which a structural unit containing an aromatic ring accounts for 90 mol% or higher, more preferably account for 95 mol% or higher, or may account for 100 mol%, of all the structural units excluding the terminal.

When calculating the mol% per all the structural units, one structural unit is defined as a unit derived from one molecule of a monomer (such as a divinyl aromatic compound, a monovinyl aromatic compound, or the like) used for producing the polymer having the structural unit represented by Formula (V).

The method for producing the polymer having the structural unit represented by Formula (V) is not particularly limited, and a common method can be used. Examples include a method in which a raw material containing a divinyl aromatic compound is polymerized in the presence of a Lewis acid catalyst (as needed, in the coexistence of a monovinyl aromatic compound, a cycloolefin compound, or the like). As the Lewis acid catalyst, a metal fluoride, such as boron trifluoride, or a complex thereof can be used.

The chain end structure of the polymer having the structural unit represented by Formula (V) is not particularly limited; however, regarding the chain end structure of the group derived from the divinyl aromatic compound, examples of the chain end include a structure of Formula (E1) described below. In Formula (E1), $L^1$ is the same as that defined for Formula (V1) above, and * * represents a bonding position.

$$*\text{-CH} = \text{CH-L}^1\text{-CH} = \text{CH}_2 \qquad \text{(E1)}$$

When the group derived from the monovinyl aromatic compound is at a chain end, examples of the chain end structure include a structure of Formula (E2) below. In the formula, $L^2$ and $R^{V1}$ each have the same meaning as that defined for Formula (V4) above. * represents a bonding position.

$$*\text{-CH} = \text{CH-L}^2\text{-R}^{V1} \qquad \text{(E2)}$$

The molecular weight of the polymer having the structural unit represented by Formula (V) is preferably 400 or more, more preferably 500 or more, still more preferably 1000 or more, and yet still more preferably 1500 or more as a number average molecular weight Mn. The upper limit of the number average molecular weight Mn is preferably 130000 or less, more preferably 120000 or less, still more preferably 110000 or less, and yet still more preferably 100000 or less, and it may be 30000 or less, 10000 or less, or 5000 or less.

The molecular weight of the polymer having the structural unit represented by Formula (V) in terms of weight average molecular weight Mw is preferably 3000 or more, more preferably 5000 or more, and still more preferably 10000 or more. When the molecular weight is the above lower limit or more, a cured product of the resin composition is enabled to effectively exhibit the excellent low dielectric properties possessed by the polymer having the structural unit represented by Formula (V), particularly the Df and the dielectric properties after moisture absorption. The upper limit of the weight average molecular weight Mw is preferably 130000 or less, more preferably 100000 or less, still more preferably 80000 or less, and even more preferably 50000 or less. When the molecular weight is the above upper limit or less, an embedding defect tends to hardly occur when the prepreg or the resin sheet is laminated on a circuit-forming substrate.

A monodispersity (Mw/Mn) represented by a ratio of the weight average molecular weight Mw to the number average molecular weight Mn is preferably 100 or less, more preferably 50 or less, and still more preferably 20 or less, and may be 15 or less or 12 or less. The lower limit is practically 1.1 or more, preferably 2.0 or more, more preferably 4 or more, still more preferably 5 or more, even more preferably 7 or more, and further more preferably 8 or more.

The Mw and Mn are measured in accordance with the description in Examples to be described later.

When the resin composition of the present embodiment contains two or more polymers having the structural unit represented by Formula (V), the Mw, Mn, and Mw/Mn of the mixture are preferably within the respective ranges described above.

The equivalent of the vinyl group of the polymer having the structural unit represented by Formula (V) is preferably 200 g/eq. or more, more preferably 230 g/eq. or more, still more preferably 250 g/eq. or more, and may be 300 g/eq. or more, or 350 g/eq. or more. The equivalent of the vinyl group is preferably 1200 g/eq. or less, and more preferably 1000 g/eq. or less, and further may be 800 g/eq. or less, 600 g/eq. or less, 500 g/eq. or less, 400 g/eq. or less, or 350 g/eq. or less. When the vinyl group equivalent is the above lower limit or more, the storage stability of the resin composition tends to improve, and the fluidity of the resin composition tends to improve. Thus, there is a tendency that moldability is improved, voids are less likely to occur at the time of forming a prepreg, and a printed wiring board having higher reliability is obtained.

Meanwhile, when the vinyl group equivalent is the above upper limit or less, the thermal resistance of the resulting cured product tends to improve.

The glass transition temperature of the polymer having the structural unit represented by Formula (V) is preferably 170°C or more, more preferably 180°C or more, still more preferably 190°C or more, and yet still more preferably 200°C or more. The upper limit of the glass transition temperature is preferably 350°C or less, and may be 300°C or less. The glass transition temperature can be determined by measuring a dynamic viscoelasticity of a measurement sample with a starting temperature of 30°C, an ending temperature of 400°C, a temperature rise rate of 5°C/min, and a measurement frequency of 1 Hz under a nitrogen atmosphere in accordance with JIS K 7244-4: 1999 (Plastics-Test Methods for Dynamic Mechanical Properties-Part 4: Tensile Vibration-Non-Resonant Method) using a dynamic viscoelasticity analyzer, and taking the maximum value of the loss tangent (tan$\sigma$) obtained in the measurement as the glass transition temperature. For the dynamic viscoelasticity analyzer, EXSTAR 6000 DMS6100 available from Seiko Instruments Inc. can be used.

A cured product of the polymer having the structural unit represented by Formula (V) preferably has excellent low dielectric properties. For example, the cured product of the polymer having the structural unit represented by Formula (V) used in the present embodiment has a relative permittivity (Dk), measured at 10 GHz in accordance with a cavity resonator perturbation method, of preferably 2.80 or less, more preferably 2.60 or less, still more preferably 2.50 or less, and yet still more preferably 2.40 or less. The lower limit of the relative permittivity is practically, for example, 1.80 or more. The cured product of the polymer having the structural unit represented by Formula (V) has a dielectric loss tangent (Df) measured at 10 GHz in accordance with the cavity resonator perturbation method of preferably 0.0030 or less, more preferably 0.0020 or less, and still more preferably 0.0010 or less. The lower limit of the dielectric loss tangent is practically, for example, 0.0001 or more.

The relative permittivity (Dk) and the dielectric loss tangent (Df) are measured by the following method.

4.5 g of the resin powder was spread in a stainless steel mold frame of 100 mm $\times$ 30 mm $\times$ 1.0 mm in height, set in a vacuum press machine (available from KITAGAWA SEIKI CO., LTD.), held at 200°C, 220°C, and 240°C for 1.5 hours, and pressed at a surface pressure of 1.9 MPa to produce a cured plate.

The cured plate was downsized to a width of 1.0 mm and then dried at 120°C for 60 minutes, and the relative permittivity (Dk) and the dielectric loss tangent (Df) at 10 GHz after drying were measured using a cavity resonator based on the perturbation method. The measurement is conducted at a temperature of 23°C.

As the cavity resonator based on the perturbation method, P5005A available from Keysite Technologies was used.

For the polymer having the structural unit represented by Formula (V) in the present specification, reference can be made to compounds, their synthesis conditions, and the like described in paragraphs [0029] to [0058] of WO 2017/115813, compounds, their synthesis conditions, and the like described in paragraphs [0013] to [0058] of JP 2018-039995 A, compounds, their synthesis conditions, and the like described in paragraphs [0008] to [0043] of JP 2018-168347 A, compounds, their synthesis conditions, and the like described in paragraphs [0014] to [0042] of JP 2006-070136 A, compounds, their synthesis conditions, and the like described in paragraphs [0014] to [0061] of JP 2006-089683 A, and compounds, their synthesis conditions, and the like described in paragraphs [0008] to [0036] of JP 2008-248001 A, the contents of which are incorporated herein by reference.

The content of the polymer having the structural unit represented by Formula (V) in the resin composition of the present embodiment is preferably 1 part by mass or more, more preferably 5 parts by mass or more, still more preferably 10 parts by mass or more, even more preferably 20 parts by mass or more, and further more preferably 25 parts by mass or more, and is preferably 90 parts by mass or less, more preferably 70 parts by mass or less, still more preferably 60 parts by mass or less, even more preferably 50 parts by mass or less, and further more preferably 40 parts by mass or less, with respect to 100 parts by mass of the resin solid content.

The resin composition of the present embodiment may contain only one type of the polymer having the structural unit represented by Formula (V) or may contain two or more types thereof. When the resin composition of the present embodiment contains two or more polymers having the structural unit represented by Formula (V), the total amount is preferably in the range described above.

<<Polyphenylene ether compound having carbon-carbon unsaturated double bond at terminal>>

The resin composition of the present embodiment may contain a polyphenylene ether compound containing a carbon-carbon unsaturated double bond at a terminal.

The polyphenylene ether compound having a carbon-carbon unsaturated double bond at a terminal is more preferably a polyphenylene ether compound having two or more carbon-carbon unsaturated double bonds at a terminal.

In the present embodiment, the carbon-carbon unsaturated double bond is more preferably a polyphenylene ether compound including one or more groups selected from the group consisting of a (meth)acryloyl group and a vinylbenzyl group. When the polyphenylene ether compound including these groups is used, dielectric properties of a

printed wiring board and the like and low water absorption tend to be more effectively improved.

In the present embodiment, it is also preferable to contain both a polyphenylene ether compound having a group represented by Formula (Rx-1) at a terminal and a polyphenylene ether compound having a group represented by Formula (Rx-2) at a terminal, which will be described later. With such a configuration, the low dielectric properties (Dk and/or Df, in particular Df) of the resulting cured product are more excellent, and the thermal resistance (low dielectric properties (Dk and/or Df, in particular Df) after heating) over time of the resulting cured product can be more effectively maintained.

Hereinafter, these details will be described.

Examples of the polyphenylene ether compound having a carbon-carbon unsaturated double bond at a terminal include a compound having a phenylene ether skeleton represented by Formula (X1) below.

[Chem.45]

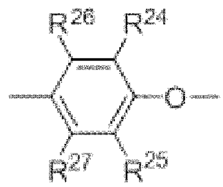

(X1)

(In Formula (X1), $R^{24}$, $R^{25}$, $R^{26}$, and $R^{27}$ may be the same or different, and each represent an alkyl group having 6 or fewer carbon atoms, an aryl group, a halogen atom, or a hydrogen atom.)

The polyphenylene ether compound containing a unsaturated carbon-carbon double bond at a terminal may further include a repeating unit represented by Formula (X2),

[Chem.46]

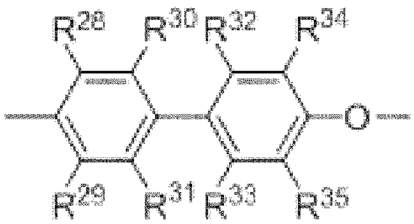

(X2)

(In Formula (X2), $R^{28}$, $R^{29}$, $R^{30}$, $R^{34}$, and $R^{35}$ may be the same or different, and each represents an alkyl group having 6 or fewer carbon atoms or a phenyl group, $R^{31}$, $R^{32}$, and $R^{33}$ may be the same or different, and each represent a hydrogen atom, an alkyl group having 6 or fewer carbon atoms, or a phenyl group) and/or a repeating unit represented by Formula (X3),

[Chem.47]

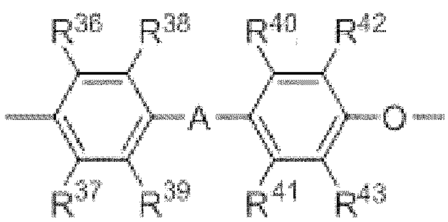

(X3)

(In Formula (X3), $R^{36}$, $R^{37}$, $R^{38}$, $R^{39}$, $R^{40}$, $R^{41}$, $R^{42}$, and $R^{43}$ may be the same or different, and each represent a hydrogen atom, an alkyl group having 6 or fewer carbon atoms, or a phenyl group; and -A- is a linear, branched, or cyclic divalent hydrocarbon group having 20 or fewer carbon atoms.)

The polyphenylene ether compound having a carbon-carbon unsaturated double bond at a terminal is preferably a modified polyphenylene ether compound (which may be hereinafter referred to as a "modified polyphenylene ether compound (g)") in which some or all terminals are functionalized with an ethylenically unsaturated group and more preferably a modified polyphenylene ether compound having two or more groups selected from the group consisting of (meth)acryloyl groups and vinylbenzyl groups at a terminal. Employing such a modified polyphenylene ether compound (g) enables the cured product of the resin composition to have further reduced dielectric loss tangent (Df) and to exhibit

enhanced low water absorption and increased the peel strength. One type of the modified polyphenylene ether compounds (g) may be used alone, or two or more types thereof may be used in combination.

Examples of the modified polyphenylene ether compound (g) include a polyphenylene ether compound represented by Formula (OP).

[Chem.48]

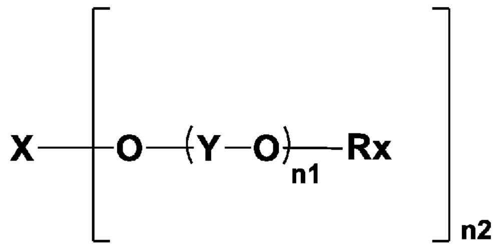

(OP)

(In Formula (OP), X represents an aromatic group; $-(Y-O)_{n1}-$represents a polyphenylene ether structure; n1 represents an integer of from 1 to 100; n2 represents an integer of from 1 to 4. Rx is a group represented by Formula (Rx-1) or Formula (Rx-2) .)

[Chem.49]

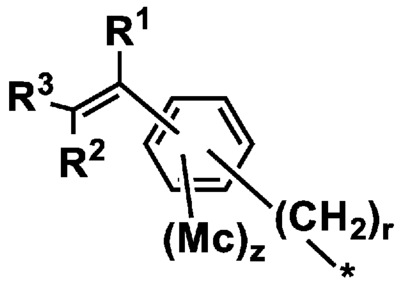

(Rx-1)

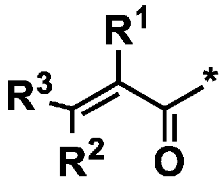

(Rx-2)

(In Formula (Rx-1) and Formula (Rx-2), $R^1$, $R^2$, and $R^3$ each independently represent a hydrogen atom, an alkyl group, an alkenyl group, or an alkynyl group. * is a bonding position for an oxygen atom. each Mc independently represents a hydrocarbon group having from 1 to 12 carbon atoms. z represents an integer of from 0 to 4. r represents an integer of from 0 to 6.)

The aromatic group represented by X may or may not have a substituent on the benzene ring, yet preferably has a substituent. When the aromatic group has a substituent, the above-described substituent Z can be exemplified, yet the substituent is preferably at least one selected from the group consisting of an alkyl group having 6 or fewer carbon atoms, an aryl group, and a halogen atom, more preferably an alkyl group having 3 or fewer carbon atoms, and still more preferably a methyl group.

The polyphenylene ether structure represented by $-(Y-O)n_1-$may or may not have a substituent on the benzene ring, yet preferably has a substituent. When the polyphenylene ether structure has a substituent, the above-described substituent Z can be exemplified, yet the substituent is preferably an alkyl group having 6 or fewer carbon atoms or a phenyl group, more preferably an alkyl group having 3 or fewer carbon atoms, and still more preferably a methyl group.

When $n_1$ and/or $n_2$ are/is each an integer of 2 or more, $n_1$ structural units (Y-O) and/or $n_2$ structural units may be the same as or different from each other. $n_2$ is preferably 2 or more and more preferably 2.

In Formula (Rx-1) and Formula (Rx-2), $R^1$, $R^2$, and $R^3$ each independently represent a hydrogen atom, an alkyl group, an alkenyl group, or an alkynyl group.

$R^1$ is preferably a hydrogen atom or an alkyl group, more preferably a hydrogen atom or a methyl group, and still more preferably a hydrogen atom.

$R^2$ and $R^3$ are each independently preferably a hydrogen atom or an alkyl group, more preferably a hydrogen atom or a methyl group, and still more preferably a hydrogen atom.

The number of carbon atoms of the alkyl group, the alkenyl group, and the alkynyl group as $R^1$, $R^2$, and $R^3$ is each preferably 5 or less, and more preferably 3 or less.

In Formula (Rx-1), r represents an integer of from 0 to 6, and may be an integer of 1 or more, and preferably an integer of 5 or less, more preferably an integer of 4 or less, still more preferably an integer of 3 or less, yet still more preferably 1 or 2, and yet still more preferably 1.

In Formula (Rx-1), each Mc independently represents a hydrocarbon group having from 1 to 12 carbon atoms,

and is preferably a hydrocarbon group having from 1 to 10 carbon atoms, more preferably a linear or branched alkyl group having from 1 to 10 carbon atoms, still more preferably a methyl group, an ethyl group, an isopropyl group, an isobutyl group, a t-butyl group, a pentyl group, an octyl group, or a nonyl group, and even more preferably a methyl group, an ethyl group, an isopropyl group, an isobutyl group, or a t-butyl group.

In Formula (Rx-1), z represents an integer of from 0 to 4, and is preferably an integer of from 0 to 3, more preferably an integer of from 0 to 2, still more preferably 0 or 1, and even more preferably 0.

A specific example of the group represented by Formula (Rx-1) is a vinylbenzyl group, and a specific example of the group represented by Formula (Rx-2) is a (meth)acryloyl group.

It is also preferable that the resin composition of the present embodiment contains, as the polyphenylene ether compound having a carbon-carbon unsaturated double bond at a terminal, both a polyphenylene ether compound that is a compound represented by Formula (OP) and has a group represented by Formula (Rx-1) and a compound having a polyphenylene ether group having a group represented by Formula (Rx-2).

Examples of the modified polyphenylene ether compound (g) include a compound represented by Formula (OP-1).

[Chem.50]

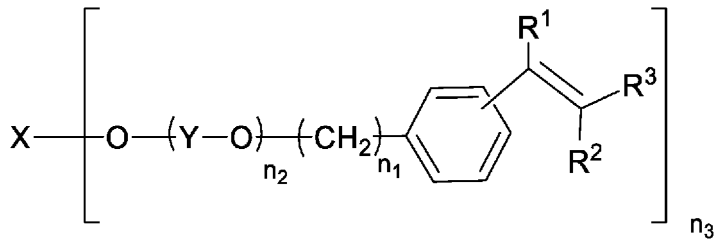

(OP-1)

(In Formula (OP-1), X represents an aromatic group; -(Y-O)$n_2$-represents a polyphenylene ether structure; $R^1$, $R^2$, and $R^3$ each independently represent a hydrogen atom, an alkyl group, an alkenyl group, or an alkynyl group; $n_1$ represents an integer of from 0 to 6; $n_2$ represents an integer of from 1 to 100; and $n_3$ represents an integer of from 1 to 4.)

The aromatic group represented by X may or may not have a substituent on the benzene ring, yet preferably has a substituent. When the aromatic group has a substituent, the above-described substituent Z can be exemplified, yet the substituent is preferably at least one selected from the group consisting of an alkyl group having 6 or fewer carbon atoms, an aryl group, and a halogen atom, more preferably an alkyl group having 3 or fewer carbon atoms, and still more preferably a methyl group.

The polyphenylene ether structure represented by -(Y-O)$n_2$-may or may not have a substituent in the benzene ring, yet preferably has a substituent. When the polyphenylene ether structure has a substituent, the above-described substituent Z can be exemplified, yet the substituent is preferably an alkyl group having 6 or fewer carbon atoms or a phenyl group, more preferably an alkyl group having 3 or fewer carbon atoms, and still more preferably a methyl group.

When $n_2$ and/or $n_3$ is an integer of 2 or more, $n_2$ pieces of structural units (Y-O) and/or $n_3$ pieces of structural units may each be the same or different. $n_3$ is preferably 2 or more and more preferably 2.

The modified polyphenylene ether compound (g) in the present embodiment is preferably a compound represented by Formula (OP-2).

[Chem.51]

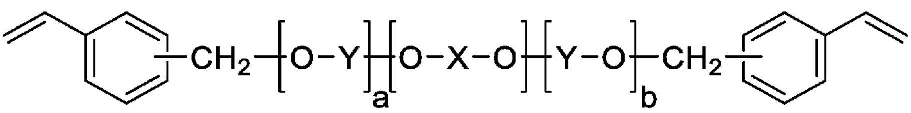

(OP-2)

In this case, -(O-X-O)- is preferably represented by Formula (OP-3):

[Chem.52]

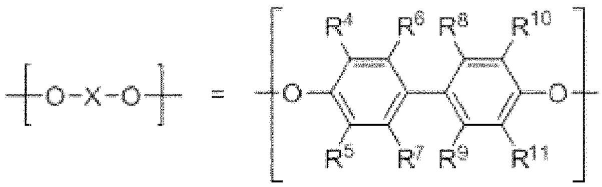 (OP-3)

(In Formula (OP-3), $R^4$, $R^5$, $R^6$, $R^{10}$, and $R^{11}$ may be the same or different, and are each an alkyl group having 6 or fewer carbon atoms or a phenyl group; and $R^7$, $R^8$, and $R^9$ may be the same or different, and are each a hydrogen atom, an alkyl group having 6 or fewer carbon atoms, or a phenyl group.)
and/or Formula (OP-4):

[Chem.53]

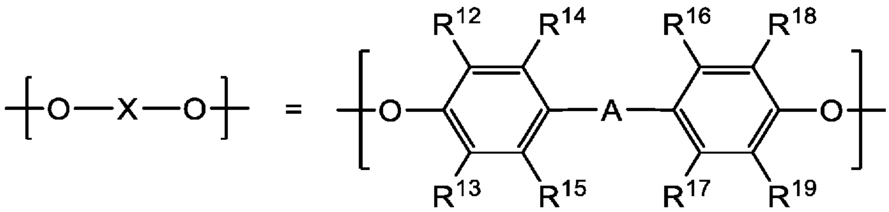 (OP-4)

(In Formula (OP-4), $R^{12}$, $R^{13}$, $R^{14}$, $R^{15}$, $R^{16}$, $R^{17}$, $R^{18}$, and $R^{19}$ may be the same or different, and are each a hydrogen atom, an alkyl group having 6 or fewer carbon atoms, or a phenyl group; and -A-is a linear, branched, or cyclic divalent hydrocarbon group having 20 or fewer carbon atoms.)

Moreover, -(Y-O)- is preferably represented by Formula (OP-5):

[Chem.54]

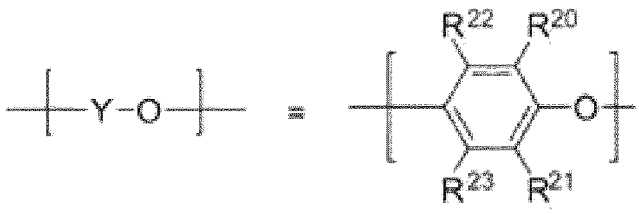 (OP-5)

(In Formula (OP-5), $R^{20}$ and $R^{21}$ may be the same or different, and are each an alkyl group having 6 or fewer carbon atoms or a phenyl group; $R^{22}$ and $R^{23}$ may be the same or different, and are each a hydrogen atom, an alkyl group having 6 or fewer carbon atoms, or a phenyl group.)

In particular, when $R^{20}$ and $R^{21}$ are each independently a group having one or more methyl groups and/or cyclohexyl groups, the rigidity of the resulting resin molecule is increased, and a molecule having high rigidity has lower mobility than a molecule having low rigidity, so that a relaxation time during dielectric relaxation is lengthened, and the low dielectric properties (Dk and/or Df, in particular Dk) are excellent, which is preferred.

An example of Formula (OP-5) is the following structure.

[Chem.55]

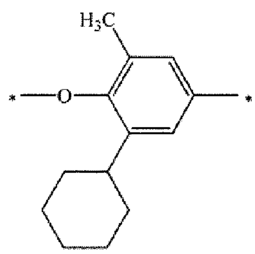

For the polyphenylene ether compound having the above-described structure, reference can be made to the description of JP 2019-194312 A, the contents of which are incorporated herein by reference.

In Formula (OP-2), a and b each independently represent an integer of from 0 to 100, and at least one of a and b is an integer of from 1 to 100. a and b are each independently preferably an integer of from 0 to 50, more preferably an integer of from 1 to 30, and preferably an integer of from 1 to 10. When a and/or b is an integer of 2 or more, two or more -(Y-O)- may each independently have one type of structure that is arranged sequentially, or two or more types of structures that are arranged in blocks or randomly.

When a plurality of compounds represented by Formula (OP-2) are contained, an average value of a is preferably $1 < a < 10$, and an average value of b is preferably $1 < b < 10$.

Examples of -A- in Formula (OP-4) include, but are not limited to, divalent organic groups such as a methylene group, an ethylidene group, a 1-methylethylidene group, 1,1-propylidene group, 1,4-phenylene bis(1-methylethylidene) group, 1,3-phenylene bis(1-methylethylidene) group, a cyclohexylidene group, a phenylmethylene group, a naphthylmethylene group, and 1-phenylethylidene group.

Among the compounds represented by Formula (OP-2), preferred is a polyphenylene ether compound in which $R^4$, $R^5$, $R^6$, $R^{10}$, $R^{11}$, $R^{20}$, and $R^{21}$ are each an alkyl group having 3 or fewer carbon atoms, and $R^7$, $R^8$, $R^9$, $R^{12}$, $R^{13}$, $R^{14}$, $R^{15}$, $R^{16}$, $R^{17}$, $R^{18}$, $R^{19}$, $R^{22}$, and $R^{23}$ are each a hydrogen atom or an alkyl group having 3 or fewer carbon atoms, and in particular, -(O-X-O)- represented by Formula (OP-3) or Formula (OP-4) is preferably Formula (OP-9), Formula (OP-10), and/or Formula (OP-11), and -(Y-O)-represented by Formula (OP-5) is preferably Formula (OP-12) or Formula (OP-13). When a and/or b are/is each an integer of 2 or more, two or more -(Y-O)- may each independently have a structure in which two or more of Formula (OP-12) and/or Formula (OP-13) are arranged, or a structure in which Formula (OP-12) and Formula (OP-13) are arranged in blocks or randomly.

[Chem.56]

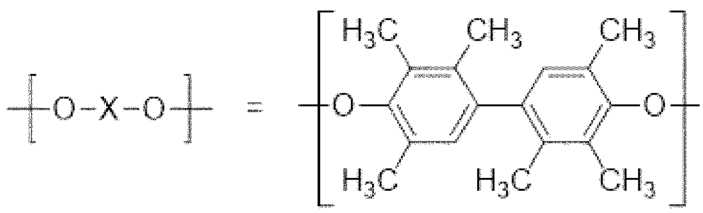

(OP-9)

[Chem.57]

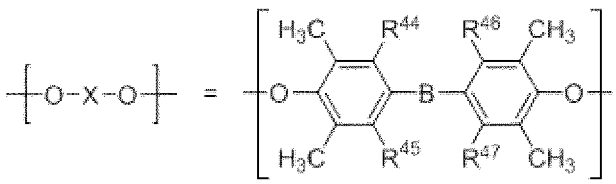

(OP-10)

(In Formula (OP-10), $R^{44}$, $R^{45}$, $R^{46}$, and $R^{47}$ may be the same or different, and are hydrogen atoms or methyl groups. -B- is a linear, branched, or cyclic divalent hydrocarbon group having 20 or fewer carbon atoms.)

Specific examples of -B- include the same as those for the specific examples of -A- in Formula (OP-4).

[Chem.58]

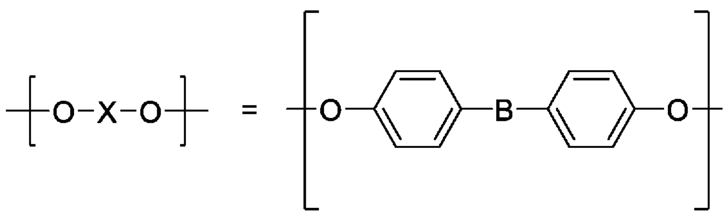

(OP-11)

(In Formula (OP-11), -B- is a linear, branched, or cyclic divalent hydrocarbon group having 20 or fewer carbon atoms.)

Specific examples of -B- include the same as those for the specific examples of -A- in Formula (OP-4).

[Chem.59]

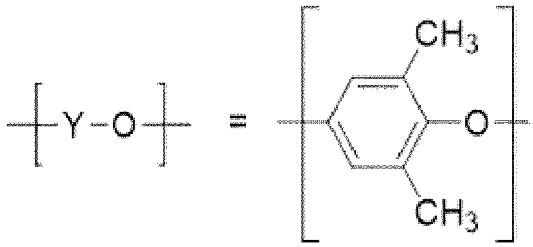

(OP-12)

[Chem.60]

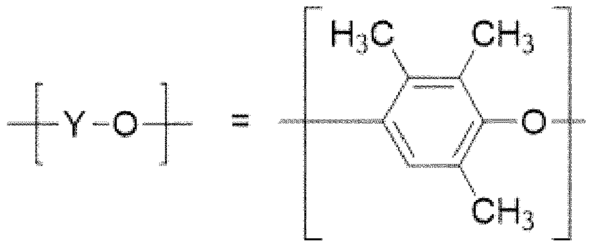

(OP-13)

The modified polyphenylene ether compound (g) is more preferably a compound represented by Formula (OP-14) and/or a compound represented by Formula (OP-15), and still more preferably the compound represented by Formula (OP-15).

[Chem.61]

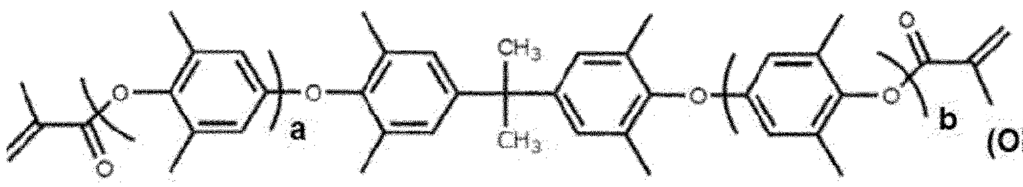

(OP-14)

(In Formula (OP-14), a and b each independently represent an integer of from 0 to 100, and at least one of a or b is an integer of from 1 to 100.)

In Formula (OP-14), a and b are independently synonymous with a and b in Formula (OP-2), respectively, and preferred ranges thereof are also the same.

[Chem.62]

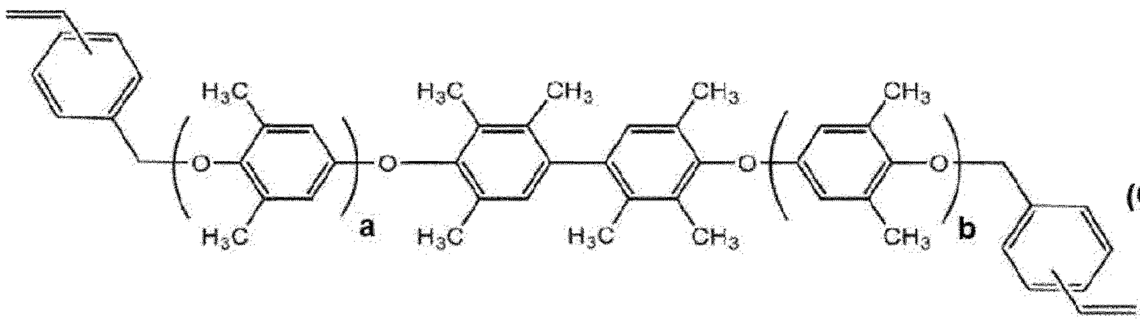

(OP-15)

(In Formula (OP-15), a and b each independently represent an integer of from 0 to 100, and at least one of a or b is an integer of from 1 to 100.)

a and b in Formula (OP-15) each independently have the same meaning as a and b in Formula (OP-2), and preferred ranges thereof are also the same.

The polyphenylene ether compound having a carbon-carbon unsaturated double bond at a terminal may be produced by a known method, or a commercially available product thereof may be used. Examples of the commercially available product include "SA9000" available from SABIC Innovative Plastics as a modified polyphenylene ether compound whose terminal is a methacryloyl group. Examples of the modified polyphenylene ether compound whose terminal is a vinylbenzyl group include "OPE-2St1200" and "OPE-2St2200" available from MITSUBISHI GAS CHEMICAL COMPANY, INC. As the modified polyphenylene ether compound whose terminal is a vinylbenzyl group, a compound, obtained by modifying the hydroxyl group at a terminal of a polyphenylene ether compound, such as "SA90" available from SABIC Innovative Plastics, to a vinylbenzyl group using vinylbenzyl chloride or the like, can also be used.

In addition to the above description, regarding details of the polyphenylene ether compound having a carbon-carbon unsaturated double bond at a terminal, reference can be made to the description of JP 2006-028111 A, JP 2018-131519 A, WO 2019/138992, and WO 2022/054303, the contents of which are incorporated herein by reference.

The polyphenylene ether compound having a carbon-carbon unsaturated double bond at a terminal (preferably, the modified polyphenylene ether compound (g)) preferably has a number average molecular weight of from 500 to 3000 by GPC (gel permeation chromatography) method calibrated with polystyrene standards (the details are according to the method described in Examples described later). When the number average molecular weight is 500 or more, stickiness tends to be further prevented when the resin composition of the present embodiment is formed into a coating film. When the number average molecular weight is 3000 or less, solubility in a solvent tends to be further improved.

A weight average molecular weight of the polyphenylene ether compound having a carbon-carbon unsaturated double bond at a terminal (preferably, the modified polyphenylene ether compound (g)) by GPC calibrated with polystyrene standards is preferably from 800 to 10000 and more preferably from 800 to 5000. When the weight average molecular weight is the above lower limit or more, the relative permittivity (Dk) and dielectric loss tangent (Df) of a cured product of the resin composition tend to further decrease, whereas when the weight average molecular weight is the above upper limit or less, the solubility of the resin composition in a solvent, and the low viscosity properties and the moldability of the resin composition tend to further improve during production of the below-described varnish.

Furthermore, in the polyphenylene ether compound (preferably, the modified polyphenylene ether compound (g)) having a carbon-carbon unsaturated double bond at a terminal, a carbon-carbon unsaturated double bond equivalent at a terminal is preferably from 400 to 5000 g, and more preferably from 400 to 2500 g, per carbon-carbon unsaturated double bond. When a terminal carbon-carbon unsaturated double bond equivalent is the above lower limit or more, the relative permittivity (Dk) and dielectric loss tangent (Df) of a cured product of the resin composition tend to further decrease, whereas when the terminal carbon-carbon unsaturated double bond equivalent is the above upper limit or less, the solubility of the resin composition in a solvent, and the low viscosity properties and the moldability of the resin composition tend to further improve.

The functional group equivalent (equivalent of carbon-carbon unsaturated double bond) in the polyphenylene ether compound having a carbon-carbon unsaturated double bond at a terminal is calculated from the inverse of the amount of double bonds, which is determined from the measurement results using an infrared spectrometer.

The double bond equivalent [g/eq.] was determined as follows.

Powder of the polyphenylene ether compound is weighed, and the weight is recorded. The powder is put into a measuring flask, and then the volume is increased to a predetermined amount with carbon disulfide to prepare a measurement sample. The sample solution is placed in a measurement cell and set in an infrared spectrophotometer (FT/IR-4600, available from JASCO Corporation). Subsequently, the sample solution is subjected to infrared spectrometry. In the case of the vinyl group in the polyphenylene ether compound, the peak area of the spectrum around 905 $cm^{-1}$ is recorded. When the carbon-carbon unsaturated double bond has a methacrylic group, the peak area of the spectrum around 1640 $cm^{-1}$ is recorded. From the area values and the calibration curve, a double bond concentration [mol/L] is obtained as a measured value.

Subsequently, the double bond equivalent is calculated by the following equation.

Double bond equivalent [g/eq.] = weight of powder in measurement sample [g]/double bond concentration [mol/L] $\times$ volume of measurement sample solution [L]

The functional group equivalents of other thermosetting compounds (C) can also be determined according to the method described above. However, in a compound (monomer) that can be represented by a single molecular weight, a value determined by calculating a functional group equivalent by (theoretical molecular weight $\div$ number of functional groups) is preferentially adopted. When two or more thermosetting compounds (C) are contained, the functional group equivalent of the thermosetting compound (C) is a sum (weighted average value) of values obtained by multiplying the functional group equivalent of each thermosetting compound (C) by a mass fraction.

When the resin composition of the present embodiment contains the polyphenylene ether compound having a carbon-carbon unsaturated double bond at a terminal, the lower limit of the content thereof is preferably 1 part by mass or

more, more preferably 5 parts by mass or more, still more preferably 10 parts by mass or more, even more preferably 20 parts by mass or more, and further more preferably 25 parts by mass or more, with respect to 100 parts by mass of the resin solid content in the resin composition. When the content is the above lower limit or more, the moldability of the resin composition, and the thermal resistance, the low water absorption, and the low dielectric properties (Dk and/or Df) of the resulting cured product tend to be further improved. In addition, the upper limit of the content of the polyphenylene ether compound having a carbon-carbon unsaturated double bond at a terminal is preferably 90 parts by mass or less, and more preferably 80 parts by mass or less, with respect to 100 parts by mass of the resin solid content in the resin composition, and may be 70 parts by mass or less, 60 parts by mass or less, 50 parts by mass or less, 40 parts by mass or less, or 35 parts by mass or less, depending on the intended use and the like. When the content is the above upper limit or less, the low dielectric properties (especially low dielectric loss tangent) and chemical resistance of the resulting cured product tend to be further improved.

The resin composition of the present embodiment may contain only one of, or two or more of the polyphenylene ether compounds having a carbon-carbon unsaturated double bond at a terminal. When two or more types are contained, the total amount is preferably in the range described above.

<<(Meth)allyl compound>>

The resin composition of the present embodiment may contain a (meth)allyl compound. The (meth)allyl compound preferably contains an allyl compound.

The (meth)allyl compound is preferably a compound containing two or more (meth)allyl groups, and more preferably a compound containing two or more allyl groups.

The (meth)allyl compound preferably contains at least one selected from the group consisting of a (meth)allyl isocyanurate compound, a tri(meth)allyl cyanurate compound, a (meth)allyl group-substituted nadiimide compound, a (meth)allyl compound having a glycoluril structure, and diallyl phthalate, more preferably contains at least one selected from the group consisting of a (meth)allyl isocyanurate compound, a (meth)allyl group-substituted nadiimide compound, and a (meth)allyl compound having a glycoluril structure, still more preferably contains a (meth)allyl isocyanurate compound and/or a (meth)allyl group-substituted nadiimide compound, and even more preferably contains a (meth)allyl group-substituted nadiimide compound.

Examples of the tri(meth)allyl cyanurate compound include a tri(meth)allyl cyanurate compound (for example, triallyl cyanurate having the following structure).

[Chem. 63]

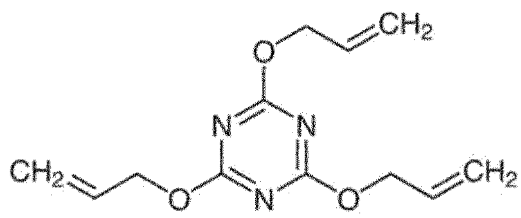

Examples of the (meth)allyl compound include a resin having an allyl group described in WO 2022/210095 (for example, compounds described in Synthesis Examples 3, 4, 6, 20, and 22 of the same publication), the contents of which are incorporated herein by reference.

When the resin composition of the present embodiment contains a (meth)allyl compound, the molecular weight thereof is preferably 195 or more, more preferably 300 or more, and may be 400 or more or 500 or more. When the molecular weight is the above lower limit or more, low dielectric properties and thermal resistance tend to be further improved. The molecular weight of the (meth)allyl compound is preferably 3000 or less, more preferably 2000 or less, still more preferably 1000 or less, and even more preferably 800 or less. When the molecular weight is the above upper limit or less, low thermal expansion tends to be further improved.

When the resin composition of the present embodiment contains a (meth)allyl compound, the content thereof is preferably 1 part by mass or more, more preferably 3 parts by mass or more, still more preferably 5 parts by mass or more, and may be 10 parts by mass or more, with respect to 100 parts by mass of the resin solid content in the resin composition. When the content of the (meth)allyl compound is the above lower limit or more, moldability tends to be excellent, and thermal resistance tends to be further improved. The upper limit of the content of the (meth)allyl compound is preferably 40 parts by mass or less, more preferably 30 parts by mass or less, and still more preferably 20 parts by mass or less, with

respect to 100 parts by mass of the resin solid content in the resin composition. When the content of the (meth)allyl compound is the above upper limit or less, low thermal expansion tends to be further improved.

The resin composition of the present embodiment may contain only one type or two or more types of the (meth) allyl compound. When two or more types are contained, the total amount is preferably in the range described above.

<<<(Meth)allyl isocyanurate compound>>>

The (meth)allyl isocyanurate compound is not particularly limited as long as it is a compound having two or more (meth)allyl groups and having an isocyanurate ring (nurate skeleton). Since the (meth)allyl isocyanurate compound has a large number of (meth)allyl groups as crosslinking points, the (meth)allyl isocyanurate compound tends to be firmly cured together with the resin (A) and the thermosetting compound (C), so that a cured product having excellent low dielectric properties (Dk and/or Df) and thermal resistance is produced. The (meth)allyl isocyanurate compound is preferably a compound represented by Formula (TA).

Formula (TA)

[Chem.64]

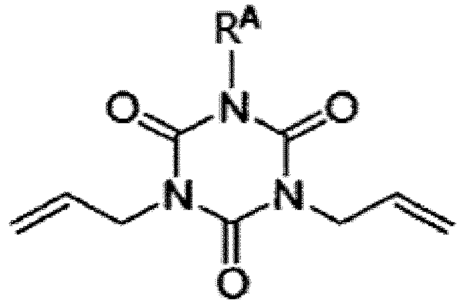

(In Formula (TA), $R^A$ represents a substituent.)

In Formula (TA), $R^A$ represents a substituent, and is more preferably a substituent having a formula weight from 15 to 500.

A first example of $R^A$ is an alkyl group having from 1 to 22 carbon atoms or an alkenyl group having from 2 to 22 carbon atoms. By using an allyl compound having an alkyl group having from 1 to 22 carbon atoms or an alkenyl group having from 2 to 22 carbon atoms, it is possible to provide a resin composition capable of obtaining a cured product having excellent crosslinkability and high toughness. As a result, even when a substrate such as glass cloth is not included in the resin composition, it is possible to suppress cracking during etching treatment or the like.

The number of carbon atoms in the alkyl group and/or the alkenyl group is preferably 3 or more, and more preferably 8 or more, and may be further 12 or more or 18 or less from the viewpoint of improving handleability. Accordingly, it is considered that the resin flowability of the resin composition is improved, and the resin composition is more excellent in circuit filling properties and the like when a multilayer circuit board or the like is produced using the resin composition of the present embodiment.

A second example of $R^A$ is a group containing an allyl isocyanurate group. When $R^A$ contains an allyl isocyanurate group, the compound represented by Formula (TA) is preferably a compound represented by Formula (TA-1).

Formula (TA-1)

[Chem.65]

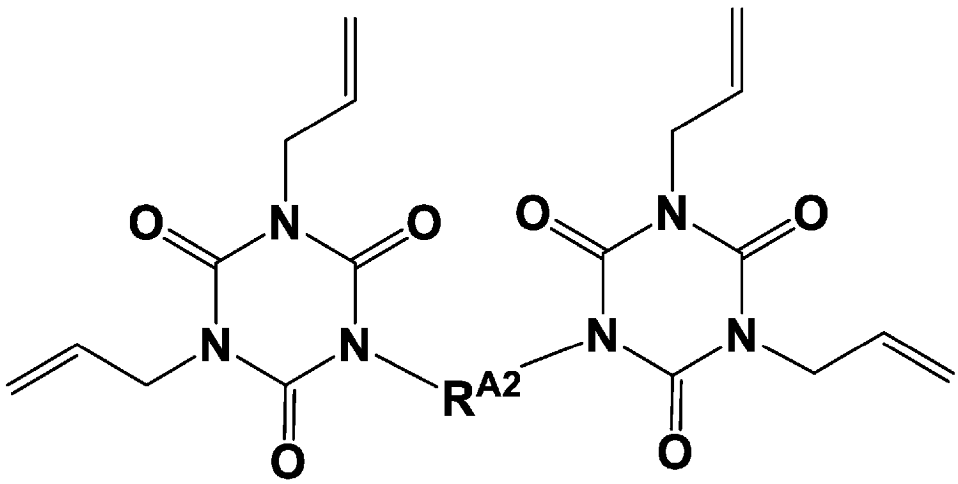

(In Formula (TA-1), $R^{A2}$ is a divalent linking group.)

In Formula (TA-1), $R^{A2}$ is preferably a divalent linking group having a formula weight of from 54 to 250, more preferably a divalent linking group having a formula weight of from 54 to 250 and having carbon atoms at both terminals, and still more preferably an aliphatic hydrocarbon group having from 2 to 20 carbon atoms (however, the aliphatic hydrocarbon group may contain an ether group or may have a hydroxyl group). More specifically, $R^{A2}$ is preferably a group represented by any one of Formulas (i) to (iii) below.

[Chem.66]

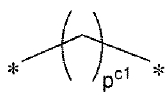

(i)

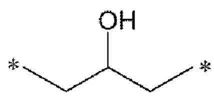

(ii)

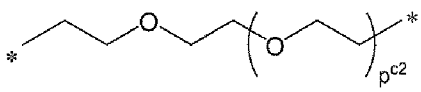

(iii)

(In Formulas (i) to (iii), $p^{c1}$ represents the number of repeating units of a methylene group, and is an integer of from 2 to 18. $p^{c2}$ represents the number of repeating units of an oxyethylene group, and is 0 or 1. * is a bonding position.)

The $p^{c1}$ is preferably an integer of from 2 to 10, more preferably an integer of from 3 to 8, and still more preferably an integer of from 3 to 5.

$p^{c2}$ may be 0 or 1, and is preferably 1.

A third example of $R^A$ is a phosphorus-based substituent.

$R^{A2}$ is preferably the first example.

In the present embodiment, the reactive group (allyl group) equivalent of the compound represented by Formula (TA) is preferably 1000 g/eq. or less. It is considered that a high Tg can be more reliably obtained when the equivalent is 1000 g/eq. or less.

Examples of the alkyl group having from 1 to 22 carbon atoms include linear or branched alkyl groups, and examples thereof include a methyl group, an ethyl group, a propyl group, a butyl group, a pentyl group, a hexyl group, a heptyl group, an octyl group, a nonyl group, a decyl group, a dodecyl group, a tetradecyl group, a hexadecyl group, an octadecyl group, an eicosyl group, and a docosyl group. Examples of the alkenyl group having from 2 to 22 carbon atoms include an allyl group and a decenyl group.

Specific examples of the compound represented by Formula (TA) include triallyl isocyanurate, 5-octyl-1,3-diallyl isocyanurate, 5-dodecyl-1,3-diallyl isocyanurate, 5-tetradecyl-1,3-diallyl isocyanurate, 5-hexadecyl-1,3-diallyl isocyanurate, 5-octadecyl-1,3-diallyl isocyanurate, 5-eicosyl-1,3-diallyl isocyanurate, 5-docosyl-1,3-diallyl isocyanurate, and 5-decenyl-1,3-diallyl isocyanurate. For these, one type may be used, or two or more types may be used in combination. These may be used as prepolymers.

The method for producing the compound represented by Formula (TA) is not particularly limited, and for example, the compound can be obtained by reacting diallyl isocyanurate and an alkyl halide in an aprotic polar solvent, such as N,N'-dimethylformamide, in the presence of a basic substance, such as sodium hydroxide, potassium carbonate, or triethylamine, at a temperature of about from 60°C to 150°C.

As the compound represented by Formula (TA), a commercially available product can also be used. The commercially available product is not particularly limited, and examples thereof include L-DAIC available from Shikoku Chemicals Corporation and P-DAIC having a phosphorus-based substituent available from Shikoku Chemicals Corporation. Examples of the triallyl isocyanurate include TAIC available from Shinryo Corporation. Examples of the compound represented by Formula (TA-1) include DD-1 available from Shikoku Chemicals Corporation.

The molecular weight of the (meth)allyl isocyanurate compound (preferably, the compound represented by Formula (TA)) is preferably 200 or more, more preferably 300 or more, and may be 400 or more or 500 or more. When the molecular weight is the above lower limit or more, the resulting cured product tends to have further improved low dielectric properties (Dk and/or Df) and thermal resistance. The molecular weight of the (meth)allyl isocyanurate compound (preferably, the compound represented by Formula (TA)) is preferably 3000 or less, more preferably 2000 or less, still more preferably 1000 or less, and even more preferably 800 or less. When the molecular weight is the above upper limit or less, the resulting cured product tends to have further improved low thermal expansion.

When the resin composition of the present embodiment contains a (meth)allyl isocyanurate compound, the content of the compound is preferably 1 part by mass or more, more preferably 3 parts by mass or more, still more preferably 5 parts by mass or more, and may be 10 parts by mass or more, with respect to 100 parts by mass of the resin solid content in the resin composition. When the content of the (meth)allyl isocyanurate compound is the above lower limit or more, the resin composition tends to have excellent moldability, and the thermal resistance and low thermal expansion of the resulting cured product tend to further improve. The upper limit of the content of the (meth)allyl isocyanurate compound is preferably 40 parts by mass or less, and more preferably 30 parts by mass or less, and may be 20 parts by mass or less, with respect to 100 parts by mass of the resin solid content in the resin composition. When the content of the (meth)allyl isocyanurate compound is the above upper limit or less, the thermal resistance and low dielectric properties (Dk and/or Df) of the resulting cured product tend to further improve.

The resin composition of the present embodiment may contain only one (meth)allyl isocyanurate compound, or may contain two or more (meth)allyl isocyanurate compounds. When two or more types are contained, the total amount is preferably in the range described above.

<<<(Meth)allyl group-substituted nadiimide compound>>>

The (meth)allyl group-substituted nadiimide compound is not particularly limited as long as it is a compound having two or more (meth)allyl group-substituted nadiimide groups per molecule. Specific examples thereof include a compound represented by Formula (AN-1) below.

Formula (AN-1)

[Chem.67]

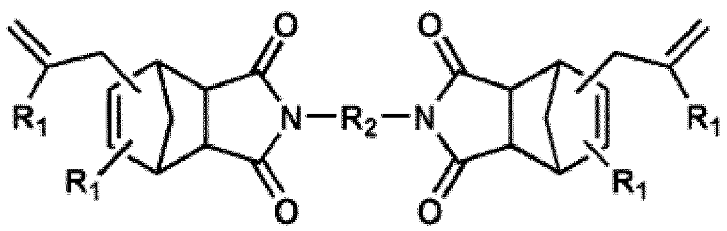

(In Formula (AN-1), each $R^1$ independently represents a hydrogen atom or an alkyl group having from 1 to 6 carbon atoms, and $R^2$ represents an alkylene group having from 1 to 6 carbon atoms, a phenylene group, a biphenylene group, a naphthylene group, or a group represented by Formula (AN-2) or (AN-3).)

Formula (AN-2)

[Chem.68]

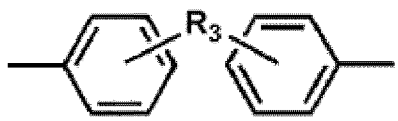

(In Formula (AN-2), $R^3$ represents a methylene group, an isopropylidene group, or a group represented by -C(=O)-, -O-, -S-, or $-S(=O)_2-$.)

Formula (AN-3)

[Chem.69]

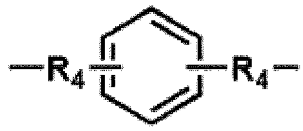

(In Formula (AN-3), each $R_4$ independently represents an alkylene group having from 1 to 4 carbon atoms or a cycloalkylene group having from 5 to 8 carbon atoms.)

As the compound represented by Formula (AN-1), a commercially available product can also be used. Examples of the commercially available compound include, but are not particularly limited to, a compound represented by Formula (AN-4) (BANI-M (available from Maruzen Petrochemical Co., Ltd.) and a compound represented by Formula (AN-5) (BANI-X (available from Maruzen Petrochemical Co., Ltd.). One of these may be used, or two or more may be used in combination.

Formula (AN-4)

[Chem.70]

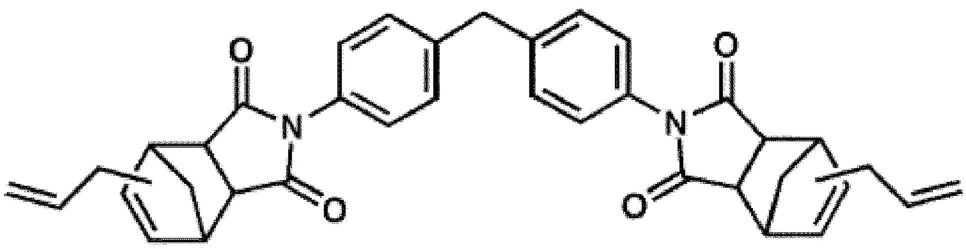

Formula (AN-5)

[Chem.71]

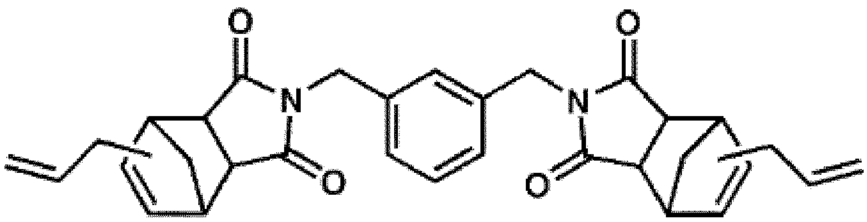

The molecular weight of the (meth)allyl group-substituted nadiimide compound (preferably, the compound represented by Formula (AN)) is preferably 400 or more, more preferably 500 or more, and may be 550 or more. When the molecular weight of the (meth)allyl group-substituted nadiimide compound is the above lower limit or more, the low dielectric properties, the low thermal expansion, and the thermal resistance tend to be further improved. The molecular weight of the (meth)allyl group-substituted nadiimide compound (preferably, the compound represented by Formula (AN))

is preferably 1500 or less, more preferably 1000 or less, and still more preferably 800 or less, and may be 700 or less or 600 or less. When the molecular weight of the (meth)allyl group-substituted nadiimide compound is the above upper limit or less, moldability and peel strength tend to be further improved.

When the resin composition of the present embodiment contains the (meth)allyl group-substituted nadiimide compound (preferably the compound represented by Formula (AN-1)), the content of the compound is preferably 1 part by mass or more, more preferably 3 parts by mass or more, and still more preferably 5 parts by mass or more, and may be 10 parts by mass or more, with respect to 100 parts by mass of the resin solid content in the resin composition. When the content of the (meth)allyl group-substituted nadiimide compound is the above lower limit or more, the moldability tends to be excellent, and the low dielectric properties, the low thermal expansion, and the thermal resistance tend to be further improved. The upper limit of the content of the (meth)allyl group-substituted nadiimide compound (preferably, the compound represented by Formula (AN-1)) is preferably 40 parts by mass or less, more preferably 30 parts by mass or less, and still more preferably 25 parts by mass or less, and may be 20 parts by mass or less, with respect to 100 parts by mass of the resin solid content in the resin composition. When the content of the (meth)allyl group-substituted nadiimide compound is the above upper limit or less, the moldability and the peel strength tend to be further improved.

The resin composition of the present embodiment may contain only one (meth)allyl group-substituted nadiimide compound, or may contain two or more (meth)allyl group-substituted nadiimide compounds. When two or more types are contained, the total amount is preferably in the range described above.

<<<(Meth)allyl compound having glycoluril structure>>>

The (meth)allyl compound having a glycoluril structure is not particularly limited as long as it is a compound containing two or more glycoluril structures and two or more (meth)allyl groups. Even when the (meth)allyl compound having a glycoluril structure is blended in the resin composition, the number of (meth)allyl groups can be increased, that is, the number of crosslinking points can be increased. Thus, similarly to the (meth)allyl isocyanurate compound, the (meth) allyl compound having a glycoluril structure tends to be firmly cured together with the resin (A) and the thermosetting compound (C), so that a cured product having excellent low dielectric properties (Dk and/or Df) and thermal resistance is produced.

In the present embodiment, the (meth)allyl compound having a glycoluril structure is preferably a compound represented by Formula (GU).

Formula (GU)

[Chem.72]

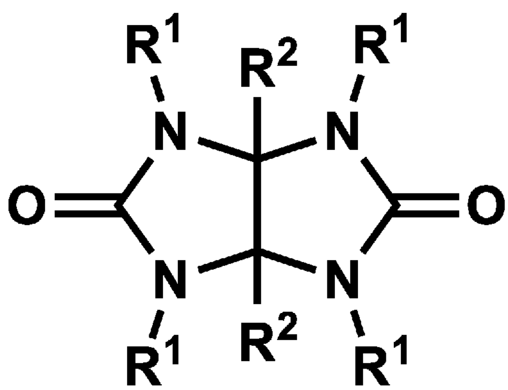

(In Formula (GU), each $R^1$ is independently a hydrogen atom or a substituent, and at least two of $R^1$ are groups containing a (meth)allyl group. each $R^2$ independently represents a hydrogen atom, an alkyl group, or an aryl group.)

In Formula (GU), each $R^1$ is independently preferably a hydrogen atom, an alkyl group having from 1 to 5 carbon atoms, or an alkenyl group having from 2 to 5 carbon atoms, preferably an alkenyl group having from 2 to 5 carbon atoms, more preferably a (meth)allyl group, and still more preferably an allyl group.

In Formula (GU), preferably, three or four of $R^1$ are groups containing a (meth)allyl group, and more preferably, four of R are groups containing a (meth)allyl group.

In Formula (GU), each $R^2$ is independently preferably a hydrogen atom, an alkyl group having from 1 to 4 carbon atoms, or a phenyl group, and more preferably a hydrogen atom or a methyl group.

Specific examples of the compound represented by Formula (GU) include 1,3,4,6-tetraallylglycoluril (a compound where R is all allyl groups in Formula (GU)).

As the (meth)allyl compound having a glycoluril structure, a commercially available product can also be used. The commercially available compound is not particularly limited, and examples thereof include TA-G available from Shikoku Chemicals Corporation.

The molecular weight of the (meth)allyl compound having a glycoluril structure (preferably, the compound represented by Formula (GU)) is preferably 195 or more, more preferably 220 or more, and still more preferably 250 or more, and may be 300 or more or 400 or more. When the molecular weight of the (meth)allyl compound having a glycoluril structure is the above lower limit or more, the thermal resistance and low thermal expansion of the resulting cured product tend to further improve. The molecular weight of the (meth)allyl compound having a glycoluril structure (preferably, the compound represented by Formula (GU)) is also preferably 1500 or less, more preferably 1000 or less, still more preferably 800 or less, and may be 700 or less or 600 or less. When the molecular weight of the (meth)allyl compound having a glycoluril structure is the above upper limit or less, the low dielectric properties (Dk and/or Df) and the thermal resistance of the resulting cured product tend to be further improved.

When the resin composition of the present embodiment contains the (meth)allyl compound having a glycoluril structure (preferably, the compound represented by Formula (GU)), the content of the compound is preferably 1 part by mass or more, more preferably 3 parts by mass or more, and still more preferably 5 parts by mass or more, and may be 10 parts by mass or more, with respect to 100 parts by mass of the resin solid content in the resin composition. When the content of the (meth)allyl compound having a glycoluril structure is the above lower limit or more, the resin composition tends to have excellent moldability, and the thermal resistance and low thermal expansion of the resulting cured product tend to further improve. The upper limit of the content of the (meth)allyl compound having a glycoluril structure (preferably, the compound represented by Formula (GU)) is preferably 40 parts by mass or less, more preferably 30 parts by mass or less, and still more preferably 25 parts by mass or less, and may be 20 parts by mass or less, with respect to 100 parts by mass of the resin solid content in the resin composition. When the content of the (meth)allyl compound having a glycoluril structure is the above upper limit or less, the low dielectric properties (Dk and/or Df) of the resulting cured product tend to further improve.

The resin composition of the present embodiment may contain only one (meth)allyl compound having a glycoluril structure, or may contain two or more (meth)allyl compounds having a glycoluril structure. When two or more types are contained, the total amount is preferably in the range described above.

<<(Meth)acrylate compound>>

The resin composition of the present embodiment may contain a (meth)acrylate compound. However, a (meth) acrylate compound, also corresponding to a polyphenylene ether compound having a carbon-carbon unsaturated double bond at a terminal, is classified into the polyphenylene ether compound having a carbon-carbon unsaturated double bond at a terminal.

The (meth)acrylate compound may contain either or both of a monofunctional (meth)acrylate compound and a polyfunctional (meth)acrylate compound.

Examples of the monofunctional (meth)acrylate compound include an unsaturated epoxy (meth)acrylate compound having a (meth)acryloyl group, a urethane (meth)acrylate compound, a polyether (meth)acrylate compound, a polyalcohol (meth)acrylate compound, an alkyd (meth)acrylate compound, a polyester (meth)acrylate compound, a spiroacetal (meth)acrylate compound, and a silane coupling agent having a (meth)acryloyloxy group (for example, 3-acryloxypropyltrimethoxysilane).

On the other hand, the polyfunctional (meth)acrylate compound means a compound containing two or more (meth)acryloyloxy groups in one molecule, and preferably contains three or more (meth)acryloyloxy groups in one molecule.

The polyfunctional (meth)acrylate compound is preferably a compound having three to five (meth)acryloyloxy groups, more preferably a compound having three or four (meth)acryloyloxy groups, and still more preferably a compound having three (meth)acryloyloxy groups. The (meth)acrylate compound is preferably a compound having a methacryloyloxy group.

Since the polyfunctional (meth)acrylate compound has a large number of (meth)acrylate groups as crosslinking points, the polyfunctional (meth)acrylate compound is firmly cured with the resin (A) and the thermosetting compound (C), and a cured product excellent in low dielectric properties (Dk and/or Df) and thermal resistance can be obtained. The polyfunctional (meth)acrylate compound is preferably a compound represented by Formula (MA).

Formula (MA)

[Chem.73]

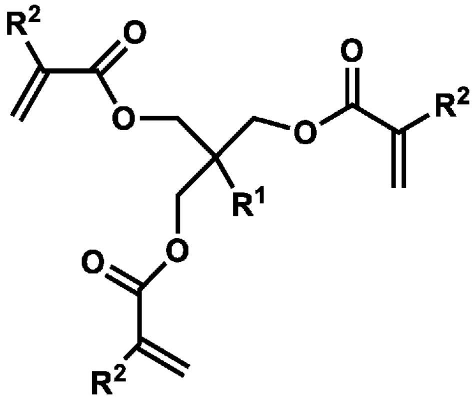

(In Formula (MA), $R^1$ represents a hydrogen atom or a substituent, and each $R^2$ independently represents a hydrogen atom or a methyl group.)

In Formula (MA), $R^1$ represents a hydrogen atom or a substituent, and is preferably a substituent having a formula weight from 15 to 500, more preferably a substituent having a formula weight from 15 to 300, still more preferably a substituent having a formula weight from 15 to 100, and yet still more preferably a substituent having a formula weight from 15 to 50.

$R^1$ is preferably a hydrocarbon group or a (meth)acryloyloxy group, more preferably a hydrocarbon group having 22 or fewer carbon atoms, and still more preferably an alkyl group having from 1 to 22 carbon atoms or an alkenyl group having from 2 to 22 carbon atoms. By using a compound having an alkyl group having from 1 to 22 carbon atoms or an alkenyl group having from 2 to 22 carbon atoms, it is possible to provide a resin composition capable of obtaining a cured product having excellent crosslinkability and high toughness. As a result, even when a substrate such as glass cloth is not included in the resin composition, it is possible to suppress cracking during etching treatment or the like.

The number of carbon atoms in the alkyl group and/or the alkenyl group is preferably 2 or more, may be 8 or more. Further, the number of carbon atoms may be 12 or more or, and may be 18 or less, from the viewpoint of improving handleability. Accordingly, it is considered that the resin flowability of the resin composition is improved, and the resin composition is more excellent in circuit filling properties and the like when a multilayer circuit board or the like is produced using the resin composition of the present embodiment.

In the present embodiment, the (meth)acrylic group equivalent of the compound represented by Formula (MA) is preferably 1000 g/eq. or less. When the equivalent is 1000 g/eq. or less, a high Tg tends to be obtained more reliably. The lower limit of the (meth)acrylic group equivalent is, for example, 99 g/eq. or more.

The alkyl group having from 1 to 22 carbon atoms is preferably a linear alkyl group having from 1 to 22 carbon atoms, or a branched alkyl group having from 3 to 22 carbon atoms, and examples thereof include a methyl group, an ethyl group, a propyl group, a butyl group, a pentyl group, a hexyl group, a heptyl group, an octyl group, a nonyl group, a decyl group, a dodecyl group, a tetradecyl group, a hexadecyl group, an octadecyl group, an eicosyl group, and a docosyl group. The alkenyl group having from 2 to 22 carbon atoms is preferably an alkenyl group having from 2 to 15 carbon atoms, and examples thereof include an allyl group and a decenyl group.

Specific examples of the compound represented by Formula (MA) include trimethylolpropane trimethacrylate, trimethylolpropane triacrylate, and pentaerythritol tetra(meth)acrylate. For these, one type may be used, or two or more types may be used in combination. These may be used as prepolymers.

As the compound represented by Formula (MA), a commercially available product can also be used. The commercially available product is not particularly limited, and examples of trimethylolpropane trimethacrylate include "NK Ester TMPT" available from Shin-Nakamura Chemical Co., Ltd.

The molecular weight of the polyfunctional (meth)acrylate compound is preferably 200 or more, more preferably 300 or more, and may be 330 or more, 400 or more, or 500 or more. When the molecular weight is the above lower limit or more, the resulting cured product tends to have further improved low dielectric properties (Dk and/or Df) and thermal resistance. The molecular weight of the (meth)acrylate compound (preferably, the compound represented by Formula (MA)) is preferably 3000 or less, more preferably 2000 or less, still more preferably 1000 or less, and still more preferably 800 or less. When the molecular weight is the above upper limit or less, the resulting cured product tends to have further improved low thermal expansion.

For the (meth)acrylate compound, reference can be made to: in addition to the above, the resin having a (meth)acrylic group described in WO 2022/210095 (for example, compounds described in Synthesis Examples 5 and 21 of the same publication); the resin having a (meth)acrylic group described in JP 6962507 B2 (for example, compounds described in Examples 1 to 9); the compound described in paragraph 0049 of JP 2019-194312 A; the resin having a methacrylic group described in WO 2023/089976; and the resin having a methacrylic group described in WO 2022/234455, the contents of which are incorporated herein.

When the resin composition of the present embodiment contains the (meth)acrylate compound, the content of the compound is preferably 1 part by mass or more, more preferably 3 parts by mass or more, still more preferably 5 parts by mass or more, and may be 10 parts by mass or more, with respect to 100 parts by mass of the resin solid content in the resin composition. When the content of the polyfunctional (meth)acrylate compound is the above lower limit or more, the resin composition tends to have excellent moldability, and the thermal resistance and low thermal expansion of the resulting cured product tend to further improve. The upper limit of the content of the (meth)acrylate compound is preferably 40 parts by mass or less, and more preferably 30 parts by mass or less, and may be 20 parts by mass or less, with respect to 100 parts by mass of the resin solid content in the resin composition. When the content of the (meth)acrylate compound is the above upper limit or less, the thermal resistance and low dielectric properties (Dk and/or Df) of the resulting cured product tend to be further improved.

The resin composition of the present embodiment may contain only one type or two or more types of the (meth) acrylate compound. When two or more types are contained, the total amount is preferably in the range described above.

<<Additional compound (compound (XC)) having carbon-carbon unsaturated double bond at terminal other than resin (A)>>

The resin composition of the present embodiment may contain the additional compound (compound (XC)) having a carbon-carbon unsaturated double bond at a terminal other than the resin (A) described above.

An example of the compound (XC) is a low molecular aromatic vinyl compound.

Examples of the aromatic vinyl compound include methylstyrene (for example, 4-methylstyrene), ethylvinylbenzene, diethyl 4-vinylbenzylphosphonate, 4-vinylbenzyl glycidyl ether, α-methylstyrene, 4-tert-butylstyrene, divinylbenzene, 1,2-bis(4-vinylphenyl)ethane (BVPE), vinylbenzyl ether, 1,3-diisopropenylbenzene, and 1,4-diisopropenylbenzene, and 4-methylstyrene, 4-tert-butylstyrene, divinylbenzene, and 1,2-bis(4-vinylphenyl)ethane are preferable.

The resin having an isopropenyl group described in WO 2022/210095 (for example, compounds described in Synthesis Examples 1, 2, 7, and 8 of the same publication) is exemplified, the contents of which are incorporated herein by reference.

Another example of another compound (compound (XC)) having a carbon-carbon unsaturated double bond at a terminal other than the resin (A) is viny benzyl ether.

Examples of the vinylbenzyl ether include a reaction product produced from a reaction of 4,4'-isopropylidene bis(2,6-dimethylphenol) (tetramethyl bisphenol A), hexamethylbiphenol (2,2',3,3',5,5'-hexamethyl-(1,1'-biphenyl)-4,4'-diol), 2,6-dihydroxynaphthalene, or the like with vinylbenzyl chloride and/or vinylbenzyl bromide.

In addition, resorcinol, catechol, hydroquinone, 2,7-dihydroxynaphthalene, 2-(diphenylphosphoryl)hydroquinone, bis(2,6-dimethylphenol), 2,2'-biphenol, 4,4-biphenol, 2,2',6,6'-tetramethylbiphenol, 3,3',5,5'-tetrabromo-2,2'6,6'-tetramethylbiphenol, 3,3'-dibromo-2,2',6,6'-tetramethylbiphenol, 4,4'-isopropylidene bis(2,6-dibromophenol) (tetrabromobisphenol A), 4,4'-isopropylidene bis (2,6-dimethylphenol) (tetramethyl bisphenol A), 4,4'-isopropylidene bis(2-methylphenol), 4,4'-isopropylidene bis (2-allylphenol), 4,4'(1,3-phenylenediisopropylidene)bisphenol (bisphenol M), 4,4'-isopropylidene bis (3-phenylphenol), 4,4'-(1,4-phenylenediisopropylidene)bisphenol (bisphenol P), 4,4'-ethylidenediphenol (bisphenol E), 4,4'-oxydiphenol, 4,4'-thiodiphenol, 4,4'-thiobis(2,6-dimethylphenol), 4,4'-sulfonyldiphenol, 4,4'-sulfonylbis (2,6-dimethylphenol), 4,4'-sulfinyldiphenol, 4,4'-hexafluoroisopropylidene) bisphenol (bisphenol AF), 4,4'(1-phenylethylidene)bisphenol (bisphenol AP), bis(4-hydroxyphenyl)-2,2-dichloroethylene (bisphenol C), bis(4-hydroxyphenyl)methane (bisphenol-F), bis(2,6-dimethyl-4-hydroxyphenyl) methane, 4,4'-(cyclopentylidene)diphenol, 4,4'-(cyclohexylidene)diphenol (bisphenol Z), 4,4'-(cyclododecylidene)diphenol, 4,4'-(bicyclo [2.2.1] heptylidene)diphenol, 4,4'-(9H-fluorene-9,9-diyl)diphenol, 3,3-bis(4-hydroxyphenyl)isobenzofuran-1(3H)-one, 1-(4-hydroxyphenyl)-3,3-dimethyl-2,3-dihydro-1H-indene-5-ol, 1-(4-hydroxy-3,5-dimethylphenyl)-1,3,3,4,6-pentamethyl-2,3-dihydro-1H-indene-5-ol, 3,3,3',3'-tetramethyl-2,2',3,3'-tetrahydro-1,1'-spirobi[indene]-5,6'-diol (spirobiindane), dihydroxybenzophenone (bisphenol K), tris(4-hydroxyphenyl)methane, tris(4-hydroxyphenyl) ethane, tris(4-hydroxyphenyl)propane, tris(4-hydroxyphenyl)butane, tris(3-methyl-4-hydroxyphenyl)methane, tris(3,5-dimethyl-4-hydroxyphenyl)methane, tetrakis(4-hydroxyphenyl) ethane, tetrakis(3,5-dimethyl-4-hydroxyphenyl) ethane, bis(4-hydroxyphenyl)phenylphosphine oxide, dicyclopentadienyl bis(2,6-dimethylphenol), dicyclopentadienyl bis(o-cresol), and vinylbenzyl ether produced by the reaction of bisphenols or the like with vinylbenzyl chloride or vinylbenzyl bromide.

In addition to the above, the vinylbenzyl compound also includes the vinylbenzyl ether compound described in paragraph 0041 of JP 2019-194312 A, the contents of which are incorporated herein by reference.

In addition to the above, a compound having vinylphenyl at a terminal described in WO 2022/210095 (for

example, the compound described in Synthesis Examples 12 to 16 of the same publication), a vinyl benzyl ether resin described in paragraphs 0029 to 0039 of JP 2022-85610 A and paragraph 0041 of JP 2019-194312 A, a copolymerized oligomer described in paragraphs 0013 to 0027 of WO 2022/014599, a copolymer described in JP 2024-007493 A, a compound described in WO 2021/100658, a compound described in JP 2024-086554 A, and the like can also be used, the contents of which are incorporated herein by reference.

Another example of the compound (XC) is a perfluorovinyl ether resin.

Examples of the perfluorovinyl ether resin include perfluorovinylbenzyl ether resin. For details thereof, the perfluorovinyl ether resins and the like described in paragraph [0043] of JP 2019-194312 A are exemplified, the contents of which are incorporated herein by reference.

Another example of the compound (XC) is a compound (additional indane resin (XC1)) having an indane skeleton having a carbon-carbon unsaturated double bond at a terminal other than the resin (A).

An example of the additional indane resin (XC1) is a resin having an indane skeleton, and is preferably a resin represented by Formula (T-St).

[Chem.74]

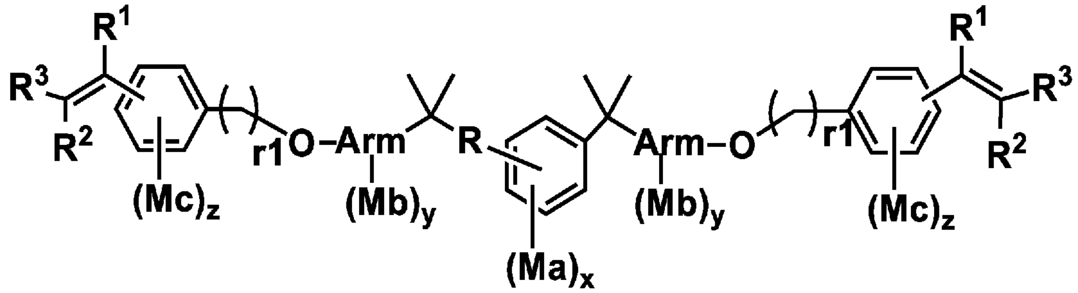

(T-St)

(In Formula (T-St), R is a group containing a structural unit represented by Formula (Tx-St). each Arm independently represents a benzene ring, a naphthalene ring, or an anthracene ring. each Ma independently represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. each Mc independently represents a hydrocarbon group having from 1 to 12 carbon atoms. x, y, and z each independently represent an integer of from 0 to 4. r1 represents an integer of from 1 to 6. $R^1$, $R^2$, and $R^3$ each independently represent a hydrogen atom, an alkyl group, an alkenyl group, or an alkynyl group.)

[Chem.75]

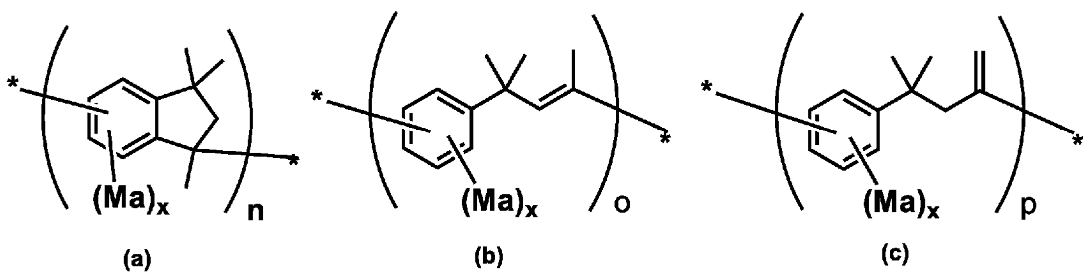

(Tx-St)

(In Formula (Tx-St), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. The structural unit is bonded to the structural unit (a), (b), or (c), or an additional group, and structural units may be randomly bonded.)

In Formula (T-St), R is a group containing structural units represented by Formula (Tx-St).

In Formula (Tx-St), n, o, and p each mean an average number of repeating units in all molecules in the resin.

In Formula (Tx-St), the sum of n, o, and p is preferably $1.1 \leq n + o + p$, more preferably $1.2 \leq n + o + p$, still more preferably $1.5 \leq n + o + p$, even more preferably $2.0 \leq n + o + p$, further more preferably $2.5 \leq n + o + p$, still further more preferably $3.0 \leq n + o + p$, and particularly preferably $3.3 \leq n + o + p$, and, in addition, the order of $3.5 \leq n + o + p$, $3.7 \leq n + o + p$, $4.0 \leq n + o + p$, and $4.2 \leq n + o + p$ is more preferred. In Formula (Tx-St), the sum of n, o, and p is also preferably $n + o + p \leq$

20.0, more preferably $n + o + p \leq 10.0$, still more preferably $n + o + p \leq 8.0$, even more preferably $n + o + p \leq 7.0$, further more preferably $n + o + p \leq 6.5$, and still further more preferably $n + o + p \leq 6.4$. The sum of n, o, and p can be calculated by the method described in Examples below. In Formula (Tx-St), the sum of n, o, and p is usually the same as the sum of n, o, and p in Formula (Tx).

In Formula (Tx-St), Ma and x have the same meanings as Ma and x in Formula (Tx) described above, respectively, and the preferred ranges thereof are also the same.

In Formula (T-St), each Arm is independently a benzene ring, a naphthalene ring, or an anthracene ring, and is preferably a benzene ring or a naphthalene ring, and more preferably a benzene ring.

When Arm is a benzene ring and y is an integer of from 1 to 4, it is preferable that an OH group bonded to Arm and Mb are bonded to each other at one or two of an ortho-position and a para position (preferably at least one or two ortho positions).

In Formula (T-St), each Ma independently represents a hydrocarbon group having from 1 to 12 carbon atoms, each carbon atom being optionally substituted with a halogen atom, and is synonymous with Ma in Formula (Tx), and a preferred range is also the same.

In Formula (T-St), each Mb independently represents a hydroxyl group, a halogen atom, or a hydrocarbon group having from 1 to 20 carbon atoms, each carbon atom being optionally substituted with a hydroxyl group or a halogen atom, and is preferably a hydroxyl group, a halogen atom, or a hydrocarbon group having from 1 to 20 carbon atoms, each carbon atom being optionally substituted with a halogen atom, and more preferably a hydroxyl group, a fluorine atom, a chlorine atom, a bromine atom, an iodine atom, a linear or branched alkyl group having from 1 to 10 carbon atoms, an alicyclic alkyl group having from 4 to 8 carbon atoms, a cumyl group, a phenyl group, or a benzyl group. The halogen atom is preferably a fluorine atom, a chlorine atom, a bromine atom, or an iodine atom, and more preferably a fluorine atom or a chlorine atom. The linear or branched alkyl group having from 1 to 10 carbon atoms is preferably a methyl group, an ethyl group, an isopropyl group, an isobutyl group, a t-butyl group, a pentyl group, an octyl group, or a nonyl group. As the alicyclic alkyl group having from 4 to 8 carbon atoms, a cyclohexyl group is preferable. In the present embodiment, Mb is more preferably a hydroxyl group, a linear or branched alkyl group having from 1 to 10 carbon atoms, or a benzyl group, and still more preferably a hydroxyl group, a methyl group, an ethyl group, an isopropyl group, an isobutyl group, a t-butyl group, or a benzyl group.

In Formula (T-St), each Mc independently represents a hydrocarbon group having from 1 to 12 carbon atoms, and is preferably a hydrocarbon group having from 1 to 10 carbon atoms, more preferably a linear or branched alkyl group having from 1 to 10 carbon atoms, still more preferably a methyl group, an ethyl group, an isopropyl group, an isobutyl group, a t-butyl group, a pentyl group, an octyl group, or a nonyl group, and yet still more preferably a methyl group, an ethyl group, an isopropyl group, an isobutyl group, or a t-butyl group.

In Formula (T-St), x has the same meaning as x in Formula (Tx), and the preferred range thereof is also the same.

In Formula (T-St), each y independently represents an integer of from 0 to 4, and is preferably an integer of from 0 to 3 and more preferably an integer of from 0 to 2.

In Formula (T-St), each z independently represents an integer of from 0 to 4, and is preferably an integer of from 0 to 3, more preferably an integer of from 0 to 2, still more preferably 0 or 1, and yet still more preferably 0.

In Formula (T-St), r1 represents an integer of from 1 to 6, preferably an integer of from 1 to 5, more preferably an integer of from 1 to 4, still more preferably an integer of from 1 to 3, further preferably 1 or 2, and yet further preferably 1.

In Formula (T-St), $R^1$, $R^2$, and $R^3$ each independently represent a hydrogen atom, an alkyl group, an alkenyl group, or an alkynyl group, and are each preferably a hydrogen atom or an alkyl group, more preferably a hydrogen atom or a methyl group, and still more preferably a hydrogen atom. The number of carbon atoms of the alkyl group, the alkenyl group, or the alkynyl group as $R^1$, $R^2$, or $R^3$ is preferably 5 or less, and more preferably 3 or less.

In the present embodiment, Formula (T-St) is preferably represented by Formula (T-St2).

[Chem.76]

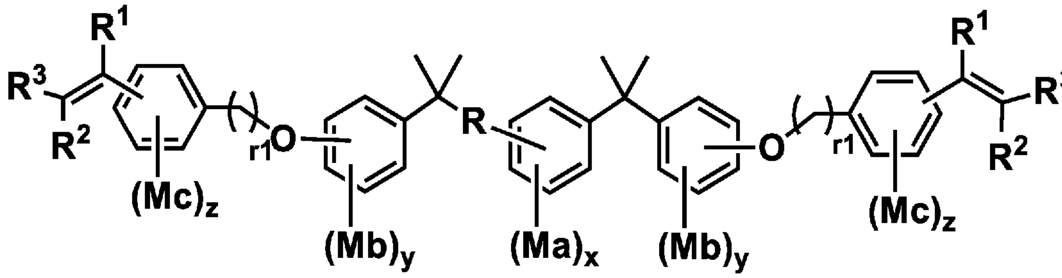

(T-St2)

(In Formula (T-St2), R is a group containing a structural unit represented by Formula (Tx-St). each Ma independently

represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. each Mc independently represents a hydrocarbon group having from 1 to 12 carbon atoms. x, y, and z each independently represent an integer of from 0 to 4. r1 represents an integer of from 1 to 6. $R^1$, $R^2$, and $R^3$ each independently represent a hydrogen atom, an alkyl group, an alkenyl group, or an alkynyl group.)

[Chem.77]

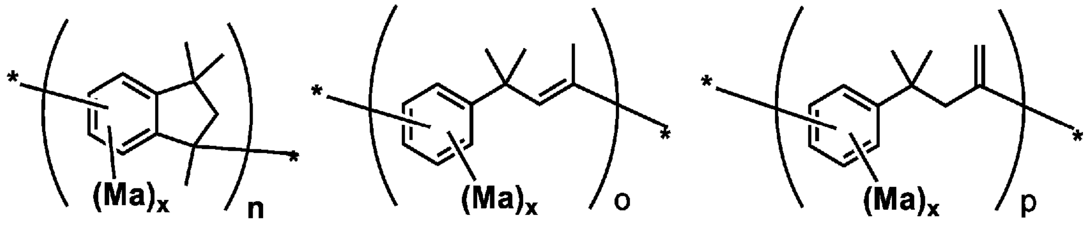

(a) (b) (c) (Tx-St)

(In Formula (Tx-St), n, o, and p are average numbers of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. The structural unit is bonded to the structural unit (a), (b), or (c), or an additional group, and structural units may be randomly bonded.)

In Formula (T-St2), R, Ma, Mb, Mc, x, y, z, r1, $R^1$, $R^2$, and $R^3$ have the same meanings as R, Ma, Mb, Mc, x, y, z, r1, $R^1$, $R^2$, and $R^3$ in Formula (T-St), respectively, and the preferred ranges thereof are also the same.

The resin represented by Formula (T-St) preferably has parameter $\alpha$ calculated from Equation ($\alpha$) of 0.55 or more and 1.00 or less.

[Num.8]

$$\text{PARAMETER}\ \alpha = \frac{(2.55ppm \text{ to } 2.31ppm)}{(6.24ppm \text{ to } 5.91ppm) + (2.98ppm \text{ to } 2.55ppm)/2 + (2.55ppm \text{ to } 2.31ppm)} \qquad (\alpha)$$

(Expressions in parentheses in Equation ($\alpha$) indicate integral values between corresponding chemical shift values in $^1$H-NMR.)

Here, $\alpha$ represents a ratio of the structural unit (the structural unit (a) in Formula (Tx-St)) having an indane skeleton. More specifically, it is presumed that when the proportion of the structural unit having an indane skeleton is adjusted so as to satisfy the range of the parameter $\alpha$, the rigidity of the resulting resin molecule can be enhanced, and the glass transition temperature of a cured product can be increased.

The parameter $\alpha$ in the resin represented by Formula (T-St) is preferably 0.57 or more, more preferably 0.59 or more, still more preferably 0.60 or more, and further preferably 0.62 or more, and may be 0.65 or more, 0.70 or more, 0.75 or more, or 0.80 or more. When the parameter $\alpha$ is the above lower limit or more, the resulting cured product tends to have further improved low dielectric properties (low relative permittivity and/or low dielectric loss tangent) and thermal resistance. The parameter $\alpha$ is preferably large because the resulting cured product tends to have substantially excellent low dielectric properties and thermal resistance. However, the parameter $\alpha$ may be 0.95 or less, 0.94 or less, 0.93 or less, or 0.92 or less.

Another example of the compound having an indane skeleton having a carbon-carbon unsaturated double bond at a terminal other than the resin (A) includes a resin (hereinafter, it may be referred to as "resin (IP1)") containing a structural unit derived from a compound represented by Formula (DIP) as a main component and having a structure represented by Formula (In-1) and/or Formula (In-2).

[Chem.78]

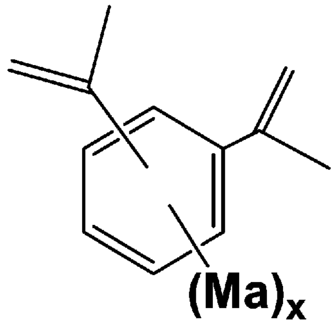

(DIP)

(In Formula (DIP), each Ma independently represents a hydrocarbon group having from 1 to 12 carbon atoms, each carbon atom being optionally substituted with a halogen atom, and x represents an integer of from 0 to 4.)

[Chem.79]

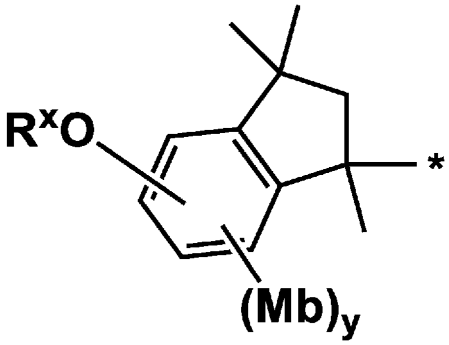

(In-1)

(In Formula (In-1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 3. $R^x$ is a group containing a carbon-carbon unsaturated double bond. * is a bonding position for another moiety.)

[Chem.80]

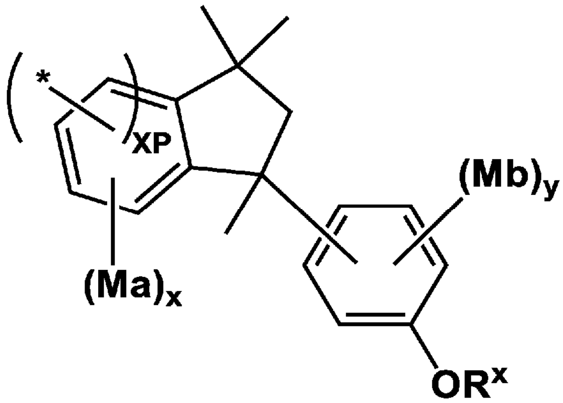

(In-2)

(In Formula (In-2), each Ma independently represents a hydrocarbon group having from 1 to 12 carbon atoms, each carbon atom being optionally substituted with a halogen atom. x represents an integer of from 0 to 3. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4. $R^x$ is a group containing a carbon-carbon unsaturated double bond. xp is the number of binders from the benzene ring, and is an integer of 1 or 2. * is a bonding position for another moiety.)

Here, another moiety means a moiety other than the structure represented by Formula (In-1) and/or Formula (In-2) contained in the resin (IP1). The same applies to other moieties in the section of the resin (IP1).

In the resin (IP1), it is presumed that, ($R^x$), a group containing a carbon-carbon unsaturated double bond at a terminal, and a structural unit derived from the compound represented by Formula (DIP) (in particular, a structural unit derived from a compound represented by Formula (DIP) and having an indane skeleton (preferably a trimethylindane structure (the same applies to the preferred range of the indane skeleton hereinafter))) are bonded via a low-molecular-weight structural unit such as an oxygen atom and/or a phenyleneoxy group optionally having a substituent, thereby increasing the content proportion of the structural unit derived from the compound represented by Formula (DIP) (in particular, indane skeleton) in the cured product of the resin composition containing the resin (IP1), and Df (dielectric loss tangent) can thus be lowered. In particular, it is presumed that a low Df can be achieved even when the curing temperature is high. Further, the resin (IP1) can have excellent thermal resistance. The resin (IP1) can also have a low relative permittivity (Dk).

It is needless to say that the structural unit derived from the compound represented by Formula (DIP) may be synthesized from the compound represented by Formula (DIP) or may be synthesized from another raw material that gives the structural unit derived from the compound represented by Formula (DIP). Examples of the compound represented by Formula (DIP) include 1,3-diisopropenylbenzene and 1,4-diisopropenylbenzene. Examples of another raw material for providing the structural unit derived from the compound represented by Formula (DIP) include an equivalent of a compound represented by Formula (DIP), such as α,α'-dihydroxy-1,3-diisopropylbenzene, α,α'-dihydroxy-1,4-diisopropylbenzene α,α'-dihalogeno-1,3-diisopropylbenzene (for example α,α'-dichloro-1,3-diisopropylbenzene), α,α'-dihalogeno-1,4-diisopropylbenzene (for example α,α'-dichloro-1,4-diisopropylbenzene), α,α'-dialkoxy-1,3-diisopropylbenzene (for example α,α'-dimethoxy-1,3-diisopropylbenzene), and α,α'-dialkoxy-1,4-diisopropylbenzene (for example α, α'-dimethoxy-1,4-diisopropylbenzene), which provides a compound represented by Formula (DIP) through a unit operation such as heating. In the present embodiment, among the above, 1,3-diisopropenylbenzene and α,α'-dihydroxy-1,3-diisopropylbenzene are preferable. One type of the above-described compounds may be used alone, or two or more types thereof may be used in combination.

First, Formula (DIP) will be described.

[Chem.81]

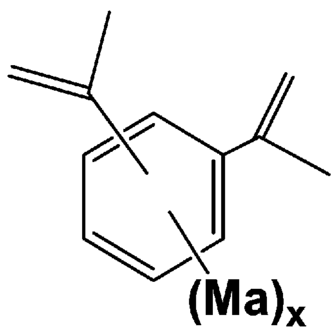

(DIP)

(In Formula (DIP), each Ma independently represents a hydrocarbon group having from 1 to 12 carbon atoms, each carbon atom being optionally substituted with a halogen atom. x represents an integer of from 0 to 4.)

The resin (IP1) may contain a plurality of structural units derived from the compound represented by Formula (DIP), and in this case, Ma and x may be the same or different.

In Formula (DIP), each Ma independently represents a hydrocarbon group having from 1 to 12 carbon atoms, each carbon atom being optionally substituted with a halogen atom, has the same meaning as Ma in Formula (T1-1) described above, and the preferred range is also the same.

In Formula (DIP), x represents an integer of from 0 to 4, and is preferably an integer of from 0 to 3, more preferably an integer of from 0 to 2, still more preferably 0 or 1, and yet still more preferably 0.

In the resin (IP1), a structural unit derived from the compound represented by Formula (DIP) is used as a main component. The phrase "used as a main component" means that the structural unit derived from the compound represented by Formula (DIP) accounts for the largest proportion among all the structural units constituting the resin (IP1). More specifically, the content of the structural unit derived from the compound represented by Formula (DIP) in the resin (IP1) is preferably 50 mol% or higher, more preferably 60 mol% or higher, still more preferably 70 mol% or higher, yet still more preferably 80 mol% or higher, yet still more preferably 82 mol% or higher, yet still more preferably 83 mol% or higher, and particularly preferably 85 mol% or higher of the total structural unit.

Here, the total structural unit means the total amount of structural units derived from all monomer molecules used as the raw material of the resin (IP1).

The resin (IP1) further has a structure represented by Formula (In-1) and/or Formula (In-2). These groups are usually present as terminal groups. Since the resin (IP1) has the structure represented by Formula (In-1) and/or Formula (In-2), the structural unit derived from the compound represented by Formula (DIP) is bonded to ($R^x$), which is the group containing a carbon-carbon unsaturated double bond, via a low-molecular-weight structural unit such as an oxygen atom and/or a phenyleneoxy group optionally having a substituent, and it is presumed that Df (dielectric loss tangent) can thus be lowered, and it is also presumed that low Df can be achieved even when the curing temperature is high, as described above.

As long as the resin (IP1) has a structure represented by Formula (In-1) and/or Formula (In-2), the resin (IP1) may have a terminal group of another structure.

[Chem.82]

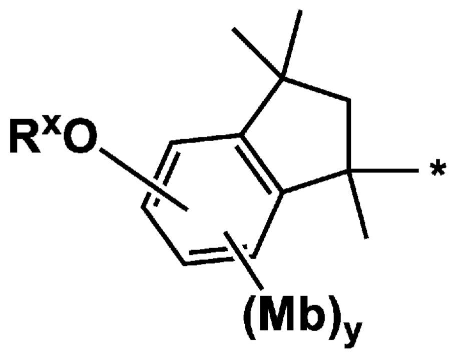

(In-1)

(In Formula (In-1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 3. $R^x$ is a group containing a carbon-carbon unsaturated double bond. * is a bonding position for another moiety.)

[Chem.83]

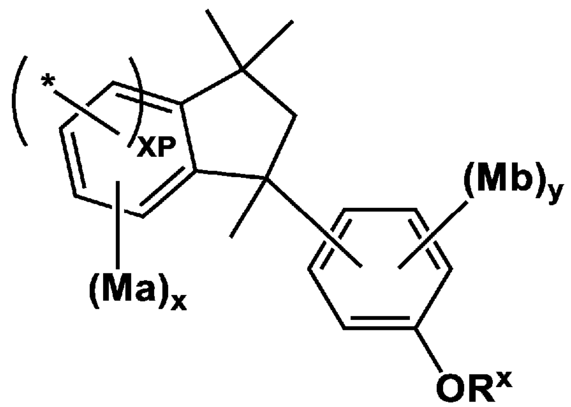

(In-2)

(In Formula (In-2), each Ma independently represents a hydrocarbon group having from 1 to 12 carbon atoms optionally substituted with a halogen atom. x represents an integer of from 0 to 3. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4. $R^x$ is a group containing a carbon-carbon unsaturated double bond. xp is the number of binders from the benzene ring, and is an integer of 1 or 2. * is a bonding position for another moiety.)

In Formula (In-1), each Mb independently represents a hydroxyl group, a halogen atom, or a hydrocarbon group having from 1 to 20 carbon atoms, each carbon atom being optionally substituted with a hydroxyl group or a halogen atom, and has the same meaning as Mb in Formula (T-St) described above, and the preferred range is also the same.

In Formula (In-1), y represents an integer of from 0 to 3, preferably an integer of from 0 to 2, more preferably 0 or 2, and may be 0. It is preferable that y is 2 from the viewpoint of dielectric properties.

When y is 1 or more, Mb is preferably bonded at an adjacent position (ortho position) to the carbon atom to which the $R^xO$ group is bonded.

In Formula (In-1), $R^x$ is a group containing a carbon-carbon unsaturated double bond, and more preferably a group having a formula weight from 27 to 120.

Specifically, each $R^x$ is independently preferably a group represented by Formula (Rx-11) or a group represented by Formula (Rx-2), more preferably a vinylbenzyl group or a (meth)acryloyl group, and still more preferably a vinylbenzyl group.

[Chem.84]

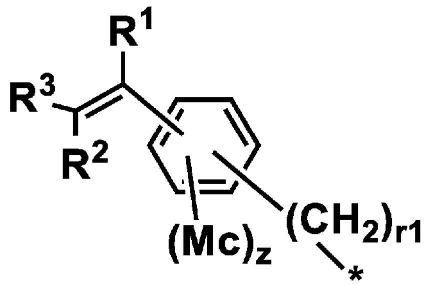

(Rx-11)

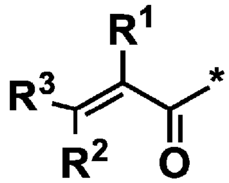

(Rx-2)

(In Formula (Rx-11) and Formula (Rx-2), $R^1$, $R^2$, and $R^3$ each independently represent a hydrogen atom, an alkyl group, an alkenyl group, or an alkynyl group. * is a bonding position for an oxygen atom. each Mc independently represents a hydrocarbon group having from 1 to 12 carbon atoms. z represents an integer of from 0 to 4. r1 represents an integer of from 1 to 6.)

Formulas (Rx-11) and (Rx-2) have the same meanings as Formulas (Rx-1) and (Rx-2) described in the section of the polyphenylene ether compound except for r1, and the preferred ranges thereof are also the same. r1 in Formula (Rx-11) is preferably an integer of 5 or less, more preferably an integer of 4 or less, still more preferably an integer of 3 or less, yet still more preferably 1 or 2, and further preferably 1.

In Formula (In-2), each Ma independently represents a hydrocarbon group having from 1 to 12 carbon atoms, each carbon atom being optionally substituted with a halogen atom, has the same meaning as Ma in Formula (T1), and the preferred range thereof is also the same.

In Formula (In-2), x represents an integer of from 0 to 3, preferably an integer of from 0 to 2, more preferably 0 or 1, and may be 0.

In Formula (In-2), Mb and $R^x$ have the same meaning as Mb and $R^x$ in Formula (In-1), respectively, and the preferred ranges thereof are also the same.

In Formula (In-2), y represents an integer of from 0 to 4, preferably an integer of from 0 to 3, more preferably an integer of from 0 to 2, still more preferably 0 or 2, and may be 0. It is preferable that y is 2 from the viewpoint of dielectric properties.

When y is 1 or more, Mb is preferably bonded at an adjacent position (ortho position) to the carbon atom to which the $R^xO$ group is bonded.

In Formula (In-2), xp is the number of binders from the benzene ring, and is an integer of 1 or 2. When xp is 2, for example, as set forth below, two groups derived from a benzene ring may be bonded to form a ring.

[Chem.85]

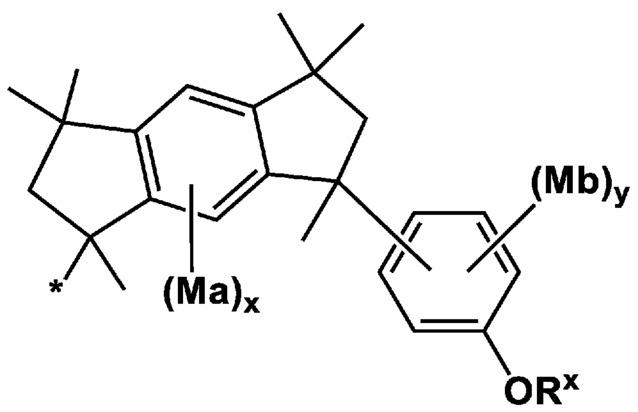

In the formula above, * is a bonding position for another site, $R^x$, Ma, x, Mb, and y have the same meaning as $R^x$,

Ma, x, Mb, and y in Formula (In-2), and the preferred ranges are also the same.

In Formula (In-1) and Formula (In-2), it is more preferable that formula weights of $R^x$ (a group containing a carbon-carbon unsaturated double bond) are each independently from 27 to 120 groups.

In the present embodiment, the number of $R^x$ in one molecule of the resin (IP1) is preferably 2.5 or more, more preferably more than 2.5, still more preferably 2.6 or more, yet still more preferably 2.7 or more, and yet still more preferably 2.8 or more on average. In addition, the number of $R^x$ in one molecule of the resin (IP1) is preferably 8.0 or less, more preferably 7.0 or less, still more preferably 6.5 or less, still more preferably 6.0 or less, and may be 5.5 or less on average. When the number of $R^x$ in one molecule of the resin (IP1) is within the above range, the resulting cured product tends to have further improved low dielectric properties (low relative permittivity and/or low dielectric loss tangent) and thermal resistance.

In the present embodiment, the resin (IP1) preferably includes both the structure represented by Formula (In-1) and the structure represented by Formula (In-2).

The resin (IP1) usually contains an indane skeleton other than the structure represented by Formula (In-1) and/or Formula (In-2). Such an indane skeleton other than the structure represented by Formula (In-1) and/or Formula (In-2) is usually formed by a cyclization reaction of the compound represented by Formula (DIP). That is, in the resin (IP1) of the present embodiment, at least a part of the structural unit derived from the compound represented by Formula (DIP) preferably contains an indane skeleton, and more preferably contains a structure represented by Formula (In-0).

[Chem.86]

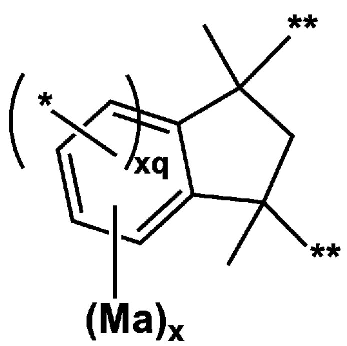

(In-0)

(In Formula (In-0), each Ma independently represents a hydrocarbon group having from 1 to 12 carbon atoms, each carbon atom being optionally substituted with a halogen atom. x represents an integer of from 0 to 3. xq is the number of binders from the benzene ring, and is an integer of 1 or 2. * is a bonding position for another moiety. ** is a bonding position for another moiety or a methyl group bonded to a cyclopentane ring. at least one of the two ** is a bonding position for another moiety.)

In Formula (In-0), Ma has the same meaning as Ma in Formula (DIP), and the preferred range thereof is also the same.

In Formula (In-0), x represents an integer of from 0 to 3, preferably an integer of from 0 to 2, more preferably 0 or 1, and may be 0.

In Formula (In-0), xq is the number of binders from the benzene ring, and is an integer of 1 or 2. When xq is 2, as described above, two groups derived from a benzene ring may be bonded to form a ring.

The content of the indane skeleton in the resin (IP1) is not particularly limited; however, when expressed by the parameter $\alpha$ described above, $\alpha$ is preferably 0.35 or more and 1.00 or less.

Specific examples of the structural unit derived from the compound represented by Formula (DIP) in the resin (IP1) include the following structural units (a) to (c) (hereinafter, may be referred to as Formula (Tx)) in addition to the structure represented by Formula (In-0). In Formula (Tx), * represents a bonding position for the structural units (a) to (c), the structure represented by Formula (In-1), the structure represented by Formula (In-2), the structure represented by Formula (In-0), a partial structure exemplified below, and the like.

[Chem.87]

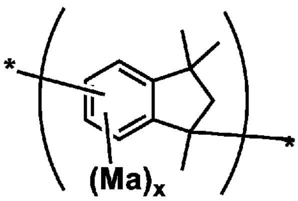

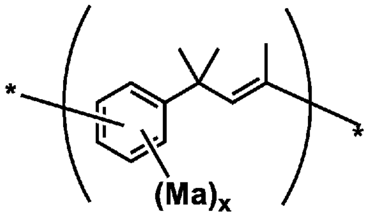

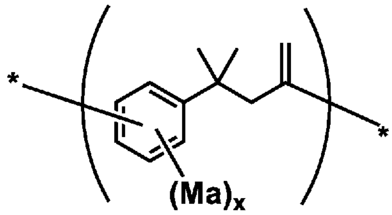

(Tx)

(a) (b) (c)

In the structural units (a) to (c), Ma and x each independently have the same meaning as Ma and x in Formula (DIP), and the preferred ranges thereof are also the same.

Specific examples of the structure containing a structural unit derived from the compound represented by Formula (DIP) in the resin (IP1) also include the following partial structures. It is needless to say that the structure including the structural unit derived from the compound represented by Formula (DIP) or the structural unit derived from the compound represented by Formula (DIP) in the resin (IP1) is not limited to these examples. Ma and x in formulas below each independently have the same meaning as Ma and x in Formula (DIP), and the preferred ranges are also the same.

[Chem.88]

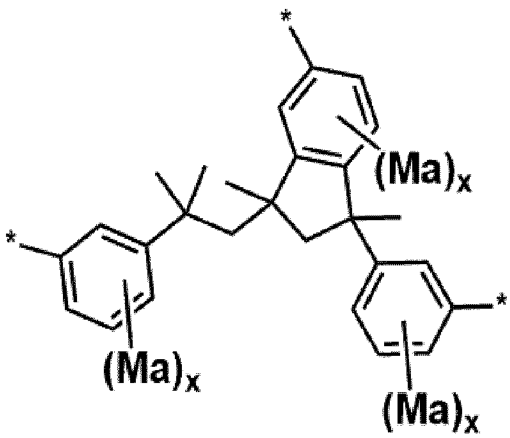

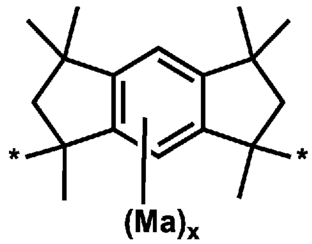

[Chem.89]

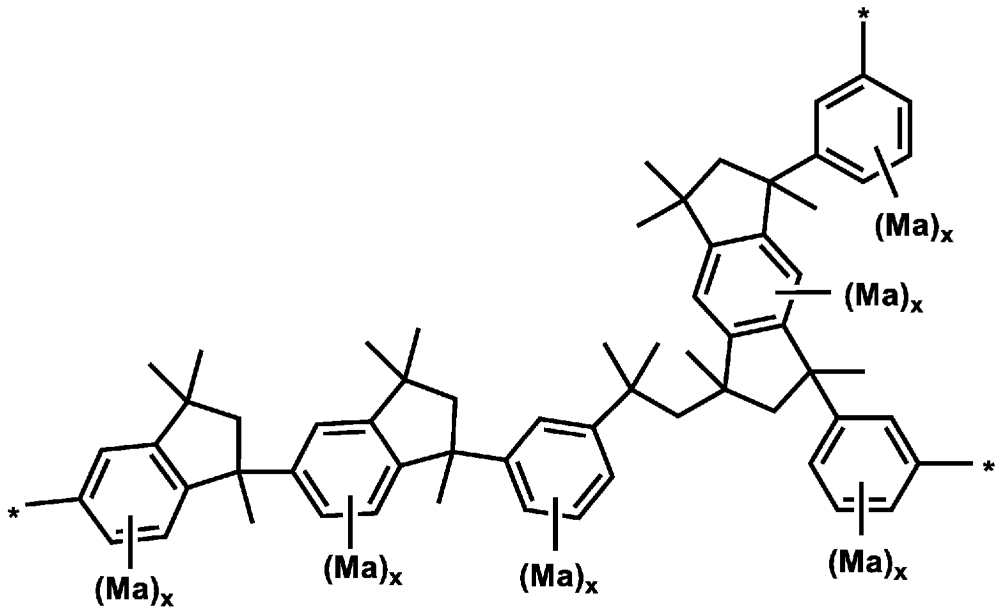

[Chem.90]

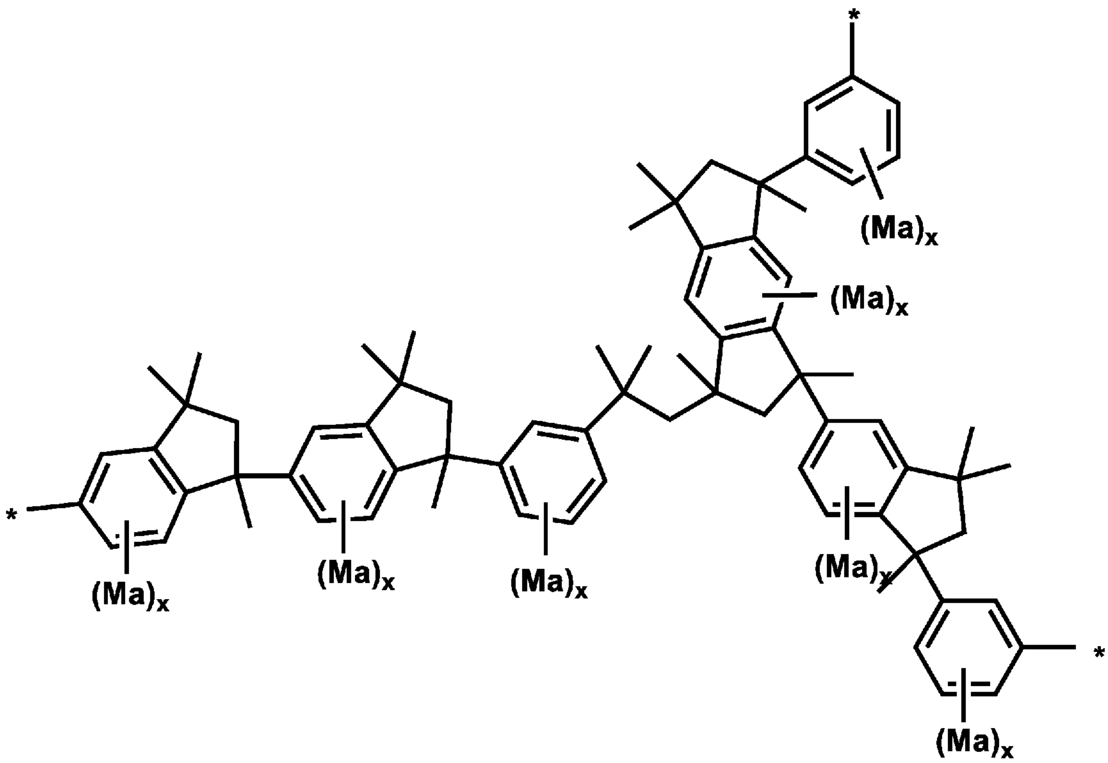

[Chem.91]

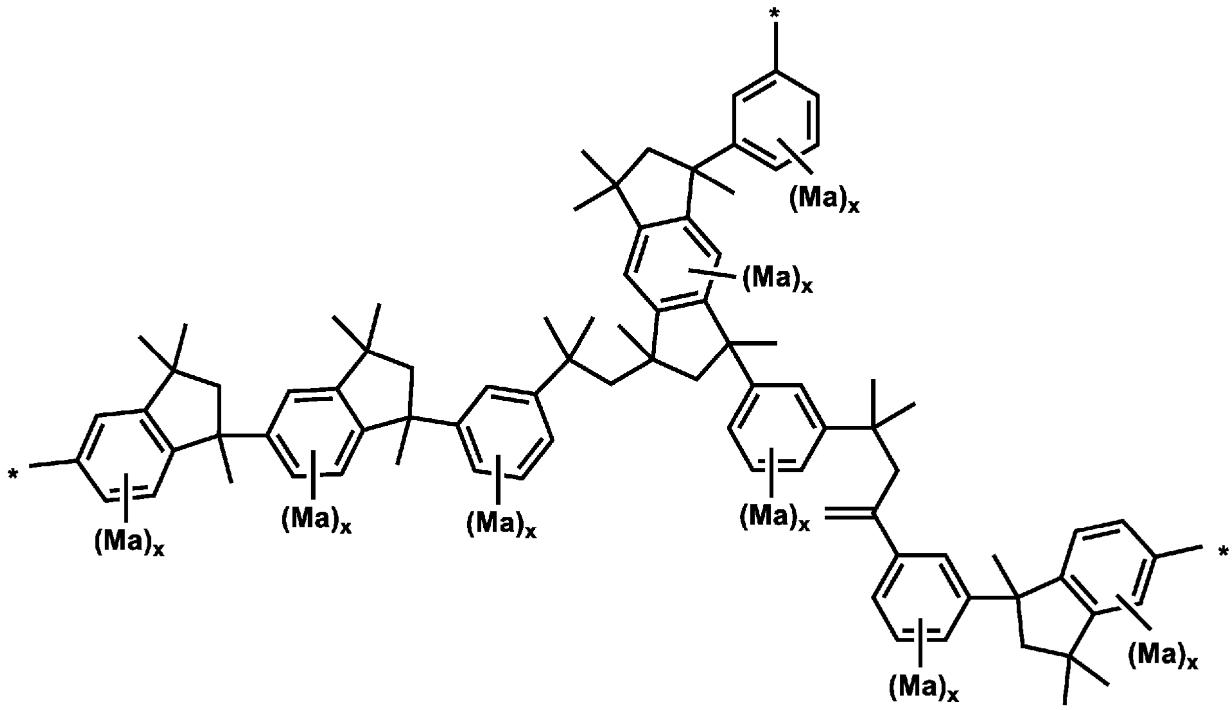

In the above formulas, * is a bonding position for another moiety.

Another example of the compound having an indane skeleton having a carbon-carbon unsaturated double bond at a terminal other than the resin (A) is a resin represented by Formula (D) (resin (IP2)). In such a resin (IP2), it is presumed that ($R^x$), a group containing a carbon-carbon unsaturated double bond at a terminal, a structural unit having an indane skeleton, and the like, are bonded via a low-molecular-weight structural unit such as an oxygen atom and/or a phenyleneoxy group optionally having a substituent, thereby increasing the content proportion of the indane skeleton (preferably a trimethylindane structure) in the cured product of the composition containing the resin (IP2), and the Df (dielectric loss tangent) can thus be lowered. In particular, it is presumed that a low Df can be achieved even when the curing temperature is high. Further, the resin of the present embodiment can have excellent thermal resistance. The resin (IP2) can also have a low relative permittivity (Dk). The resin (IP2) may be the same resin as the resin (IP1).

[Chem. 92]

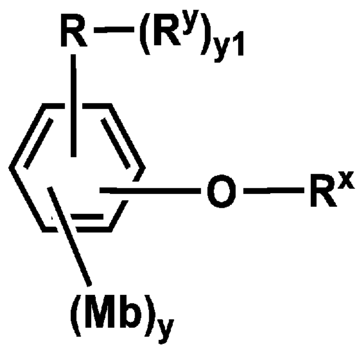

(D)

(In Formula (D), R is a group containing a structural unit represented by Formula (Tx). $R^x$ is a group containing a carbon-carbon unsaturated double bond. $R^y$ is a hydrogen atom, a group containing an -O-carbon-carbon unsaturated double bond, or another group. y1 is an integer of from 1 to 4. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.93]

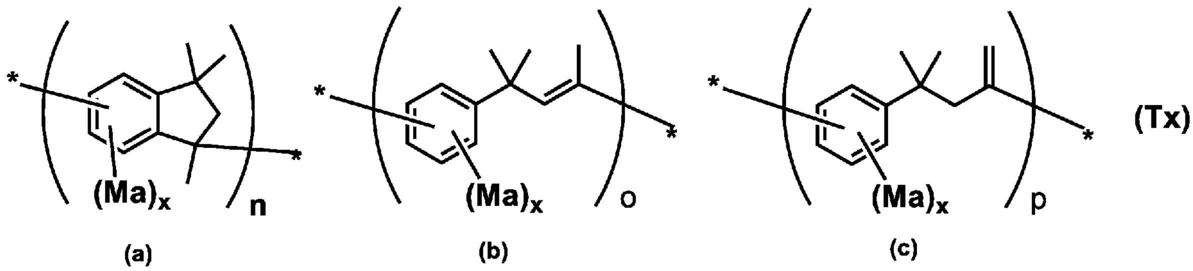

(In Formula (Tx), n, o, and p represent an average number of repeating units, n represents a number of more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded to the structural unit (a), (b), or (c), or an additional group by *, and structural units may be randomly bonded.)

In Formula (D), R is a group containing a structural unit represented by Formula (Tx).

That is, in the resin (IP2), R contains at least the structural unit (a) in a part thereof, and may further contain the structural units (b) and/or (c), and may further have another structural unit (hereinafter, it may be referred to as "additional structural unit") or another group other than the structural units (a), (b) or (c). That is, the structural units (a), (b), and (c) may be bonded to: any one of the structural units (a) to (c); the additional structural unit other than the structural units (a) to (c); another group; and a group bonded to R in Formula (D) at *, respectively.

In the resin (IP2), R is not necessarily linear, and may be bonded two-dimensionally or three-dimensionally. In the present embodiment, the resin (IP2) (in particular, a group containing a structural unit represented by Formula (Tx)) is preferably linear. When the respective structural units constituting the resin (IP2) are linearly bonded, low dielectric properties tend to improve, which is preferable.

Examples of another structural unit include a structural unit derived from a compound represented by Formula (DIP) which is bonded to any one of structural units (a), (b) and (c).

It is needless to say that the structural unit derived from the compound represented by Formula (DIP) may be synthesized from the compound represented by Formula (DIP) or may be synthesized from another raw material that gives the structural unit derived from the compound represented by Formula (DIP). Examples of another raw material for providing the structural unit derived from the compound represented by Formula (DIP) include equivalents of the compound represented by Formula (DIP), which provide the compound represented by Formula (DIP) through a unit operation such as heating, such as $\alpha,\alpha'$-dihydroxy-1,3-diisopropylbenzene, $\alpha,\alpha'$-dihalogeno-1,3-diisopropylbenzene, and $\alpha,\alpha'$-dialkoxy-1,3-diisopropylbenzene.

[Chem.94]

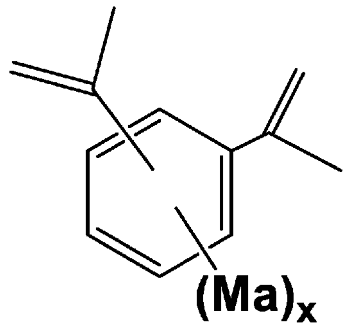

(DIP)

(In Formula (DIP), each Ma independently represents a hydrocarbon group having from 1 to 12 carbon atoms, each carbon atom being optionally substituted with a halogen atom. x represents an integer of from 0 to 4.)

The details of Formula (DIP) have the same meaning as described in the section of the resin (IP1), and the preferred range thereof is also the same.

When the resin (IP2) has an additional structural unit, the resin (IP2) may have a branched structure.

Further, in the resin (IP2), the double bond of the structural unit (b) and/or (c) may react with the structural unit derived from the compound represented by Formula (DIP) to form a ring, thereby constituting a structural unit having an indane skeleton. As an example of such a structure, for example, the following structure is exemplified.

[Chem.95]

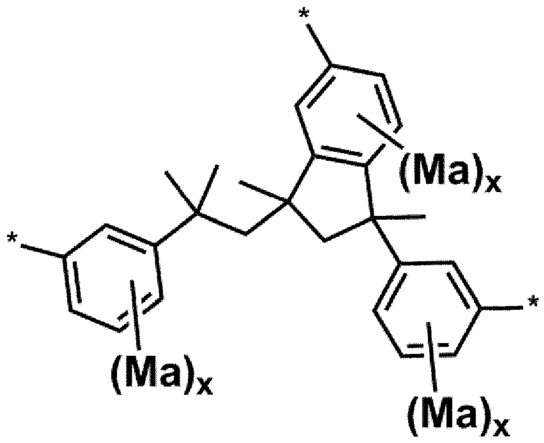

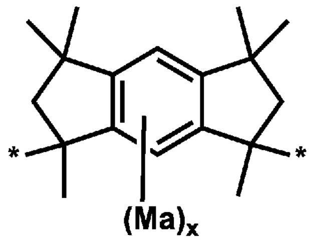

In the above structure, Ma and x each independently have the same meaning as Ma and x in Formula (Tx), and the preferred ranges are also the same.

In the above structure, * is preferably bonded to any one of the terminal groups bonded to R in Formula (D) or any of the structural units (a) to (c).

Further, a terminal group may be bonded to the structural unit (a), (b), or (c).

The resin (IP2) may contain the compound described below.

[Chem.96]

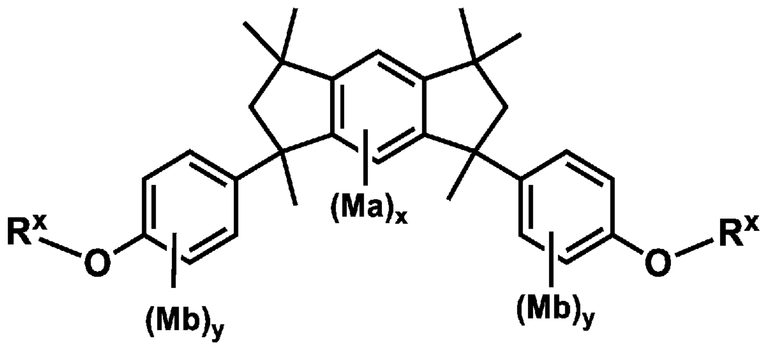

In the above-described compound, Ma and x have the same meanings as Ma and x in Formula (Tx), respectively, and the preferred ranges are also the same. Mb and y each independently have the same meaning as Mb and y in Formula (D) described in detail below, and the preferred ranges thereof are also the same. $R^x$ is a group containing a carbon-carbon unsaturated double bond.

Formula (Tx) has the same meaning as (Tx) described in the section of the resin (A), and the preferred range thereof is also the same.

In Formula (D), $R^x$ is a group containing a carbon-carbon unsaturated double bond, and more preferably a group having a formula weight from 27 to 120.

Specifically, each $R^x$ is independently preferably a group represented by Formula (Rx-11) or a group represented by Formula (Rx-2), more preferably a vinylbenzyl group or a (meth)acryloyl group, and still more preferably a vinylbenzyl group.

[Chem. 97]

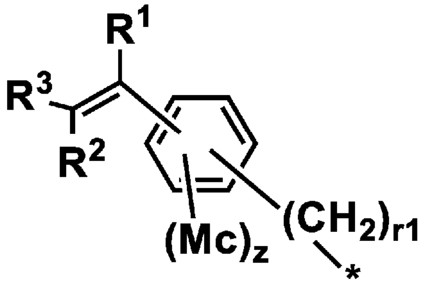

(Rx-11)

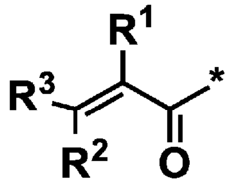

(Rx-2)

(In Formula (Rx-11) and Formula (Rx-2), $R^1$, $R^2$, and $R^3$ each independently represent a hydrogen atom, an alkyl group, an alkenyl group, or an alkynyl group. * is a bonding position for an oxygen atom. each Mc independently represents a hydrocarbon group having from 1 to 12 carbon atoms. z represents an integer of from 0 to 4. r1 represents an integer of from 1 to 6.)

Formulas (Rx-11) and (Rx-2) have the same meanings as Formulas (Rx-1) and (Rx-2) described in the section of the polyphenylene ether compound except for r1, and the preferred ranges thereof are also the same. r1 in Formula (Rx-11) is preferably an integer of 5 or less, more preferably an integer of 4 or less, still more preferably an integer of 3 or less, yet still more preferably 1 or 2, and further preferably 1.

In Formula (D), $R^y$ is a hydrogen atom, a group containing an -O-carbon-carbon unsaturated double bond, or another group.

$R^y$ is bonded to R at any position, but may be bonded to any one of the structural units (a), (b), or (c) contained in R and the additional structural unit described above. An example of an aspect in which R is bonded is an aspect in which R is bonded to a benzene ring of the structural unit (a), (b) or (c). Still another example of the aspect in which R is bonded is an aspect in which R is bonded to the additional structural unit other than the structural units (a), (b), or (c) included in R. In the resin of the present embodiment, preferably, at least one of $R^y$ is bonded to the benzene ring of the structural unit (a), (b) or (c), and more preferably, at least one of $R^y$ is bonded to the benzene ring of the structural unit (a).

When $R^y$ is a group containing an -O-carbon-carbon unsaturated double bond, the group containing a carbon-carbon unsaturated double bond has the same meaning as $R^x$ described above, and the preferred range thereof is also the same.

The number of groups containing a carbon-carbon unsaturated double bond in $R^y$ is preferably 0.2 or more, more preferably 0.3 or more, still more preferably 0.4 or more, yet still more preferably 0.5 or more, yet further preferably 0.8 or more, and may be 1.0 or more in terms of the average value of all molecules in the resin (IP2). The number of groups containing a carbon-carbon unsaturated double bond in $R^y$ is preferably 7 or less, more preferably 6 or less, still more preferably 5 or less, still more preferably 4 or less, and yet still more preferably 3 or less in terms of the average value of all molecules in the resin, and may be 2.5 or less, 1.5 or less, less than 1.5, 1.4 or less, or 1.2 or less.

When $R^y$ has another group, examples of another group include an organic group, a hydroxyl group, and a halogen atom. As the organic group, a hydrocarbon group having from 1 to 20 carbon atoms optionally substituted with a hydroxyl group or a halogen atom is preferable, a hydrocarbon group having from 1 to 5 carbon atoms, each carbon atom being optionally substituted with a hydroxyl group or a halogen atom, is more preferable, a saturated hydrocarbon group having from 1 to 5 carbon atoms is still more preferable, a saturated hydrocarbon group having from 1 to 3 carbon atoms is yet still more preferable, and a propyl group or an isopropyl group is yet still more preferable.

In Formula (D), y1 is an integer of from 1 to 4, preferably 1 or more, preferably 3 or less, more preferably 2 or less, and still more preferably 1.

The total number of groups containing a carbon-carbon unsaturated double bond contained in $R^x$ and/or $R^y$ per molecule of the resin (IP2) is preferably 2.5 or less, more preferably less than 2.5, still more preferably 2.4 or less, and may be 2.2 or less in terms of the average value of all molecules in the resin (IP2). The total number of groups containing a carbon-carbon unsaturated double bond contained in $R^x$ and/or $R^y$ per molecule of the resin (IP2) is preferably 0.8 or more, more preferably 1.2 or more, still more preferably 1.3 or more, yet still more preferably 1.4 or more, yet still more preferably 1.5 or more, yet still more preferably 1.8 or more, and may be 2.0 or more. When the total number of groups containing the carbon-carbon unsaturated double bond is within the above range, the cured product tends to have excellent low dielectric properties.

In Formula (D), each Mb independently represents a hydroxyl group, a halogen atom, or a hydrocarbon group having from 1 to 20 carbon atoms, each carbon atom being optionally substituted with a hydroxyl group or a halogen atom, has the same meaning as Mb in Formula (T-St) described above, and the preferred range thereof is also the same.

In Formula (D), y represents an integer of from 0 to 4, preferably an integer of from 0 to 3, more preferably an integer of from 0 to 2, still more preferably 0 or 2, and may be 0. It is preferable that y is 2 from the viewpoint of dielectric

properties.

When y is 1 or more, Mb is preferably bonded at an adjacent position (ortho position) to the carbon atom to which the $R^xO$ group is bonded.

In the resin (IP2) of the present embodiment, Formula (D) is preferably represented by Formula (D-1).

[Chem.98]

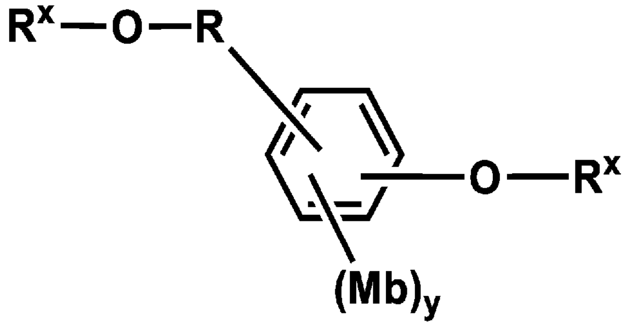

(D-1)

(In Formula (D-1), R is a group containing a structural unit represented by Formula (Tx). each $R^x$ independently represents a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Further, Formula (D-1) is preferably represented by Formula (D-1-2).

[Chem.99]

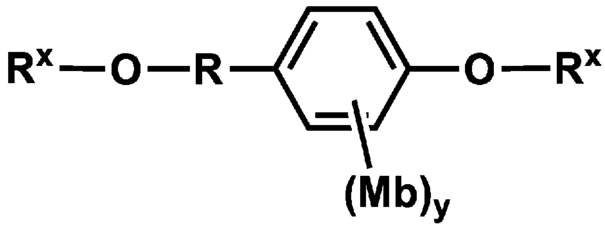

(D-1-2)

(In Formula (D-1-2), R is a group containing a structural unit represented by Formula (Tx). each $R^x$ independently represents a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

In the resin (IP2) of the present embodiment, Formula (D) is preferably represented by Formula (D-2).

[Chem.100]

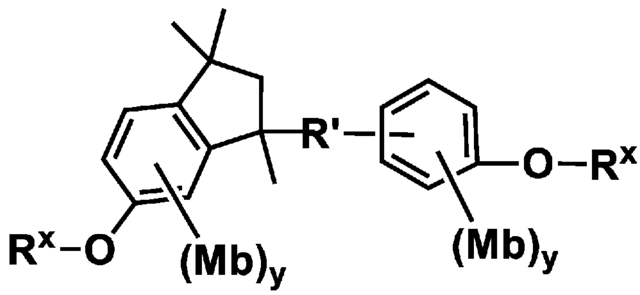

(D-2)

(In Formula (D-2), R' is a group to be a group containing the structural unit represented by Formula (Tx) together with the group having an indane skeleton adjacent to the left side, and each $R^x$ is independently a group containing a carbon-carbon unsaturated double bond. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Further, Formula (D-2) is preferably represented by Formula (D-2-1).

[Chem.101]

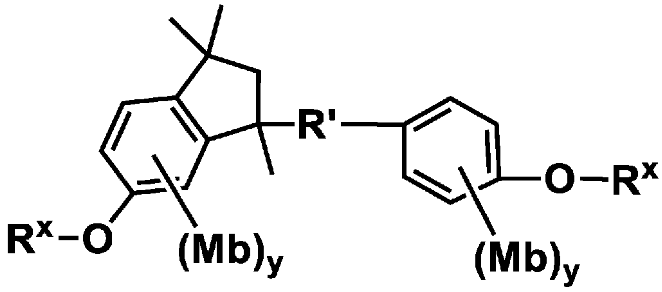

(D-2-1)

(In Formula (D-2-1), R' is a group to be a group containing a structural unit represented by Formula (Tx) together with the group having an indane skeleton adjacent to the left side, and each $R^x$ is independently a group containing a carbon-carbon unsaturated double bond. each Mb independently represents a hydroxyl group, a halogen atom, or a hydrocarbon group having from 1 to 20 carbon atoms, each carbon atom optionally substituted with a hydroxyl group or a halogen atom. y represents an integer of from 0 to 4.)

In Formulas (D-1), (D-1-2), (D-2), and (D-2-1), each $R^x$ independently has the same meaning as $R^x$ in Formula (D), and the preferred range thereof is also the same.

In Formula (D-1) and Formula (D-1-2), each R independently has the same meaning as R in Formula (D), and the preferred range thereof is also the same.

In Formulas (D-2) and (D-2-1), R' is a group to be a group containing the structural unit represented by Formula (Tx) together with the group having an indane skeleton adjacent to the left side. That is, Formula (D) essentially has a structure in which $R^y$ is a group containing an -O-carbon-carbon unsaturated double bond, and an oxygen atom thereof is bonded to the benzene ring of the structural unit (a) in Formula (Tx). Specifically, for example, in Formula (D-2), a circled portion described below corresponds to R in Formula (D).

[Chem.102]

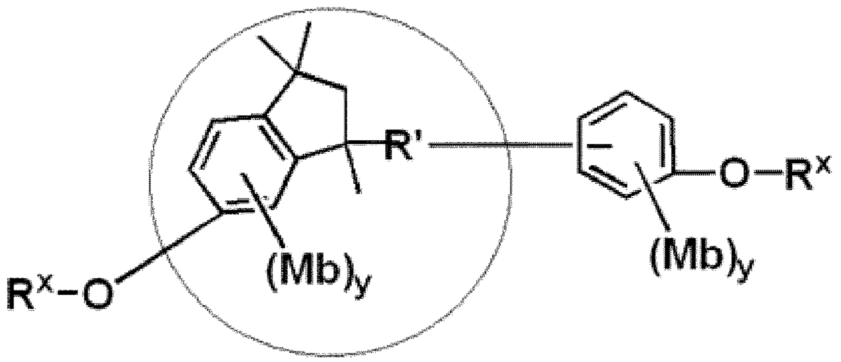

(D-2)

In Formula (D-1), Formula (D-1-2), Formula (D-2), and Formula (D-2-1), Mb and y each independently have the same meaning as Mb and y in Formula (D), and the preferred ranges are also the same.

In the present embodiment, the resin (IP1) and/or the resin (IP2) preferably have parameter $\alpha$ of 0.35 or more and 1.00 or less as calculated from Equation ($\alpha$).

[Num.9]

$$\text{PARAMETER}\ \alpha = \frac{(2.55ppm\ \text{to}\ 2.31ppm)}{(6.24ppm\ \text{to}\ 5.91ppm)+(2.98ppm\ \text{to}\ 2.55ppm)/2+(2.55ppm\ \text{to}\ 2.31ppm)} \qquad (\alpha)$$

(Expressions in parentheses in Equation ($\alpha$) indicate integral values between corresponding chemical shift values in $^1$H-NMR.)

Here, $\alpha$ represents the proportion of the structural unit (structural unit (a) in Formula (Tx)) having an indane skeleton in the resin (IP1) and/or the resin (IP2). More specifically, it is presumed that by adjusting the proportion of the structural unit having an indane skeleton in the resin (IP1) and/or the resin (IP2) so as to satisfy the range of the parameter $\alpha$, the rigidity of the resulting resin molecule is increased. The molecule having high rigidity has lower mobility than the molecule having low rigidity. Thus, the relaxation time at the time of dielectric relaxation becomes longer, and the dielectric

loss tangent (Df) can be lowered. In addition, it is presumed that since the rigidity of the resin molecule is increased, the glass transition temperature of the cured product can be increased, and the thermal resistance is excellent. In the present embodiment, R in Formula (D), a group containing a structural unit represented by Formula (Tx), is bonded to ($R^x$), a group containing a carbon-carbon unsaturated double bond, via a low-molecular-weight structural unit such as an oxygen atom and/or a phenyleneoxy group optionally having a substituent, thereby increasing the content proportion of the indane skeleton in the resin (IP1) and/or the resin (IP2).

The parameter $\alpha$ in the resin (IP1) and/or the resin (IP2) is more preferably 0.36 or more, still more preferably 0.40 or more, yet still more preferably 0.45 or more, and yet still more preferably 0.50 or more. Further, the parameter $\alpha$ may be 0.55 or more, 0.60 or more, 0.65 or more, or 0.70 or more. When the parameter $\alpha$ is the above lower limit or more, the resulting cured product tends to have further improved low dielectric properties (low relative permittivity and/or low dielectric loss tangent) and thermal resistance. The parameter $\alpha$ is preferably large because the parameter $\alpha$ tends to provide substantially excellent low dielectric properties and thermal resistance. However, the parameter $\alpha$ may be 0.98 or less, 0.95 or less, 0.90 or less, 0.85 or less, 0.84 or less, or 0.82 or less.

The number average molecular weight of the resin (IP1) and/or the resin (IP2) is preferably 8000 or less, and more preferably 4000 or less. When the number average molecular weight is the above lower limit or more, the resulting cured product tends to have further improved low dielectric properties (in particular, low dielectric loss tangent). This is considered to be because the proportion of the indane skeleton (for example, the structural unit (a) in Formula (Tx)) contained in the molecule increases as the molecular weight is increased. When the number average molecular weight is the above upper limit or less, the moldability and solvent solubility of the resin tend to further improve. The lower limit of the number average molecular weight of the resin (IP1) and/or the resin (IP2) is more preferably 500 or more, still more preferably 600 or more, and yet still more preferably 700 or more, yet still more preferably 800 or more, and may be 850 or more, 900 or more, 1000 or more, 1100 or more, 1200 or more, 1300 or more, 1400 or more, 1500 or more, 1600 or more, 1700 or more, 1800 or more, 1900 or more, 2000 or more, 2200 or more, 2300 or more, 2400 or more, 2500 or more, or 2600 or more. The upper limit of the number average molecular weight of the resin (IP1) and/or the resin (IP2) is more preferably 7000 or less, still more preferably 6000 or less, yet still more preferably 5000 or less, yet still more preferably 4000 or less, and may be 3800 or less, 3500 or less, 3200 or less, or 3000 or less, and further, may be 2800 or less, 2600 or less, 2400 or less, 2200 or less, 2000 or less, 1900 or less, 1800 or less, 1700 or less, 1600 or less, or 1500 or less.

A method for producing the resin represented by the resin (IP1) and/or the resin (IP2) is not particularly limited. For example, it can be produced using a hydroxy resin in which the RxO moiety and the Ry moiety are hydroxyl groups in Formula (D).

Examples of a first embodiment of the method for producing the resin (IP1) and/or the resin (IP2) include a method in which a mixture containing a compound represented by Formula (DIP) and a compound represented by Formula (P1) is reacted to synthesize a resin having a hydroxyl group (hereinafter, it may be referred to as "hydroxy resin"), and the hydroxy resin is reacted with a compound having a group containing a carbon-carbon unsaturated double bond and a group that reacts with the hydroxyl group of the hydroxy resin to be eliminated to synthesize the resin. Further, the hydroxy resin may be synthesized by reacting a compound represented by Formula (DIP) with a compound represented by Formula (P1) described later, and then further reacting a compound represented by Formula (DIP).

[Chem.103]

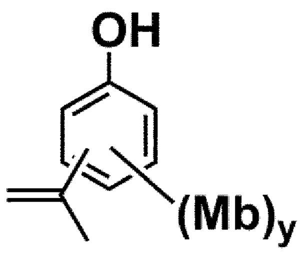

(P1)

(In Formula (P1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Mb and y in Formula (P1) have the same meaning as Mb and y in Formula (D), and the preferred ranges thereof are also the same.

The compound having a group containing a carbon-carbon unsaturated double bond and the group that reacts with the hydroxyl group of the hydroxy resin to be eliminated will be described.

The group containing a carbon-carbon unsaturated double bond is preferably a group represented by Formula (Rx-1) or a group represented by Formula (Rx-2), more preferably a vinylbenzyl group or a (meth)acryloyl group, and still

more preferably a vinylbenzyl group.

On the other hand, examples of the group that reacts with the hydroxyl group of the hydroxy resin to be eliminated include a halogen atom, a hydroxyl group, an alkoxy group, and a (meth)acryloyl group, and a halogen atom is preferable. Examples of the halogen atom include a chlorine atom, a bromine atom, and an iodine atom. The halogen atom is preferably a chlorine atom or a bromine atom.

As a first embodiment of the method for producing the resin (IP1) and/or the resin (IP2), the resin (IP1) and/or the resin (IP2) can be produced by synthesizing a polymer (oligomer) containing, as a main component, a structural unit derived from a compound represented by Formula (DIP) in advance from a compound represented by Formula (DIP), then reacting the polymer with a compound represented by Formula (P1) to synthesize a hydroxy resin, and reacting the obtained hydroxy resin with a compound having a group containing a carbon-carbon unsaturated double bond and a group that reacts with the hydroxyl group of the hydroxy resin to be eliminated.

When the resin composition of the present embodiment contains a compound having an indane skeleton having a carbon-carbon unsaturated double bond at a terminal other than the resin (A), the content thereof is preferably 1 part by mass or more and preferably 50 parts by mass or less with respect to 100 parts by mass of the resin solid content in the resin composition.

The resin composition in the present embodiment may contain only one, or two or more compounds having an indane skeleton having a carbon-carbon unsaturated double bond at a terminal other than the resin (A). When two or more types are contained, the total amount is preferably in the range described above.

The resin composition in the present embodiment can also be configured to contain substantially no compounds having an indane skeleton having a carbon-carbon unsaturated double bond at a terminal other than the resin (A). The phrase "contain substantially no" means that the content of the compound having an indane skeleton having a carbon-carbon unsaturated double bond at a terminal other than the resin (A) is less than 1 part by mass, preferably less than 0.1 parts by mass, and more preferably less than 0.01 parts by mass, with respect to 100 parts by mass of the resin solid content in the resin composition.

<Other curable compound>

In addition to the above, the resin composition of the present embodiment may contain a curable compound (other curable compound) other than those described above within a range not departing from the gist of the present invention.

Examples of the other curable compound include an epoxy compound, a phenolic compound, an oxetane compound, a benzoxazine compound, a cyanate ester compound, an aryl cyclobutene resin, a polyamide compound, a polyimide compound, and a compound having a vinylene group.

<<Epoxy compound>>

The resin composition of the present embodiment may contain an epoxy compound.

The epoxy compound is not particularly limited as long as it is a compound or resin having one or more (preferably from 2 to 12, more preferably from 2 to 6, still more preferably from 2 to 4, even more preferably 2 or 3, and further more preferably 2) epoxy groups per molecule, and compounds usually used in the field of printed wiring boards can be commonly used.

Examples of the epoxy compound include: compounds obtained by epoxidizing double bonds such as a phenol novolac-type epoxy resin, a bisphenol A novolac-type epoxy resin, a glycidyl ester-type epoxy resin, an aralkyl novolac-type epoxy resin, a biphenyl aralkyl-type epoxy resin, a naphthylene ether-type epoxy resin, a cresol novolac-type epoxy resin, a polyfunctional phenol-type epoxy resin, a naphthalene-type epoxy resin, an anthracene-type epoxy resin, a naphthalene skeleton modified novolac-type epoxy resin, a phenol aralkyl-type epoxy resin, a naphthol aralkyl-type epoxy resin, a dicyclopentadiene-type epoxy resin, a biphenyl-type epoxy resin, an alicyclic epoxy resin, a polyol-type epoxy resin, a phosphorus-containing epoxy resin, glycidylamine, a glycidyl ester, and butadiene; and compounds obtained by reacting hydroxyl group-containing silicone resins with epichlorohydrin. The use of such a compound improves the moldability and adhesion of the resin composition. Among these, the epoxy compound is preferably one or more selected from the group consisting of a biphenyl aralkyl-type epoxy resin, a naphthylene ether-type epoxy resin, a polyfunctional phenol-type epoxy resin, and a naphthalene-type epoxy resin, and more preferably a biphenyl aralkyl-type epoxy resin, from the viewpoint of further improving flame retardancy and thermal resistance.

When the resin composition of the present embodiment contains the epoxy compound, the content of the epoxy compound is preferably 0.1 parts by mass or more, more preferably 1 part by mass or more, and still more preferably 2 parts by mass or more with respect to 100 parts by mass of the resin solid content in the resin composition. When the content of the epoxy compound is 0.1 parts by mass or more, peel strength and toughness tend to be improved. The upper limit of the content of the epoxy compound is preferably 50 parts by mass or less, more preferably 30 parts by mass or less, still more

preferably 20 parts by mass or less, even more preferably 10 parts by mass or less, and may be 8 parts by mass or less or 5 parts by mass or less, with respect to 100 parts by mass of the resin solid content in the resin composition. With the content of the epoxy compound being 50 parts by mass or less, the resulting cured product tends to improve in electrical properties.

The resin composition of the present embodiment may contain only one type of epoxy compound or may contain two or more types of epoxy compounds. When two or more types are contained, the total amount is preferably in the range described above.

In addition, the resin composition in the present embodiment can also be configured to contain substantially no epoxy compound. The phrase "contain substantially no" means that the content of the epoxy compound is less than 0.1 parts by mass with respect to 100 parts by mass of the resin solid content in the resin composition, and the content is preferably less than 0.01 parts by mass, and may be less than 0.001 parts by mass.

<<Phenolic compound>>

The resin composition of the present embodiment may contain a phenolic compound.

The phenolic compound is any phenolic compound having one or more (preferably from 2 to 12, more preferably from 2 to 6, still more preferably from 2 to 4, yet still more preferably 2 or 3, and yet still more preferably 2) phenolic hydroxyl groups per molecule and is not particularly limited, and a wide variety of compounds commonly used in the field of printed wiring boards can be used.

Examples of the phenolic compound include a phenolic novolac resin, a bisphenolic A novolac-type phenolic resin, a glycidyl ester-type phenolic resin, an aralkyl novolac phenolic resin, a biphenyl aralkyl-type phenolic resin, a cresol novolac-type phenolic resin, a polyfunctional phenolic resins, a naphthol resin, a naphthol novolac resin, a polyfunctional naphthol resin, an anthracene-type phenolic resin, a naphthalene skeleton-modified novolac-type phenolic resin, a phenolic aralkyl-type phenolic resin, a naphthol aralkyl-type phenolic resin, a dicyclopentadiene-type phenolic resin, a biphenyl-type phenolic resin, an alicyclic phenolic resin, a polyol-type phenolic resin, a phosphorus-containing phenolic resin, and a hydroxyl group-containing silicone resin. Among these, from the viewpoints of further improving the flame resistance of the resulting cured product, the phenolic compound is preferably at least one selected from the group consisting of biphenyl aralkyl-type phenolic resins, naphthol aralkyl-type phenolic resins, phosphorus-containing phenolic resins, and hydroxyl group-containing silicone resins.

Other examples of the phenolic compound that can be used in the present embodiment include a resin having a hydroxyl group obtained by reacting a mixture containing a compound represented by Formula (DIP) and a compound represented by Formula (P1).

[Chem.104]

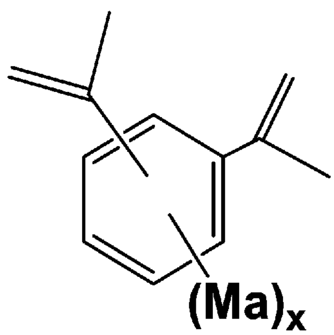

(DIP)

(In Formula (DIP), each Ma independently represents a hydrocarbon group having from 1 to 12 carbon atoms, each carbon atom being optionally substituted with a halogen atom. x represents an integer of from 0 to 4.)

[Chem.105]

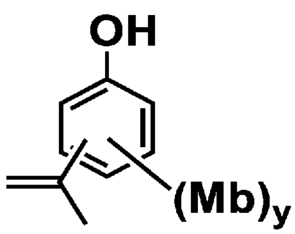

(P1)

(In Formula (P1), each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

Formula (DIP) has the same meaning as Formula (DIP) described in the section of the resin (IP1), and the preferred range thereof is also the same.

In Formula (P1), Mb and y each independently have the same meaning as Mb and y in Formula (T-St) described above, and the preferred ranges thereof are also the same.

For details of the resin having a hydroxyl group obtained by reacting a mixture containing the compound represented by Formula (DIP) and the compound represented by Formula (P1), reference can be made to the description of JP 2022-180443, the contents of which are incorporated herein by reference.

Other examples of the phenolic compound that can be used in the present embodiment include a hydroxy resin represented by Formula (T-OH).

[Chem.106]

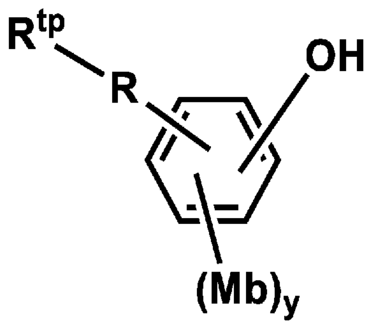

(T-OH)

(In Formula (T-OH), R is a group containing a structural unit represented by Formula (Tx). $R^{tp}$ is a hydrogen atom, a hydroxyl group, an isopropenyl group, or another group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.107]

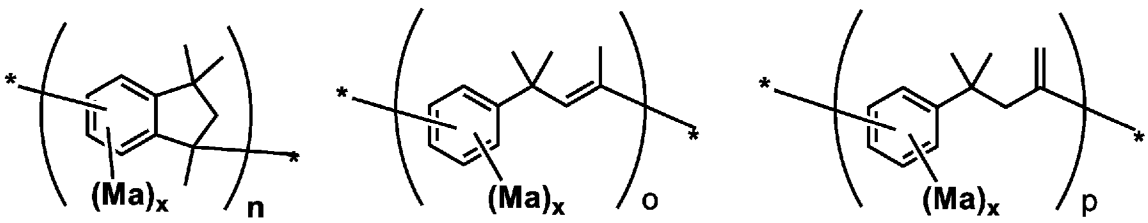

(Tx)

(a) (b) (c)

(In Formula (Tx), n, o, and p are average numbers of repeating units, n represents a number more than 0 and 20 or less, o and p each independently represent a number of from 0 to 20, and $1.0 \leq n + o + p \leq 20.0$. each Ma independently represents a hydrocarbon group having from 1 to 12 carbon atoms, each carbon atom being optionally substituted with a halogen atom. x represents an integer of from 0 to 4. the structural units (a), (b), and (c) are each bonded to the structural unit (a), (b), or (c), or an additional group by *, and structural units may be randomly bonded.)

Formula (T-OH) is preferably represented by Formula (T-OH2), and more preferably represented by Formula (T-OH3).

[Chem.108]

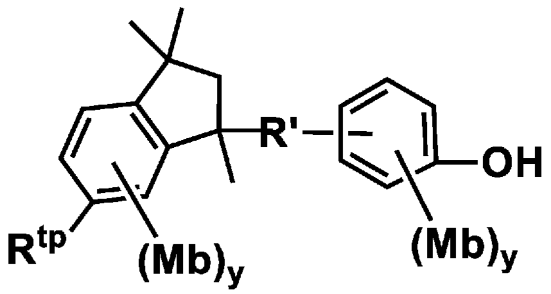

(T-OH2)

(In Formula (T-OH2), R' is a group to be a group containing a structural unit represented by Formula (Tx) in combination with the group having an indane skeleton adjacent to the left side, and $R^{tp}$ is a hydrogen atom, a hydroxyl group, an isopropenyl group, or another group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

[Chem.109]

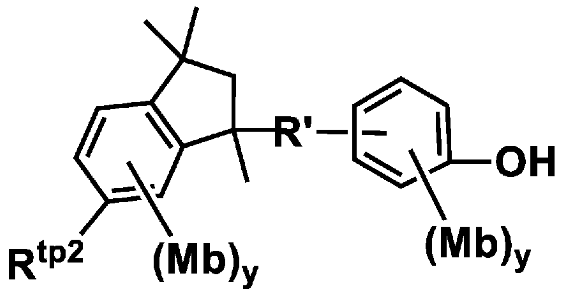

(T-OH3)

(In Formula (T-OH3), R' is a group to be a group containing a structural unit represented by Formula (Tx) in combination with the group having an indane skeleton adjacent to the left side, and $R^{tp2}$ represents a hydroxyl group or an isopropenyl group. each Mb independently represents a hydroxyl group, a halogen atom, or a hydrocarbon group having from 1 to 20 carbon atoms, each carbon atom being optionally substituted with a hydroxyl group or a halogen atom. y represents an integer of from 0 to 4.)

In Formula (T-OH), R has the same meaning as R in Formula (T1-1) described above, and the preferred range thereof is also the same. Mb and y each independently have the same meaning as Mb and y in Formula (T-St) described above, and the preferred ranges thereof are also the same. $R^{tp}$ is preferably a hydroxyl group or an isopropenyl group, and more preferably a hydroxyl group.

In Formula (T-OH2) and Formula (T-OH3), R' has the same meaning as R in Formula (T1-1) described above, and the preferred range thereof is also the same. Mb and y each independently have the same meaning as Mb and y in Formula (T-St), and the preferred ranges thereof are also the same.

In Formula (T-OH2), $R^{tp}$ is preferably a hydroxyl group or an isopropenyl group, and more preferably a hydroxyl group.

In Formula (T-OH3), $R^{tp2}$ is preferably a hydroxyl group.

For details of the hydroxy resins represented by Formulas (T-OH1) to (T-OH3), reference can be made to the description of JP 2022-180444, the contents of which are incorporated herein by reference.

Other examples of the phenolic compound that can be used in the present embodiment also include a hydroxy resin represented by Formula (T-OH4).

[Chem.110]

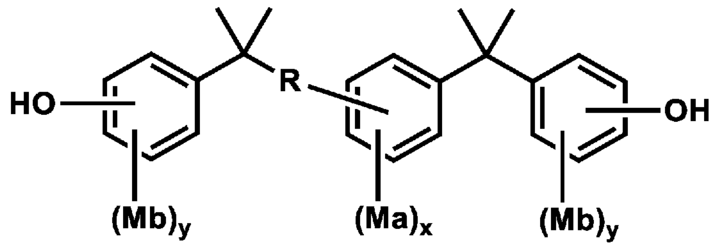

(T-OH4)

(In Formula (T-OH4), R is a group containing a structural unit represented by Formula (Tx). each Ma independently represents a hydrocarbon group having from 1 to 12 carbon atoms, each carbon atom being optionally substituted with a halogen atom. each Mb independently represents a hydroxyl group, a halogen atom, or a hydrocarbon group having from 1 to 20 carbon atoms, each carbon atom being optionally substituted with a hydroxyl group or a halogen atom. x and y each independently represent an integer of from 0 to 4.)

[Chem.111]

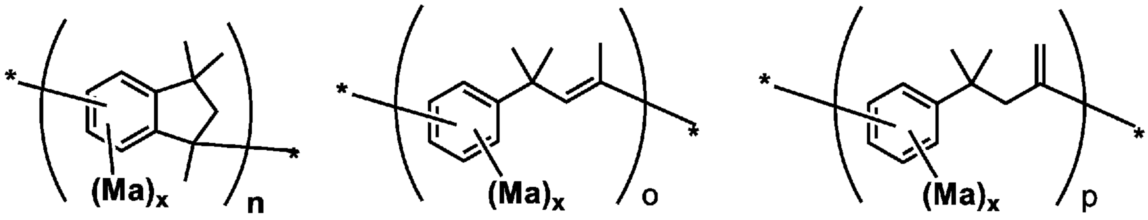

(a) (b) (c)

(Tx)

(In Formula (Tx), n, o, and p are average numbers of repeating units, n represents a number more than 0 and 20 or less, o and p each independently represent a number of from 0 to 20, and $1.0 \leq n + o + p \leq 20.0$. each Ma independently represents a hydrocarbon group having from 1 to 12 carbon atoms which is optionally substituted with a halogen atom. x represents an integer of from 0 to 4. the structural units (a), (b), and (c) are each bonded to the structural unit (a), (b), or (c), or an additional group by *, and structural units may be randomly bonded.)

In Formula (T-OH4), Ma and x each independently have the same meanings as Ma and x in Formula (T1), respectively, and the preferred ranges thereof are also the same.

In Formula (T-OH4), Mb and y each independently have the same meanings as Mb and y in Formula (T-St) described later, respectively, and the preferred ranges thereof are also the same.

In Formula (T-OH4), R has the same meaning as R in Formula (T-OH), and the preferred range thereof is also the same.

For details of the hydroxy resin represented by Formula (T-OH4), reference can be made to the description of paragraphs [0018] to [0019] of PCT/JP2023/009587, the contents of which are incorporated herein by reference.

When the resin composition of the present embodiment contains the phenolic compound, the content of the phenolic compound is preferably 0.1 parts by mass or more, more preferably 1 part by mass or more, and still more preferably 2 parts by mass or more with respect to 100 parts by mass of the resin solid content in the resin composition. The content is preferably 50 parts by mass or less, more preferably 30 parts by mass or less, still more preferably 20 parts by mass or less, and still more preferably 10 parts by mass or less, and may be 5 parts by mass or less.

The resin composition of the present embodiment may contain only one phenolic compound or may contain two or more phenolic compounds. When two or more types are contained, the total amount is preferably in the range described above.

In addition, the resin composition in the present embodiment can also be configured to contain substantially no phenolic compound. The phrase "contain substantially no" means that the content of the phenolic compound is less than 0.1 parts by mass with respect to 100 parts by mass of the resin solid content in the resin composition.

<<Oxetane compound>>

The resin composition of the present embodiment may contain an oxetane compound.

The oxetane compound is not particularly limited as long as it is a compound having one or more (preferably from

2 to 12, more preferably from 2 to 6, still more preferably from 2 to 4, even more preferably 2 or 3, and further more preferably 2) oxetanyl groups, and compounds usually used in the field of printed wiring boards can be commonly used.

Examples of the oxetane compound include oxetane, alkyloxetanes (for example, 2-methyloxetane, 2,2-dimethyloxetane, 3-methyloxetane, and 3,3-dimethyloxetane), 3-methyl-3-methoxymethyloxetane, 3,3-di(trifluoromethyl)oxetane, 2-chloromethyloxetane, 3,3-bis(chloromethyl)oxetane, biphenyl-type oxetane, OXT-101 (available from Toagosei Co., Ltd.), and OXT-121 (available from Toagosei Co., Ltd.).

The resin composition of the present embodiment preferably contains the oxetane compound in a range that does not impair the effects of the present invention. When the resin composition of the present embodiment contains the oxetane compound, the content of the oxetane resin is preferably 0.1 parts by mass or more, more preferably 1 part by mass or more, and still more preferably 2 parts by mass or more, with respect to 100 parts by mass of the resin solid content in the resin composition. When the content of the oxetane compound is 0.1 parts by mass or more, the resulting cured product tends to have improved peel strength and toughness. When the resin composition of the present embodiment contains the oxetane compound, the upper limit of the content of the oxetane compound is preferably 50 parts by mass or less, more preferably 30 parts by mass or less, still more preferably 20 parts by mass or less, yet still more preferably 10 parts by mass or less, and yet still more preferably 8 parts by mass or less, with respect to 100 parts by mass of the resin solid content in the resin composition. When the content of the oxetane compound is 50 parts by mass or less, the resulting cured product tends to have improved electrical properties.

The resin composition of the present embodiment may contain only one, or two or more oxetane compounds. When two or more types are contained, the total amount is preferably in the range described above.

The resin composition in the present embodiment can also be configured to contain substantially no oxetane compound. The phrase "contain substantially no" means that the content of the oxetane compound is less than 0.1 parts by mass with respect to 100 parts by mass of the resin solid content in the resin composition.

<<Benzoxazine compound>>

The resin composition of the present embodiment may contain a benzoxazine compound.

The benzoxazine compound is any compound having two or more (preferably from 2 to 12, more preferably from 2 to 6, still more preferably from 2 to 4, still more preferably 2 or 3, and even more preferably 2) dihydrobenzoxazine rings per molecule and is not particularly limited, and a compound from a wide variety of compounds commonly used in the field of printed wiring boards can be used.

Examples of the benzoxazine compound include a bisphenolic A-type benzoxazine BA-BXZ (available from Konishi Chemical Ind. Co., Ltd.), a bisphenolic F-type benzoxazine BF-BXZ (available from Konishi Chemical Industry Co., Ltd.), and a bisphenolic S-type benzoxazine BS-BXZ (available from Konishi Chemical Industry Co., Ltd.).

The resin composition of the present embodiment preferably contains the benzoxazine compound in a range that does not impair the effects of the present invention. When the resin composition of the present embodiment contains the benzoxazine compound, the content of the benzoxazine compound is preferably 0.1 parts by mass or more and preferably 50 parts by mass or less with respect to 100 parts by mass of the resin solid content in the resin composition.

The resin composition in the present embodiment may contain only one benzoxazine compound or may contain two or more benzoxazine compounds. When two or more types are contained, the total amount is preferably in the range described above.

In addition, the resin composition in the present embodiment can also be configured to contain substantially no benzoxazine compound. The phrase "contain substantially no" means that the content of the benzoxazine compound is less than 0.1 parts by mass with respect to 100 parts by mass of the resin solid content in the resin composition.

<<Cyanate ester compound>>

The cyanate ester compound that can be used in the resin composition of the present embodiment is not particularly limited as long as it is a compound containing one or more (preferably 2 or more, more preferably 2 to 12, still more preferably 2 to 6, even more preferably 2 to 4, further more preferably 2 or 3, still further more preferably 2) cyanate groups (cyanato groups) per molecule, and a wide variety of compounds commonly used in the field of printed wiring boards can be used. The cyanate ester compound is preferably a compound in which the cyanate group is directly bonded to an aromatic backbone (aromatic ring).

Examples of the cyanate ester compound include at least one selected from the group consisting of phenol novolac-type cyanate ester compounds, naphthol aralkyl-type cyanate ester compounds (naphthol aralkyl-type cyanates), naphthylene ether-type cyanate ester compounds, biphenyl aralkyl-type cyanate ester compounds, xylene resin-type cyanate ester compounds, trisphenol methane-type cyanate ester compounds, adamantane backbone-type cyanate ester compounds, bisphenol M-type cyanate ester compounds, bisphenol A-type cyanate ester compounds, bisphenol E-type cyanate ester compounds, diallyl bisphenol A-type cyanate ester compounds, and indancinate compounds. Among

these, from the viewpoints of further improving the low water absorption of the resulting cured product, the cyanate ester compound is preferably at least one selected from the group consisting of phenol novolac-type cyanate ester compounds, naphthol aralkyl-type cyanate ester compounds, naphthylene ether-type cyanate ester compounds, xylene resin-type cyanate ester compounds, bisphenol M-type cyanate ester compounds, bisphenol A-type cyanate ester compounds, and diallyl bisphenol A-type cyanate ester compounds, more preferably at least one selected from the group consisting of phenol novolac-type cyanate ester compounds and naphthol aralkyl-type cyanate ester compounds, and still more preferably naphthol aralkyl-type cyanate ester compounds. Such a cyanate ester compound may be prepared by a known method, or a commercially available product may be used. A cyanate ester compound having a naphthol aralkyl backbone, a naphthylene ether backbone, a xylene backbone, a trisphenol methane backbone, or an adamantane backbone has a relatively large number of functional group equivalents and a small number of unreacted cyanate ester groups, and thus the cured product of the resin composition formed using the cyanate ester compound of these tends to have even better low water absorption. In addition, mainly due to having an aromatic skeleton or an adamantane skeleton, plating adhesion tends to be further improved.

The naphthol aralkyl-type cyanate ester compound is preferably a compound represented by Formula (1) below.

[Chem.112]

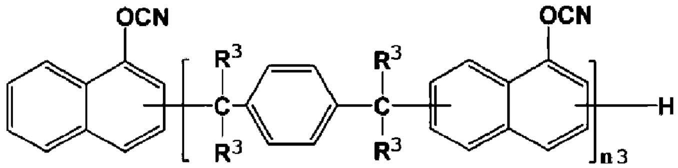

(1)

(In Formula (1), each $R^3$ independently represents a hydrogen atom or a methyl group, and n3 represents an integer of 1 or more.)

In Formula (1), each $R^3$ independently represents a hydrogen atom or a methyl group, and among these, a hydrogen atom is preferable.

In Formula (1), n3 is an integer of 1 or more, and preferably an integer of from 1 to 20, more preferably an integer of from 1 to 10, and still more preferably an integer of from 1 to 6.

The novolac-type cyanate ester compound is not particularly limited, but, for example, is preferably a compound represented by Formula (VII) below.

[Chem.113]

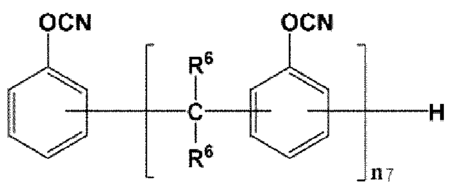

(VII)

(In Formula (VII), each $R^6$ independently represents a hydrogen atom or a methyl group; and n7 represents an integer of 1 or more.)

In Formula (VII), each $R^6$ independently represents a hydrogen atom or a methyl group, and among them, a hydrogen atom is preferred.

In Formula (VII), n7 is an integer of 1 or more, preferably an integer of from 1 to 20, more preferably an integer of from 1 to 10, and still more preferably an integer of from 1 to 6.

As the bisphenol A-type cyanate ester compound, one or more selected from the group consisting of 2,2-bis(4-cyanatophenyl)propane and a prepolymer of 2,2-bis(4-cyanatophenyl)propane may be used.

Examples of the indancinate compound include a compound represented by Formula (a) bel.

Formula (a)

[Chem.114]

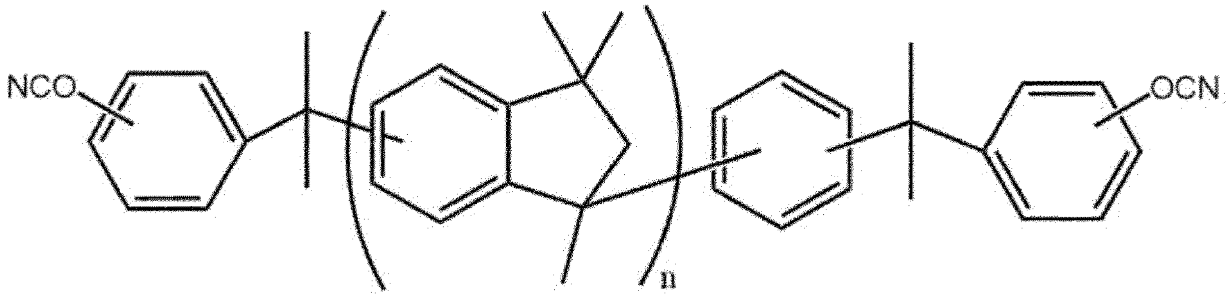

(In Formula (a), n is an average number of repetitions and is a number of 3.0 or more and 15.0 or less.)

As the cyanate ester compound, a compound described in paragraphs 0035 to 0061 of JP 2024-110099 can also be used in addition to the above, the contents of which are incorporated herein by reference.

The resin composition of the present embodiment preferably contains the cyanate ester compound to such an extent that the effects of the present invention are not compromised. When the resin composition of the present embodiment contains a cyanate ester compound, the lower limit of the content of the cyanate ester compound is preferably 0.1 parts by mass or more, more preferably 2 parts by mass or more, still more preferably 5 parts by mass or more, and even more preferably 8 parts by mass or more with respect to 100 parts by mass of the resin solid content in the resin composition. When the content of the cyanate ester compound is 0.1 parts by mass or more, the thermal resistance, combustion resistance, chemical resistance, low dielectric properties (low relative permittivity, low dielectric loss tangent), and insulation of the resulting cured product tend to improve. When the resin composition of the present embodiment contains the cyanate ester compound, the upper limit of the content of the cyanate ester compound is preferably 70 parts by mass or less, more preferably 50 parts by mass or less, still more preferably 40 parts by mass or less, even more preferably 30 parts by mass or less, and further more preferably 20 parts by mass or less with respect to 100 parts by mass of the resin solid content in the resin composition.

The resin composition of the present embodiment may contain only one, or two or more cyanate ester compounds. When two or more types are contained, the total amount is preferably in the range described above.

<<Arylcyclobutene resin>>

The resin composition of the present embodiment may contain an arylcyclobutene resin.

For details thereof, the arylcyclobutene resins described in paragraph [0042] of JP 2019-194312 A are exemplified, the contents of which are incorporated herein by reference.

The resin composition of the present embodiment preferably contains the arylcyclobutene resin in a range that does not impair the effects of the present invention. When the resin composition of the present embodiment contains the arylcyclobutene resin, the content thereof is preferably 0.1 parts by mass or more and preferably 50 parts by mass or less, with respect to 100 parts by mass of the resin solid content in the resin composition.

The resin composition in the present embodiment may contain only one arylcyclobutene resin or may contain two or more arylcyclobutene resins. When two or more aliphatic polyamide resins are contained, the total amount is preferably in the range described above.

In addition, the resin composition in the present embodiment can also be configured to contain substantially no arylcyclobutene resin. The phrase "contain substantially no" means that the content of the arylcyclobutene resin is less than 0.1 parts by mass with respect to 100 parts by mass of the resin solid content in the resin composition.

<<Polyamide compound>>

The resin composition of the present embodiment may contain a polyamide compound or a thermosetting polyamide compound.

For details thereof, reference can be made to the polyamide described in paragraph 0063 of JP 6951829 B, the contents of which are incorporated herein by reference.

The resin composition of the present embodiment preferably contains the polyamide compound in a range that does not impair the effects of the present invention. When the resin composition of the present embodiment contains the polyamide compound, the content thereof is preferably 0.1 parts by mass or more and preferably 50 parts by mass or less with respect to 100 parts by mass of the resin solid content in the resin composition.

The resin composition of the present embodiment may contain only one of, or two or more of the polyamide compounds. When two or more types are contained, the total amount is preferably in the range described above.

The resin composition in the present embodiment can also be configured to contain substantially no polyamide

compound. The phrase "contain substantially no" means that the content of the polyamide compound is less than 0.1 parts by mass, with respect to 100 parts by mass of the resin solid content in the resin composition.

<<Polyimide compound>>

The resin composition of the present embodiment may contain a polyimide compound or a thermosetting polyimide compound.

For details thereof, reference can be made to the polyimide described in paragraph 0064 of JP 6951829 B, the contents of which are incorporated herein by reference.

The resin composition of the present embodiment preferably contains the polyimide compound in a range that does not impair the effects of the present invention. When the resin composition of the present embodiment contains the polyimide compound, the content thereof is preferably 0.1 parts by mass or more and preferably 50 parts by mass or less with respect to 100 parts by mass of the resin solid content in the resin composition.

The resin composition of the present embodiment may contain only one of, or two or more of the polyimide compounds. When two or more types are contained, the total amount is preferably in the range described above.

The resin composition of the present embodiment can also be configured to contain substantially no polyimide compound. The phrase "contain substantially no" means that the content of the polyimide compound is less than 0.1 parts by mass, with respect to 100 parts by mass of the resin solid content in the resin composition.

<<Compound having vinylene group>>

The resin composition of the present embodiment may contain a compound having a vinylene group.

Examples of the compound having a vinylene group include a compound containing one or two or more -CH=CH- in the molecule, and a compound containing one -CH=CH- in the molecule is preferable. A compound having a vinylene group and also corresponding to a maleimide compound is a maleimide compound.

As specific examples of the compound having a vinylene group, acenaphthylene and pyrazylene are preferred, and acenaphthylene is more preferred.

In the present specification, a compound that corresponds to a compound having a vinylene group, such as an imidazole compound to be described later, and that is explicitly described as a component (for example, a curing accelerator) other than the compound having a vinylene group does not correspond to the compound having a vinylene group.

<Filler>

The resin composition of the present embodiment preferably contains a filler. Containing the filler enables further improvement of physical properties, such as dielectric properties (e.g., low dielectric constant, low dielectric loss tangent), flame resistance, and low thermal expansion properties of the resin composition and a cured product thereof.

The filler used in the present embodiment more preferably has excellent low dielectric properties (Dk and/or Df). For example, the filler used in the present embodiment has a relative permittivity (Dk) at a frequency of 10 GHz as measured according to a cavity resonator perturbation method of preferably 8.0 or less, more preferably 6.0 or less, and still more preferably 4.0 or less. Furthermore, the lower limit of the relative permittivity is, for example, practically 2.0 or more. The filler used in the present embodiment has a dielectric loss tangent (Df) at a frequency of 10 GHz as measured according to a cavity resonator perturbation method of preferably 0.05 or less, and more preferably 0.01 or less. The lower limit of the dielectric loss tangent is, for example, practically 0.0001 or more.

The type of the filler used in the present embodiment is not particularly limited, and any filler commonly used in the art can be suitably used. Specific examples of the filler include silica such as natural silica, fused silica, synthetic silica, amorphous silica, aerosil, and hollow silica; metal oxides such as alumina, white carbon, titanium white, titanium oxide, zinc oxide, magnesium oxide, and zirconium oxide; composite oxides such as zinc borate, zinc stannate, forsterite, barium titanate, strontium titanate, and calcium titanate; nitrides such as boron nitride, aggregated boron nitride, silicon nitride, and aluminum nitride; metal hydroxides such as aluminum hydroxide, aluminum hydroxide heat treated products (aluminum hydroxide subjected to heat treatment to reduce a part of crystal water), boehmite, and magnesium hydroxide (including hydrates); molybdenum compounds such as molybdenum oxide and zinc molybdate; inorganic fillers such as barium sulfate, clay, kaolin, talc, fired clay, fired kaolin, fired talc, mica, E-glass, A-glass, NE-glass, NER-glass, NEZ-glass, C-glass, L-glass, D-glass, S-glass, M-glass G20, short glass fibers (including fine powders of glass such as E glass, T glass, D glass, S glass, and Q glass), hollow glass, and spherical glass; and organic fillers such as styrene type, butadiene type, and acrylic type rubber powders, core-shell type rubber powders, silicone resin powders, silicone rubber powders, and silicone composite powders.

In the present embodiments, inorganic fillers are preferable, and more preferably the filler includes one or more

selected from the group consisting of silica, aluminum hydroxide, talc, aluminum nitride, boron nitride, forsterite, titanium oxide, barium titanate, strontium titanate, and calcium titanate. From the viewpoint of the low dielectric properties (Dk and/or Df), the filler more preferably contains one or more selected from the group consisting of silica and aluminum hydroxide, and even more preferably contains silica. With the use of these inorganic fillers, the cured product of the resin composition is improved in characteristics such as heat resistance, dielectric properties, thermal expansion characteristics, dimensional stability, and flame retardancy.

The content of the filler in the resin composition of the present embodiment can be appropriately determined depending on the desired properties, and is not particularly limited. The content is preferably 10 parts by mass or more, more preferably 20 parts by mass or more, still more preferably 40 parts by mass or more, even more preferably 60 parts by mass or more, and further more preferably 80 parts by mass or more, with respect to 100 parts by mass of the resin solid content in the resin composition. When the content is the above lower limit or more, the resulting cured product tends to be more excellent in low thermal expansion property and low dielectric loss tangent. The upper limit of the content of the filler is preferably 1600 parts by mass or less, more preferably 1000 parts by mass or less, still more preferably 500 parts by mass or less, even more preferably 300 parts by mass or less, and further more preferably 250 parts by mass or less, and may be 200 parts by mass or less, or 120 parts by mass or less with respect to 100 parts by mass of the resin solid content. When the content is the above upper limit or less, the moldability of the resin composition tends to be further improved.

In the resin composition according to the present embodiment, an aspect in which the content of the filler is from 1 to 95 mass% of components excluding a solvent is exemplified as an example of a preferred embodiment, and an aspect in which the content of the filler is from 30 mass% to 80 mass% of components excluding a solvent is preferable.

The resin composition of the present embodiment may contain only one type of filler, or may contain two or more types of fillers. When two or more aliphatic polyamide resins are contained, the total amount is preferably in the range described above.

When the filler, in particular, an inorganic filler, is used in the resin composition according to the present embodiments, a silane coupling agent may be further contained. By containing a silane coupling agent, the dispersion of the filler and the adhesive strength between the resin component and the filler and the substrate to be described later tend to be further improved.

The silane coupling agent is not particularly limited, examples thereof include silane coupling agents generally used in surface treatment of inorganic substances, and examples thereof include an aminosilane-based compound (for example, γ-aminopropyltriethoxysilane, N-β-(aminoethyl)-γ-aminopropyltrimethoxysilane, or the like), an epoxysilane-based compound (for example, γ-glycidoxypropyltrimethoxysilane or the like), a vinylsilane-based compound (for example, vinyltrimethoxysilane, vinyltriethoxysilane, tetravinylsilane, triethylvinylsilane, 1,3-vinyltetramethylsiloxane, or the like), a styrylsilane-based compound (for example, 4-vinylphenyltrimethoxysilane or the like), an acrylsilane-based compound (for example, γ-acryloxypropyltrimethoxysilane or the like), a cathionic silane-based compound (for example, N-β-(N-vinylbenzylaminoethyl)-γ-aminopropyltrimethoxysilane hydrochloride or the like), and a phenylsilane-based compound. Among them, it is preferable to contain at least one selected from the group consisting of a vinylsilane-based compound, a styrylsilane-based compound, and an acrylsilane-based compound, and a vinylsilane-based compound is more preferable. One type of the silane coupling agents can be used alone, or two or more types thereof can be used in combination.

The content of the silane coupling agent is not particularly limited, but may be from 0.1 to 5.0 parts by mass relative to 100 parts by mass of resin solids.

<Curing accelerator>

The resin composition of the present embodiment may further contain a curing accelerator.

The curing accelerator is not particularly limited, and examples thereof include imidazoles such as 2-ethyl-4-methylimidazole, 2-phenyl-4-methylimidazole, and triphenylimidazole; organic peroxides such as benzoyl peroxide, lauroyl peroxide, acetyl peroxide, parachlorobenzoyl peroxide, di-tert-butyl-di-perphthalate α,α'-di(t-butylperoxy)diisopropylbenzene, 2,5-dimethyl-2,5-di(t-butylperoxy) hexane, and 2,5-dimethyl-2,5-bis(t-butylperoxy)hexine-3; azo compounds such as azobisnitriles; tertiary amines such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine, and N-methylpiperidine; phenols such as phenol, xylenol, cresol, resorcin, and catechol; high-temperature decomposition type radical generator such as 2,3-dimethyl-2,3-diphenylbutane; organometallic salts such as lead naphthenate, lead stearate, zinc naphthenate, zinc octylate, manganese octylate, tin oleate, dibutyltin malate, manganese naphthenate, cobalt naphthenate, and iron acetylacetonate; those formed by dissolving these organometallic salts in hydroxyl group-containing compounds such as phenol and bisphenol; inorganic metal salts such as tin chloride, zinc chloride, and aluminum chloride; and organotin compounds such as dioctyl tin oxide, other alkyl tins, and alkyl tin oxides. Among them, preferred curing accelerators are imidazoles, organometallic salts, and organic peroxides, and imidazoles and organic peroxides are more preferred.

When the resin composition of the present embodiment contains the curing accelerator, the lower limit of the content of the curing accelerator is preferably 0.005 parts by mass or more, more preferably 0.01 parts by mass or more, and still more preferably 0.1 parts by mass or more, with respect to 100 parts by mass of the resin solid content in the resin composition. The upper limit of the content of the curing accelerator is preferably 10 parts by mass or less, more preferably 5 parts by mass or less, still more preferably 3 parts by mass or less, yet still more preferably 2 parts by mass or less, yet still more preferably 1.5 parts by mass or less, yet still more preferably 1.0 parts by mass or less, yet still more preferably 0.8 parts by mass or less, and particularly preferably 0.7 parts by mass or less, with respect to 100 parts by mass of the resin solid content in the resin composition. The resin composition of the present embodiment is preferred in that the resin composition can be sufficiently cured even when the content of the curing accelerator is 0.8 parts by mass or less.
One type of the curing accelerators can be used alone, or two or more types thereof may be used in combination. When two or more are used, the total amount is in the above range.

<Flame retardant>

The resin composition of the present embodiment may contain a flame retardant. Examples of the flame retardant include a phosphorus-based flame retardant, a halogen-based flame retardant, an inorganic flame retardant, and a silicone-based flame retardant, and the phosphorus-based flame retardant is preferred.
A known flame retardant can be used as the flame retardant, and examples thereof include: halogen-based flame retardants such as a brominated epoxy resin, brominated polycarbonate, brominated polystyrene, brominated styrene, brominated phthalimide, tetrabromobisphenol A, pentabromobenzyl(meth)acrylate, pentabromotoluene, tribromophenol, hexabromobenzene, decabromodiphenyl ether, bis-1,2-pentabromophenylethane, chlorinated polystyrene, and chlorinated paraffin; phosphorus-based flame retardants such as red phosphorus, tricresyl phosphate, triphenyl phosphate, cresyl diphenyl phosphate, trixylenyl phosphate, trialkyl phosphate, dialkyl phosphate, tris(chloroethyl)phosphate, phosphazene, 1,3-phenylene bis(2,6-dixylenyl phosphate), and 10-(2,5-dihydroxyphenyl)-10H-9-oxa-10-phosphaphenanthrene-10-oxide; inorganic flame retardants such as aluminum hydroxide, magnesium hydroxide, partial boehmite, boehmite, zinc borate, and antimony trioxide; and silicone-based flame retardants such as silicone rubber and a silicone resin.
In the present embodiment, of these, 1,3-phenylene bis(2,6-dixylenylphosphate) does not impair the low dielectric properties (Dk and/or Df) and thus is preferred.
When the resin composition of the present embodiment contains a flame retardant, the content thereof is preferably 1 part by mass or more, more preferably 5 parts by mass or more, and still more preferably 10 parts by mass or more, and may be 15 parts by mass or more, with respect to 100 parts by mass of the resin solid content in the resin composition. The lower limit of the content of the flame retardant is preferably 30 parts by mass or less, and more preferably 25 parts by mass or less, with respect to 100 parts by mass of the resin solid content in the resin composition.
One type of the flame retardants can be used alone, or two or more types thereof can be used in combination. When two or more are used, the total amount is in the above range.

<Active ester compound>

The resin composition of the present embodiment may contain an active ester compound within a range that does not impair the effects of the present invention. The active ester compound is not particularly limited, and for example, reference can be made to the description of paragraphs [0064] to [0066] of WO 2021/172317, the content of which is incorporated herein by reference.
When the resin composition of the present embodiment contains the active ester compound, the content of the active ester compound is preferably 1 part by mass or more and preferably 50 parts by mass or less, with respect to 100 parts by mass of the resin solid content in the resin composition.
The resin composition of the present embodiment may contain only one type of active ester compound or may contain two or more types of active ester compounds. When two or more types are contained, the total amount is preferably in the range described above.
The resin composition of the present embodiment can also be configured to contain substantially no active ester compound. The phrase "contain substantially no" means that the content of the active ester compound is less than 1 part by mass with respect to 100 parts by mass of the resin solid content in the resin composition, and the content is preferably less than 0.1 parts by mass, and more preferably less than 0.01 parts by mass.

<Dispersant>

The resin composition of the present embodiment may contain a dispersant. A dispersant commonly used in paints can be suitably used, and the type of the dispersant is not particularly limited. As the dispersant, a copolymer-based

wet dispersant is preferably used, and specific examples thereof include DISPERBYK (trade name) -110, 111, 161, 180, 2009, 2152, and 2155, and BYK (trade name) -W996, W9010, W903, and W940, all of which are available from BYK Japan KK.

When the resin composition of the present embodiment contains a dispersant, the lower limit of the content thereof is preferably 0.01 parts by mass or more, more preferably 0.1 parts by mass or more, and may be 0.3 parts by mass or more, with respect to 100 parts by mass of the resin solid content in the resin composition. Furthermore, the upper limit of a content of the dispersant is preferably 10 parts by mass or less, and more preferably 5 parts by mass or less, and may be 3 parts by mass or less, with respect to 100 parts by mass of the resin solid content in the resin composition.

One type of the dispersants may be used alone, or two or more types thereof may be used in combination. When two or more are used, the total amount is in the above range.

<Solvent>

The resin composition of the present embodiment may contain a solvent and preferably contains an organic solvent. When the resin composition of the present embodiment contains a solvent, the resin composition is in a form (of solution or varnish) in which at least some, or preferably all of the various resin solids described aforementioned are dissolved or homogeneously mixed in the solvent. The solvent is not particularly limited as long as it is a polar organic solvent or non-polar organic solvent capable of dissolving or homogeneously mixing at least some, or preferably all of the various resin solid contents described above; examples of the polar organic solvent include ketones (for example, acetone, methyl ethyl ketone, methyl isobutyl ketone, and cyclohexanone), cellosolves (for example, propylene glycol monomethyl ether and propylene glycol monomethyl ether acetate), esters (for example, ethyl lactate, methyl acetate, ethyl acetate, butyl acetate, isoamyl acetate, ethyl lactate, methyl methoxypropionate, and methyl hydroxyisobutyrate), and amides (for example, dimethoxy acetamide and dimethylformamide); and examples of the non-polar organic solvent include aromatic hydrocarbon atoms (for example, toluene and xylene).

One type of the solvents can be used alone, or two or more types thereof can be used in combination. When two or more are used, the total amount is in the above range.

<Other components>

The resin composition of the present embodiment may contain various polymer compounds such as thermoplastic resins and oligomers thereof, various additives, and the like other than the above-described components. Examples of the additive include ultraviolet absorbers, antioxidants, photopolymerization initiators, fluorescent whitening agents, photosensitizers, dyes, pigments, thickeners, flow control agents, lubricants, antifoaming agents, leveling agents, brighteners, and polymerization inhibitors. One type of these additives can be used alone, or two or more types thereof can be used in combination.

The content of components (various polymer compounds such as thermoplastic resins and oligomers thereof, various additives, and the like) other than the above-described components in the resin composition of the present embodiment is preferably 0 parts by mass or more and less than 10 parts by mass, more preferably 0 parts by mass or more and less than 5 parts by mass, still more preferably 0 parts by mass or more and less than 3 parts by mass, and may be 0 parts by mass or more and less than 1 part by mass, with respect to 100 parts by mass of the resin solid content.

The content (total amount) of the additive is preferably 0 parts by mass or more and less than 5 parts by mass, more preferably 0 parts by mass or more and less than 3 parts by mass, still more preferably 0 parts by mass or more and less than 1 part by mass, and may be 0 parts by mass or more and less than 0.5 parts by mass, with respect to 100 parts by mass of the resin solid content.

Examples of the polymerization inhibitor include quinone, a phenol-based polymerization inhibitor, nitroso, hydroxylamine, an organic boric acid compound, and a compound having a phenolic hydroxyl group. Specific examples thereof include 2-nitrophenol, 4-methoxyphenol, 4-tert-butylpyrocatechol, pyrogallol, 4,4'-butylidene bis(6-tert-butyl-m-cresol), tert-butylhydroquinone, 1,4-benzoquinone, 2-hydroxybenzophenone, cuprous chloride, phenothiazine, chloranil, naphthylamine, β-naphthol, 2,6-di-t-butyl-4-cresol, 2,2'-methylene bis(4-methyl-6-t-butylphenol), pyridine, nitrobenzene, dinitrobenzene, picric acid, 4-toluidine, methylene blue, copper-organic chelating agent reaction product, methyl salicylate, dibutylhydroxytoluene, 1,1-diphenyl-2-picrylhydrazyl free radical, hydroquinone, hydroquinone monomethyl ether, mequinol, N-nitroso-N-phenylhydroxylamine aluminum, triethyl borate, tributyl borate, triisopropyl borate, 2,3-dihydroxynaphthalene, 4-methoxy-1-naphthol, and methylhydroquinone. In addition, the polymerization inhibitor to be used is not limited only to those described above.

When the resin composition of the present embodiment contains the polymerization inhibitor, the content thereof is preferably 0.001 parts by mass or more, more preferably 0.01 parts by mass or more, still more preferably 0.02 parts by mass or more, and even more preferably 0.04 parts by mass or more, and is preferably 10 parts by mass or less, more preferably 3 parts by mass or less, still more preferably 1 part by mass or less, even more preferably 0.5 parts by mass or

less, and further more preferably 0.2 parts by mass or less, with respect to 100 parts by mass of the resin solid content. When the content is the above lower limit or more, the low dielectric properties (Dk and/or Df, in particular, Df) of the resulting cured product after heating for a long period of time tend to be further improved. When the content is the above upper limit or less, the resulting cured product tends to have improved low dielectric properties (Dk and/or Df) and thermal resistance.

The resin composition of the present embodiment may include only one type of polymerization inhibitor, or may include two or more types thereof. When two or more types are contained, the total amount is preferably in the range described above.

<Application>

The resin composition of the present embodiment is used as a cured product. Specifically, the resin composition of the present embodiment can be suitably used as a low relative permittivity material and/or a low dielectric loss tangent material, and as a resin composition for an electronic material, such as an insulating layer of a printed wiring board or a material for a semiconductor package. The resin composition of the present embodiment can be suitably used as a material for a prepreg, a metal foil-clad laminate including the prepreg, a resin composite sheet, and a printed wiring board.

The cured product of the resin composition of the present embodiment preferably has a low relative permittivity (Dk) and a low dielectric loss tangent (Df). Specifically, when the resin composition is molded into a cured plate (without metal foil) having a thickness of 1.0 mm, the relative permittivity (Dk) at a frequency of 10 GHz measured according to a cavity resonator perturbation method is preferably less than 2.40. The lower limit of the relative permittivity (Dk) is not particularly determined but is, for example, practically 0.01 or more. When the resin composition is molded into a cured plate (without metal foil) having a thickness of 1.0 mm, the dielectric loss tangent (Df) at a frequency of 10 GHz measured according to a cavity resonator perturbation method is preferably 0.0020 or less. The lower limit of the dielectric loss tangent (Df) is not particularly specified, but is practically at least 0.0001, for example.

In the resin composition of the present embodiment, it is preferable that the Dk is less than 2.40 and the Df is 0.0020 or less.

The relative permittivity (Dk) and the dielectric loss tangent (Df) are, more specifically, measured according to methods which will be described in Examples below.

The resin composition of the present embodiment is used in the form of a layered material (intended to include a film-like or sheet-like material), such as a prepreg or a resin composite sheet serving as an insulating layer of a printed wiring board. When the resin composition is formed into such a layered material, the thickness of the layered material is preferably 5 μm or more, and more preferably 10 μm or more. The upper limit of the thickness is preferably 200 μm or less and more preferably 180 μm or less. The thickness of the layered material means, for example, a thickness including a glass cloth when the glass cloth or such is impregnated with the resin composition of the present embodiment.

The material formed from the resin composition of the present embodiment may be used in an application to form a pattern by exposure and development or may be used in an application not involving exposure and development. In particular, the material is suitable for an application not involving exposure and development.

<<Prepreg>>

A prepreg of the present embodiment is formed from a substrate (prepreg substrate) and the resin composition of the present embodiment. The prepreg of the present embodiment is produced by, for example, applying the resin composition of the present embodiment to a substrate (for example, impregnating and/or coating the substrate with the resin composition) and then semi-curing the resin composition by heating (for example, by a method of drying at 120 to 220°C for 2 to 15 minutes). In this case, the amount of the resin composition adhered to the substrate, that is, the amount of the resin composition (including the filler) relative to the total amount of the prepreg after semi-curing is preferably in a range of 20 to 99 mass% and more preferably in a range of 20 to 80 mass%.

The substrate is not particularly limited as long as it is a substrate used in various printed wiring board materials. Examples of the material of the substrate include glass fibers (for example, such as E-glass, D-glass, L-glass, S-glass, T-glass, Q-glass, UN-glass, NE-glass, NER-glass, NEZ-glass, and spherical glass), inorganic fibers other than glass (for example, such as quartz), and organic fibers (for example, such as polyimide, polyamide, polyester, liquid crystal polyester, and polytetrafluoroethylene). The form of the substrate is not particularly limited, and examples include woven fabrics, nonwoven fabrics, rovings, chopped strand mats, and surfacing mats. One type of the substrates may be used alone, or two or more types thereof may be used in combination. Among these substrates, from the viewpoint of dimensional stability, the substrate is preferably a woven fabric subjected to ultra fiber opening and fine weaving; from the viewpoints of strength and low water absorption, the substrate is preferably a glass woven fabric with a thickness of 200 μm or less and a mass of 250 $g/m^2$ or less; and from the viewpoint of moisture-absorbability/thermal resistance, the substrate is preferably a glass woven fabric surface-treated with a silane coupling agent or the like, such as an epoxy silane

or an aminosilane. From the viewpoint of electrical properties, the substrate is more preferably a low relative dielectric glass cloth made of a glass fiber, such as a glass fiber of L-glass, NE-glass, NER-glass, NEZ-glass, or Q-glass, achieving a low relative permittivity and a low dielectric loss tangent.

The low relative permittivity substrate is exemplified by a substrate with a relative permittivity of 5.0 or less (preferably from 3.0 to 4.9). The low dielectric loss tangent substrate is exemplified by a substrate with a dielectric loss tangent of 0.006 or lower (preferably from 0.001 to 0.005). The relative permittivity and the dielectric loss tangent are defined as the values obtained by measurement at a frequency of 10 GHz by the cavity resonator based on the perturbation method.

<<Metal foil-clad laminate>>

The metal foil-clad laminate of the present embodiment includes at least one layer formed from the prepreg of the present embodiment, and a metal foil disposed on one surface or both surfaces of the layer formed from the prepreg. Examples of the method for producing a metal foil-clad laminate of the present embodiment include a method of disposing at least one prepreg (preferably stacking two or more prepregs) of the present embodiment, disposing a metal foil on one or both sides of the prepreg, and laminate-molding the metal foil and the prepreg. More specifically, the metal foil-clad laminate can be produced by disposing a metal foil of copper, aluminum, or the like on one side or both sides of the prepreg, and laminate-molding the metal foil and the prepreg. The number of prepregs is preferably from 1 to 10, more preferably from 2 to 10, and still more preferably from 2 to 9.

The metal foil is any metal foil used in materials for printed wiring boards and is not particularly limited, but examples include a copper foil, such as a rolled copper foil and an electrolytic copper foil. The thickness of the metal foil (preferably a copper foil) is not particularly limited and may be approximately from 1.5 to 70 μm. When a copper foil is used as the metal foil, as the copper foil, roughness Rz of a copper foil surface as measured in accordance with JIS B 0601: 2013 is adjusted to from 0.2 to 4.0 μm. When the copper foil surface roughness Rz is 0.2 μm or more, the roughness of the copper foil surface is adjusted to a suitable level, and the copper foil peel strength tends to be further improved. On the other hand, with the roughness Rz of the copper foil surface being 4.0 μm or less, the roughness of the copper foil surface becomes an appropriate level, and the dielectric loss tangent properties of the resulting cured product tend to further improve. From the viewpoint of reducing the dielectric loss tangent, the copper foil surface roughness Rz is more preferably 0.5 μm or more, still more preferably 0.6 μm or more, particularly preferably 0.7 μm or more, and is more preferably 3.5 μm or less, still more preferably 3.0 μm or less, particularly preferably 2.0 μm or less.

Examples of the laminate-molding method include methods commonly used in molding a laminate and a multilayer board for a printed wiring board, and more specific examples include a method of laminate-molding using a multi-stage press, a multi-stage vacuum press, a continuous molding machine, an autoclave molding machine, or the like at a temperature of approximately 180 to 350°C, a heating time of approximately 100 to 300 minutes, and a surface pressure of approximately 1 to 10 MPa. In addition, the prepreg of the present embodiment is combined and laminate-molded with a separately produced wiring board for an inner layer and can also be formed into a multilayer board. In a method of manufacturing a multilayer board, a multilayer board can be produced, for example, by disposing copper foils of approximately 35 μm on both sides of one prepreg of the present embodiment, laminate-molding them by the molding method described above, then forming an inner layer circuit, subjecting the inner layer circuit to a blackening treatment to form an inner layer circuit board, then alternately disposing the inner layer circuit board and the prepreg of the present embodiment one by one, and further disposing a copper foil on the outermost layer, followed by lamination molding under the conditions above preferably under vacuum. The metal foil-clad laminate of the present embodiment can be suitably used as a printed wiring board.

The metal foil-clad laminate of the present embodiment has a peel strength of preferably 0.28 kN/m or more, more preferably 0.38 kN/m or more, and even more preferably 0.50 kN/m or more as measured in accordance with 5.7 "Peel Strength" specified in JIS C6481. The upper limit of the peel strength is not particularly limited, and for example, even if the peel strength is 2.00 kN/m or less, the required performance is sufficiently satisfied.

As described above, in the resin composition for an electronic material obtained using the resin composition of the present embodiment (resin composition including a combination of specific components), the cured product thereof can have characteristics excellent in thermal resistance, desmear resistance, crack resistance, appearance of the cured product, and low thermal expansion property in addition to the low dielectric properties (low permittivity, low dielectric loss tangent, in particular low permittivity), the moisture-absorbability/thermal resistance, and the peel strength to the metal foil.

<<Printed wiring board>>

A printed wiring board of the present embodiment is a printed wiring board including an insulating layer and a conductor layer disposed on the surface of the insulating layer, and the insulating layer includes at least one of a layer formed from the resin composition of the present embodiment or a layer formed from the prepreg of the present

embodiment. Such a printed wiring board can be manufactured by a common method, and the manufacturing method is not particularly limited. An example of the method of manufacturing the printed wiring board is described below. First, the metal foil-clad laminate, such as the copper foil-clad laminate, described above is prepared. Next, the surface of the metal foil-clad laminate is subjected to an etching treatment to form an inner layer circuit, and an inner layer substrate is produced. The inner layer circuit surface of the inner layer substrate is subjected to surface treatment to increase the adhesive strength as necessary, then a required number of the prepregs described above are layered on the inner layer circuit surface, a metal foil for an outer layer circuit is further laminated on the outer side, and the laminate is heated, pressurized, and integrally molded. A multilayer laminate is thus manufactured with an insulating layer composed of a substrate and a cured product of the resin composition formed between the inner layer circuit and the metal foil for the outer layer circuit. Then, the multilayer laminate is subjected to a drilling process for a through hole or a via hole, and then a plated metal film, for electrically connecting the inner layer circuit and the metal foil for the outer layer circuit, is formed on the wall surfaces of the holes. Further, the metal foil for the outer layer circuit is subjected to an etching treatment to form the outer layer circuit, thereby producing a printed wiring board.

The printed wiring board produced in the aforementioned producing example is configured to include an insulating layer and a conductor layer formed on the surface of the insulating layer, in which the insulating layer is configured to contain the resin composition of the present embodiment described above and/or the cured product thereof. That is, the prepreg of the present embodiment described above (for example, a prepreg formed from a substrate and the resin composition of the present embodiment impregnated into or applied onto the substrate) and the layer formed from the resin composition on the metal foil-clad laminate of the present embodiment described above serve as the insulating layer of the present embodiment.

The present embodiment also relates to a semiconductor device including the printed wiring board. For details of the semiconductor device, reference can be made to the description of paragraphs 0200 to 0202 of JP 2021-021027 A, the contents of which are incorporated herein by reference.

In the insulating layer formed of the cured product of the resin composition of the present embodiment, it is preferable to reduce the surface roughness of the insulating layer after roughening treatment. Specifically, the arithmetic average roughness Ra of the surface of the insulating layer after the roughening treatment is preferably 200 nm or less, more preferably 150 nm or less, and particularly preferably 100 nm or less. The lower limit of the arithmetic average roughness Ra is not particularly limited, and may be, for example, 10 nm or more. The arithmetic average roughness Ra of the surface of the insulating layer is measured using a non-contact type surface roughness meter, a VSI mode, and a lens with a magnification of 50.

As the non-contact type surface roughness meter, WYKONT3300 available from Beacon Instruments is used.

<<Resin composite sheet>>

A resin composite sheet of the present embodiment includes a layer including a support and the resin composition of the present embodiment disposed on a surface of the support. The resin composite sheet can be used as a build-up film or a dry film solder resist. The method for producing the resin composite sheet is not particularly limited, and examples include a method in which a solution obtained by dissolving the resin composition of the present embodiment in a solvent is coated (applied) to a support and dried to obtain a resin composite sheet.

Examples of the support used herein include, but are not particularly limited to, organic-based film substrates, such as polyethylene films, polypropylene films, polycarbonate films, poly(ethylene terephthalate) films, ethylene-tetrafluoroethylene copolymer films, as well as release films formed by coating a surface of such a film with a release agent, and polyimide films; conductive foils, such as copper foils and aluminum foils; and plate-like supports, such as glass plates, steel use stainless (SUS) plates, and fiber-reinforced plastics (FRPs).

For example, the application method (coating method) involves application of a solution prepared by dissolving the resin composition of the present embodiment in a solvent onto a support by using a bar coater, a die coater, a doctor blade, or a Baker applicator. In addition, a monolayer sheet can also be formed by peeling or etching the support after drying from the resin composite sheet in which the support and the resin composition are laminated. A monolayer sheet can also be produced without using a support by, for example, feeding a solution prepared by dissolving the resin composition of the present embodiment in a solvent into a mold having a sheet-shaped cavity and drying the solution to mold into a sheet shape.

In the production of the monolayer sheet or the resin composite sheet of the present embodiment, the drying conditions for removing the solvent are not particularly limited. However, drying at a low temperature is likely to cause the solvent to remain in the resin composition, and drying at a high temperature allows the curing of the resin composition to proceed. Thus, the drying is preferably performed at a temperature from 20°C to 200°C for from 1 to 90 minutes. The monolayer sheet or resin composite sheet can be used in an uncured state where the solvent is only dried or can be used as necessary in a semi-cured (B-staged) state. Further, the thickness of the resin layer in the monolayer sheet or resin composite sheet of the present embodiment can be adjusted by the concentration of the solution of the resin composition

used for coating (application) of the present embodiment and the coating thickness, and is not particularly limited. However, in general, as the thickness of the coating increases, the solvent is likely to remain during drying, and thus the thickness is preferably from 0.1 to 500 μm.

## Examples

Hereinafter, the present invention will be described more specifically with reference to Examples. Materials, amounts used, proportions, processing details, and processing procedures described in the following Examples can be appropriately changed without departing from the spirit of the present invention. Thus, the scope of the present invention is not limited to the specific examples described below.

When it is difficult to obtain a measuring instrument or the like used in Examples because of discontinuation or the like, another instrument with equivalent performance can be used for the measurements.

<Measurement of weight average molecular weight and number average molecular weight>

The weight average molecular weight (Mw) and the number average molecular weight (Mn) of the compound (including the resin) were measured by a gel permeation chromatography (GPC) method. The measurement was conducted using a liquid feed pump (LC-20AD available from Shimadzu Corporation), a differential refractive index detector (RID-20A available from Shimadzu Corporation), and GPC columns (GPC KF-801, 802, 803, 804, available from Showa Denko K.K.), and also using tetrahydrofuran as a solvent, at a flow rate of 1.0 mL/min, a column temperature of 40°C, and a calibration curve based on monodispersed polystyrene.

<Measurement of parameters α and β>

The parameters α and β in the resin (A) were calculated by $^1$H-NMR measurement. The synthesized resin was dissolved in a mixed solvent of heptane and methanol and repeatedly dried to remove a residual solvent contained in a recovered solid. Thereafter, the recovered solid was dissolved in $CDCl_3$ (containing 0.03 vol% of TMS (tetramethylsilane)), and $^1$H-NMR measurement was performed. The parameters α and β of each resin were calculated using the following formula in the measured $^1$H-NMR. A peak position of TMS (tetramethylsilane) was set to 0 ppm.

As an apparatus, NMR AVANCE NEO500 available from Bruker was used.

[Num.10]

$$\text{PARAMETER } \alpha = \frac{(2.55ppm \text{ to } 2.31ppm)}{(6.24ppm \text{ to } 5.91ppm)+(2.98ppm \text{ to } 2.55ppm)/2+(2.55ppm \text{ to } 2.31ppm)} \quad (\alpha)$$

$$\text{PARAMETER } \beta = \frac{\{(5.49ppm \text{ to } 4.89ppm)-(4.89ppm \text{ to } 4.45ppm)\}\times 1.5}{(2.31ppm \text{ to } 1.96ppm)-(2.55ppm \text{ to } 2.31ppm)} \quad (\beta)$$

(Expressions in parentheses in Equations (α) and (β) indicate integral values between corresponding chemical shift values in $^1$H-NMR.)

<Synthesis Example 1 Synthesis of resin (A) having terminal group represented by Formula (T1) and having indane skeleton>

A flask equipped with a thermometer and a cooling tube was charged with 520 g of toluene, 0.75 g of activated clay, 150 g of 1,3-diisopropenylbenzene (available from Tokyo Chemical Industry), and a stirring bar, and the mixture was heated to an internal temperature of 50°C while being stirred. Thereafter, the mixture was gradually heated to an internal temperature of 70°C over 5 hours, and further reacted at an internal temperature of 70°C for 1 hour. After cooling, the activated clay was removed by filtration, and the solvent was distilled off with heating under reduced pressure to produce 129 g of a solid resin. An NMR chart of the produced resin is illustrated in FIG. 1.

The produced resin (A) had Mw of 1193, Mn of 693, and Mw/Mn of 1.7. In Formula (Tx), the parameter α was 0.63, the parameter β was 1.07, and n + o + p was 3.4. The structures in parentheses represented by (a), (b), and (c) in Formula (Tx) all had the same molecular weight, and n + o + p was calculated assuming that the Mn of the synthesized resin was the average molecular weight. It was confirmed that the amount of the residual monomer was 1 mass% or less through GPC analysis. The functional group equivalent (isopropenyl group equivalent) of the obtained resin (A) was 324 g/eq.

The functional group equivalent (g/eq.) of the resin (A) was calculated from (number average molecular weight

(Mn) ÷ 2) ÷ β.

<Synthesis Example 2 Polyphenylene ether compound (B1) having carbon-carbon unsaturated double bond at terminal>

<<Synthesis of bifunctional phenylene ether oligomer>>

A 12 L vertically long reactor equipped with a stirrer, a thermometer, an air introduction tube, and a baffle plate was charged with 1.81 g (11 mmol) of N,N'-di-t-butylethylenediamine of 9.36 g (42 mmol) of $CuBr_2$ (copper bromide), 67.8 g (670 mmol) of n-butyldimethylamine, and 2600 g of toluene, and the mixture was stirred at an internal temperature of 40°C. To this, a mixed solution of 129.3 g (0.48 mol) of 2,2',3,3',5,5'-hexamethyl-(1,1'-biphenyl)-4,4'-diol previously dissolved in 2300 g of methanol, 878 g (7.2 mol) of 2,6-dimethylphenol, 1.22 g (7.2 mmol) of N,N'-di-t-butylethylenediamine, and 26.4 g (261 mmol) of n-butyldimethylamine was added dropwise over 230 minutes while bubbling a mixed gas obtained by mixing nitrogen and air and adjusting the oxygen concentration to 8% at a flow rate of 5.2 L/min, and the resulting mixture was stirred at a reaction temperature of 40°C.

After completion of the dropwise addition, 1500 g of water in which 48.1 g (130 mmol) of tetrasodium ethylenediaminetetraacetate had been dissolved was added to stop the reaction. The aqueous layer and the organic layer were separated from each other, and the organic layer was washed with 1 M aqueous hydrochloric acid solution and then with pure water. The obtained solution was concentrated to 50 mass% with an evaporator to obtain 1980 g of a toluene solution A1 of a phenylene ether resin. The toluene solution A had a number average molecular weight of 1975 by the GPC method calibrated with polystyrene standards, a weight average molecular weight of 3514 by the GPC method calibrated with polystyrene standards, and a hydroxyl group equivalent of 990 g/eq.

<<Synthesis of Modified Polyphenylene Ether Compound>>

A reactor equipped with a stirrer, a thermometer, and a reflux tube was charged with 833 g of the toluene solution A1 of the phenylene ether resin obtained above, 76.7 g (0.50 mol) of vinylbenzyl chloride ("CMS-P" available from AGC Seimi Chemical Co., Ltd.), 1600 g of methylene chloride, 6.20 g (0.046 mol) of benzyldimethylamine, 200 g of pure water, and 84 g of a 30.5 mass% NaOH aqueous solution, and the mixture was stirred at a reaction temperature of 40°C. After stirring for 24 hours, the organic layer was washed with a 1 M aqueous hydrochloric acid solution followed by pure water. The resulting solution was concentrated, and added dropwise to methanol to solidify the solution. The solid was collected by filtration, and vacuum-dried to obtain 450 g of a polyphenylene ether compound (B1) mainly composed of a compound represented by Formula (OP-15).

The number average molecular weight by the GPC method calibrated with polystyrene standards was 2250, the weight average molecular weight by the GPC method calibrated with polystyrene standards was 3920, the double bond equivalent of the vinyl group was 1189 g/eq., and the hydroxyl group equivalent was 56250 g/eq.

<Synthesis Example 3 Polyphenylene ether compound (B2) having carbon-carbon unsaturated double bond at terminal>

<<Synthesis of Bifunctional Phenylene Ether Oligomer>>

0.33 g (1.5 mmol) of $CuBr_2$ (copper bromide), 0.63 g (3.7 mmol) of N,N'-di-t-butylethylenediamine, 6.95 g (69 mmol) of n-butyldimethylamine, 670 g of toluene, and 320 g of methanol were charged in a vertically long reactor (polymerization tank) equipped with a stirrer, a thermometer, an air introduction tube, and a baffle plate, stirred at an internal temperature of 40°C, and dissolved. To this, 46.2 g (171 mmol) of 2,2',3,3',5,5'-hexamethyl-(1,1'-biphenyl)-4,4'-diol, 129.5 g (1060 mmol) of 2,6-dimethylphenol, 0.33 g (1.5 mmol) of $CuBr_2$ (copper bromide), 0.63 g (3.7 mmol) of N,N'-di-t-butylethylenediamine, 6.95 g (69 mmol) of n-butyldimethylamine, 440 g of toluene, and 170 g of methanol were charged in advance in another container (dropping funnel), and the mixture was stirred at an internal temperature of 40°C to be dissolved.

Thereafter, a mixed solution in the dropping funnel was added dropwise over 280 minutes while bubbling a mixed gas obtained by mixing nitrogen and air and adjusting the oxygen concentration to 8% into the mixed liquid in the polymerization tank, and the mixture was stirred at a reaction temperature of 40°C.

After completion of the dropwise addition, 700 g of water in which 7.1 g (16 mmol) of tetrasodium ethylenediaminetetraacetate had been dissolved was added to cease the reaction. The aqueous layer and the organic layer were separated from each other, and the organic layer was washed with 1 M aqueous hydrochloric acid solution and then with pure water. The obtained solution was concentrated to 50 mass% with an evaporator to obtain 340 g of a toluene solution A2 of a phenylene ether resin. The toluene solution A1 had a number average molecular weight of 985 by the GPC method

calibrated with polystyrene standards, a weight average molecular weight of 1090 by the GPC method calibrated with polystyrene standards, and a hydroxyl group equivalent of 478 g/eq.

<<Synthesis of Modified Polyphenylene Ether Compound>>

A reactor equipped with a stirrer, a thermometer, and a reflux tube was charged with 300 g of the toluene solution A2 of the phenylene ether resin obtained above, 57.5 g (0.38 mol) of vinylbenzyl chloride ("CMS-P" available from AGC Seimi Chemical Co., Ltd.), 1200 g of methylene chloride, 5 g (0.037 mol) of benzyldimethylamine, 70 g of pure water, and 63 g of a 30.5 mass% NaOH aqueous solution, and the mixture was stirred at a reaction temperature of 40°C. After stirring for 24 hours, the organic layer was washed with a 1 M aqueous hydrochloric acid solution followed by pure water. The obtained solution was concentrated, and added dropwise to methanol to solidify the solution. The solid was collected by filtration, and vacuum-dried to obtain 178 g of a polyphenylene ether compound (B2) mainly composed of a compound represented by Formula (OP-15).

The number average molecular weight by the GPC method calibrated with polystyrene standards was 1200, the weight average molecular weight by the GPC method calibrated with polystyrene standards was 1840, the double bond equivalent of the vinyl group was 620 g/eq., and the hydroxyl group equivalent was 48500 g/eq.

<Synthesis Example 4: Synthesis of polymer (va) having structural unit represented by Formula (V)>

Into a reactor were placed 2.25 mol (292.9 g) of divinylbenzene, 1.32 mol (172.0 g) of ethylvinylbenzene, 11.43 mol (1190.3 g) of styrene, and 15.0 mol (1532.0 g) of n-propyl acetate, then 600 mmol of a diethyl ether complex of boron trifluoride was added thereto at 70°C, and the mixture was allowed to react for 4 hours. After the polymerization reaction was stopped with an aqueous sodium bicarbonate solution, the oil layer was washed three times with pure water, devolatilized under reduced pressure at 60°C, and a polymer (va) having a structural unit represented by Formula (V) was collected. The resulting polymer (va) having the structural unit represented by Formula (V) was weighed to confirm that 860.8 g of the polymer (va) having the structural unit represented by Formula (V) was produced.

The resulting polymer (va) having the structural unit represented by Formula (V) had a number average molecular weight Mn of 2060, a weight average molecular weight Mw of 30700, and a monodispersity Mw/Mn of 14.9. $^{13}$C-NMR and $^{1}$H-NMR analyses were performed, and a resonance line originating from each monomer unit used as the raw materials was observed in the polymer (va) having the structural unit represented by Formula (V). Based on the NMR measurement results and GC analytical results, the proportions of the structural units of the polymer (va) (structural units derived from respective raw materials) having the structural unit represented by Formula (V) were calculated as follows.

Structural units derived from divinylbenzene: 20.9 mol% (24.3 mass%)
Structural units derived from ethylvinylbenzene: 9.1 mol% (10.7 mass%)
Structural units derived from styrene: 70.0 mol% (65.0 mass%)

The proportion of a structural unit having a residual vinyl group derived from divinylbenzene was 16.7 mol% (18.5 mass%). The vinyl group equivalent was 241 g/eq.

Example 1

20 parts by mass of the resin (A) obtained in Synthesis Example 1, 70 parts by mass of a maleimide compound (ma) ("NE-X-9470S" available from DIC Corporation, functional group equivalent (maleimide group equivalent) was 450 g/eq.) having the following structure, and 10 parts by mass of a hydrogenated styrene thermoplastic elastomer (SEPS, SEPTON2104, Mn83000, available from KURARAY CO., LTD.) were dissolved in methyl ethyl ketone and toluene and mixed to obtain a varnish. The content of each component described above indicates a value in terms of solid content.

Maleimide compound (ma)

[Chem.115]

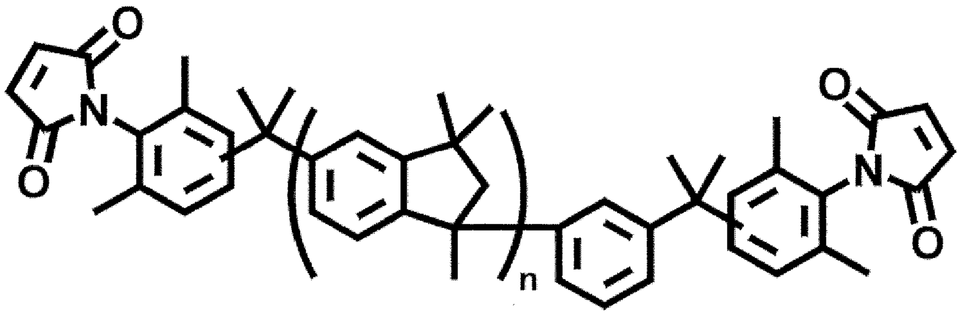

<Production of cured plate with copper foil having thickness of 1.0 mm>

The solvent was distilled off by evaporation from the obtained varnish, and a powder of a resin composition was obtained. Using the obtained powder of the resin composition, a cured plate with copper foil was prepared as follows. 4.5 g of the powder of the resin composition was spread in a stainless steel mold of 100 mm × 30 mm × 1.0 mm high frame, and 12 μm copper foils (3EC-M3-VLP, available from Mitsui Kinzoku Co., Ltd.) were arranged on both sides, set in a vacuum press machine (available from KITAGAWA SEIKI CO., LTD.), held at 200°C for 1.5 hours, and pressed at a surface pressure of 1.9 MPa.

The obtained cured plate with copper foil was used to evaluate the moldability, the relative permittivity (Dk), the dielectric loss tangent (Df), and the peel strength. In the evaluation of the moldability, the relative permittivity (Dk), and the dielectric loss tangent (Df), the evaluation is performed in a state where the copper foil is etched. The evaluation results are presented in Tables 1, 2, 3, and 4.

<Methods of measurement and evaluation>

(1) Moldability

The moldability was evaluated as follows.

The copper foils on both surfaces of the cured plate with copper foil obtained as described above were removed by etching, downsized to a width of 1.0 mm, and then dried at 120°C for 60 minutes. This sample was evaluated.

A: The product could be molded, and was not deformed even under a drying condition of 120°C for 60 minutes.
B: Although the product could be molded, the product was deformed under the drying condition of 120°C for 60 minutes, and the characteristics could not be evaluated.
C: The product was broken and could not be molded.

(2) Dielectric properties

Among the samples evaluated for moldability, the sample evaluated as A was used as it was, and the relative permittivity (Dk) and the dielectric loss tangent (Df) at a frequency of 10 GHz were measured using a perturbation method cavity resonator. The measurement temperature was 23°C. Evaluation was made as follows:

A: Dk is less than 2.40, and Df is 0.0020 or less
B: Dk is less than 2.40 and Df is more than 0.0020, or Dk is 2.40 or more and Df is 0.0020 or less
C: Dk is 2.40 or more, and Df is more than 0.0020

As the cavity resonator based on the perturbation method, P5005A available from Keysite Technologies was used.

(3) Peel strength

Using the cured plate with copper foil obtained as described above (10 mm × 100 mm × 1 mm), the copper foil peel strength (adhesive strength) was measured three times in accordance with 5.7 "Peel Strength" specified in JIS C 6481, and the average value was determined. The measurement temperature was 23°C.

A: 0.50 kN/m or more
B: less than 0.50 kN/m

Example 2

The same procedure as in Example 1 was carried out, except that the content of the resin (A) obtained in Synthesis Example 1 was 15 parts by mass, the content of the maleimide compound (ma) was 55 parts by mass, and the content of the hydrogenated styrene thermoplastic elastomer (SEPTON2104) was 30 parts by mass, in Example 1.

Example 3

The same procedure as in Example 1 was carried out, except that the content of the resin (A) obtained in Synthesis Example 1 was 20 parts by mass, the content of the maleimide compound (ma) was changed to 60 parts by mass, and the hydrogenated styrene thermoplastic elastomer (SEPTON2104) was changed to 20 parts by mass of a partially hydrogenated styrene thermoplastic elastomer (SEBS, S.O.E. (trade name) S1609, Mn228000, available from Asahi Kasei Corporation), in Example 1.

Example 4

The same procedure as in Example 1 was carried out, except that the content of the resin (A) obtained in Synthesis Example 1 was 20 parts by mass, the maleimide compound (ma) was not blended, the content of the polyphenylene ether compound (B1) having a carbon-carbon unsaturated double bond at a terminal obtained in Synthesis Example 2 was 50 parts by mass, and the content of the hydrogenated styrene thermoplastic elastomer (SEPTON2104) was 30 parts by mass, in Example 1.

Example 5

The same procedure as in Example 1 was carried out, except that the content of the resin (A) obtained in Synthesis Example 1 was 25 parts by mass, the content of the maleimide compound (ma) was 25 parts by mass, the content of the polyphenylene ether compound (B2) having a carbon-carbon unsaturated double bond at a terminal obtained in Synthesis Example 3 was 37.5 parts by mass, and the content of the hydrogenated styrene thermoplastic elastomer (SEPTON2104, Mn83000, available from KURARAY CO., LTD.) was 12.5 parts by mass, in Example 1.

Example 6

The same procedure as in Example 1 was carried out, except that the content of the resin (A) obtained in Synthesis Example 1 was 20 parts by mass, the maleimide compound (ma) was not blended, the content of the polyphenylene ether compound (B1) having a carbon-carbon unsaturated double bond at a terminal obtained in Synthesis Example 2 was 50 parts by mass, and the hydrogenated styrene thermoplastic elastomer (SEPTON2104) was changed to 30 parts by mass of a hydrogenated styrene thermoplastic elastomer (SEBS, Tuftec (trade name) H1043, Mn39000, available from Asahi Kasei Corporation), in Example 1.

Example 7

The same procedure as in Example 1 was carried out, except that the content of the resin (A) obtained in Synthesis Example 1 was 20 parts by mass, the maleimide compound (ma) was not blended, the content of the polyphenylene ether compound (B1) having a carbon-carbon unsaturated double bond at a terminal obtained in Synthesis Example 2 was 50 parts by mass, and the hydrogenated styrene thermoplastic elastomer (SEPTON2104) was changed to 30 parts by mass of a partially hydrogenated styrene thermoplastic elastomer (S1609), in Example 1.

Example 8

The same procedure as in Example 1 was carried out, except that the content of the resin (A) obtained in Synthesis Example 1 was 37 parts by mass, the maleimide compound (ma) was not blended, the content of the maleimide compound (the compound represented by Formula (M4), BMI-70 available from K · I Chemical Industry Co., Ltd. functional group equivalent (maleimide group equivalent) was 221 g/eq.) was 58 parts by mass, the hydrogenated styrene thermoplastic elastomer (SEPTON2104) was not blended, the content of the hydrogenated styrene thermoplastic elastomer (SEBS, S.O.E. (trade name) S1605, available from Asahi Kasei Corporation) was 5 parts by mass, and the

content of perbutyl P(α,α'-di(t-butylperoxy)diisopropylbenzene, available from NOF CORPORATION) was 0.5 parts by mass, in Example 1.

Example 9

The same procedure as in Example 1 was carried out, except that the content of the resin (A) obtained in Synthesis Example 1 was 35 parts by mass, the maleimide compound (ma) was not blended, the content of the maleimide compound (the compound represented by Formula (M4), BMI-70 available from K · I Chemical Industry Co., Ltd. functional group equivalent (maleimide group equivalent) was 221 g/eq.) was 55 parts by mass, the content of the hydrogenated styrene thermoplastic elastomer (SEPTON2104, Mn83000, available from KURARAY CO., LTD.) was 10 parts by mass, and the content of perbutyl P(α,α'-di(t-butylperoxy)diisopropylbenzene, available from NOF CORPORATION) was 0.5 parts by mass, in Example 1.

Example 10

The same procedure as in Example 1 was carried out, except that the content of the resin (A) obtained in Synthesis Example 1 was 18 parts by mass, the maleimide compound (ma) was not blended, the content of the maleimide compound (the compound represented by Formula (M4), BMI-70 available from K · I Chemical Industry Co., Ltd. functional group equivalent (maleimide group equivalent) was 221 g/eq.) was 9 parts by mass, the hydrogenated styrene thermoplastic elastomer (SEPTON2104) was not blended, the content of the hydrogenated styrene thermoplastic elastomer (SEBS, S.O.E. (trade name) S1605, available from Asahi Kasei Corporation) was 10 parts by mass, the content of a modified polyphenylene ether compound (SA9000 available from SABIC Innovative Plastics, functional group equivalent (double bond equivalent of vinyl group) was 1011 g/eq.) having a methacrylic group at a terminal was 26 parts by mass, the content of triallyl isocyanurate (available from Nihon Kasei CO., LTD., molecular weight: 249.7, number of terminal double bonds: 3) was 37 parts by mass, and the content of perbutyl P(α,α'-di(t-butylperoxy)diisopropylbenzene, available from NOF CORPORATION) was 0.5 parts by mass, in Example 1.

Example 11

The same procedure as in Example 1 was carried out, except that the content of the resin (A) obtained in Synthesis Example 1 was 30.5 parts by mass, the maleimide compound (ma) was not blended, the content of the maleimide compound (the compound represented by Formula (M4), BMI-70 available from K • I Chemical Industry Co., Ltd. functional group equivalent (maleimide group equivalent) was 221 g/eq.) was 23.5 parts by mass, the content of the hydrogenated styrene thermoplastic elastomer (SEPTON2104, Mn83000, available from Kuraray Co., Ltd.) was 8.5 parts by mass, the content of the hydrogenated styrene thermoplastic elastomer (SEBS, S.O.E. (trade name) S1605, available from Asahi Kasei Corporation) was 8.5 parts by mass, the content of a modified polyphenylene ether compound (available from SABIC Innovative Plastics, SA9000, functional group equivalent (double bond equivalent of vinyl group) was 1011 g/eq.) having a methacrylic group at a terminal was 15 parts by mass, the content of triallyl isocyanurate (available from Nihon Kasei CO., LTD., molecular weight: 249.7, number of terminal double bonds: 3) was 14 parts, and the content of perbutyl P(α,α'-di(t-butylperoxy)diisopropylbenzene, available from NOF CORPORATION) was 0.5 parts by mass, in Example 1.

Example 12

The same procedure as in Example 1 was carried out, except that the content of the resin (A) obtained in Synthesis Example 1 was 27 parts by mass, the maleimide compound (ma) was not blended, the content of the maleimide compound (the compound represented by Formula (M4), BMI-70 available from K · I Chemical Industry Co., Ltd. functional group equivalent (maleimide group equivalent) was 221 g/eq.) was 15 parts by mass, the hydrogenated styrene thermoplastic elastomer (SEPTON2104) was not blended, the content of the hydrogenated styrene thermoplastic elastomer (SEBS, S.O.E. (trade mark) S1605, available from Asahi Kasei Corporation) was 8.5 parts by mass, the content of the hydrogenated styrene thermoplastic elastomer (SEBS, Tuftec (trade name) H1043, Mn39000, available from Asahi Kasei Corporation) was 8.5 parts by mass, the content of a modified polyphenylene ether compound (available from SABIC Innovative Plastics, SA9000, functional group equivalent (double bond equivalent of vinyl group) was 1011 g/eq.) having a methacrylic group at a terminal was 17 parts by mass, the content of triallyl isocyanurate (available from Nihon Kasei CO., LTD., molecular weight: 249.7, number of terminal double bonds: 3) was 24 parts by mass, and the content of perbutyl P(α,α'-di(t-butylperoxy)diisopropylbenzene, available from NOF CORPORATION) was 0.5 parts by mass, in Example 1.

Example 13

The same procedure as in Example 1 was carried out, except that the maleimide compound (ma) was not blended, the content of the polyphenylene ether compound (B1) having a carbon-carbon unsaturated double bond at a terminal obtained in Synthesis Example 2 was 60 parts by mass, the hydrogenated styrene thermoplastic elastomer (SEPTON2104) was not blended, and the content of 1,2-polybutadiene (homopolymer) (B-3000 (trade name) available from Nippon Soda Co., Ltd.) was 20 parts by mass, in Example 1.

Example 14

The same procedure as in Example 1 was carried out, except that the maleimide compound (ma) was not blended, the content of the polyphenylene ether compound (B1) having a carbon-carbon unsaturated double bond at a terminal obtained in Synthesis Example 2 was 60 parts by mass, the hydrogenated styrene thermoplastic elastomer (SEPTON2104) was not blended, and the content of 1,2-vinyl group-containing SBS (1,2-H-SBS-partial hydrogenation (development product name) available from Nippon Soda Co., Ltd.) was 20 parts by mass, in Example 1.

Example 15

The same procedure as in Example 1 was carried out, except that the maleimide compound (ma) was not blended, the content of the polyphenylene ether compound (B1) having a carbon-carbon unsaturated double bond at a terminal obtained in Synthesis Example 2 was 60 parts by mass, the hydrogenated styrene thermoplastic elastomer (SEPTON2104) was not blended, and the content of 1,2-vinyl group-containing SBS (1,2-SBS-P35 (development product name) available from Nippon Soda Co., Ltd., Mn35000, pellet) was 20 parts by mass, in Example 1.

Comparative Example 1

The same procedure as in Example 1 was carried out, except that the resin (A) obtained in Synthesis Example 1 and the maleimide compound (ma) were not blended, 80 parts by mass of the polymer (va) having a structural unit represented by Formula (V) obtained in Synthesis Example 4 was blended, and the content of the hydrogenated styrene thermoplastic elastomer (SEPTON2104) was changed to 20 parts by mass, in Example 1.

Comparative Example 2

The same procedure as in Example 1 was carried out, except that the content of the resin (A) obtained in Synthesis Example 1 was 30 parts by mass, the maleimide compound (ma) and the hydrogenated styrene thermoplastic elastomer (SEPTON2104) were not blended, and 70 parts by mass of the polymer (va) having a structural unit represented by Formula (V) obtained in Synthesis Example 4 was blended, in Example 1.

Comparative Example 3

The same procedure as in Example 1 was carried out, except that the content of the resin (A) obtained in Synthesis Example 1 was 70 parts by mass, the maleimide compound (ma) was not blended, and the content of the hydrogenated styrene thermoplastic elastomer (SEPTON2104) was changed to 30 parts by mass, in Example 1.

Comparative Example 4

The same procedure as in Example 1 was carried out, except that the content of the resin (A) obtained in Synthesis Example 1 was 30 parts by mass, the content of the maleimide compound (ma) was 70 parts by mass, and the hydrogenated styrene thermoplastic elastomer (SEPTON2104) was not blended, in Example 1.

Comparative Example 5

The same procedure as in Example 1 was carried out, except that the content of the resin (A) obtained in Synthesis Example 1 was 30 parts by mass, the maleimide compound (ma) was not blended, and the content of the hydrogenated styrene thermoplastic elastomer (SEPTON2104) was changed to 70 parts by mass, in Example 1.

Comparative Example 6

The same procedure as in Example 1 was carried out, except that the resin (A) obtained in Synthesis Example 1 was not blended, the content of the maleimide compound (ma) was 80 parts by mass, and the content of the hydrogenated styrene thermoplastic elastomer (SEPTON2104) was changed to 20 parts by mass, in Example 1.

[Table 1]

| | Example 1 | Example 2 | Example 3 | Example 4 | Example 5 | Example 6 | Example 7 |
|---|---|---|---|---|---|---|---|
| Moldability | A | A | A | A | A | A | A |
| Dielectric properties | A | A | A | A | A | A | A |
| Peel strength | A | A | A | A | A | A | A |

[Table 2]

| | Comparative Example 1 | Comparative Example 2 | Comparative Example 3 | Comparative Example 4 | Comparative Example 5 | Comparative Example 6 |
|---|---|---|---|---|---|---|
| Moldability | A | A | C | A | B | A |
| Dielectric properties | A | A | - | C | - | C |
| Peel strength | B | B | - | A | - | A |

[Table 3]

| | Examples 8 | Examples 9 | Example 10 | Example 11 | Example 12 |
|---|---|---|---|---|---|
| Moldability | A | A | A | A | A |
| Dielectric properties | A | A | A | A | A |
| Peel strength | A | A | A | A | A |

[Table 4]

| | Example 13 | Example 14 | Example 15 |
|---|---|---|---|
| Moldability | A | A | A |
| Dielectric properties | A | A | A |
| Peel strength | A | A | A |

## Claims

**1.** A resin composition comprising:

a resin (A) represented by Formula (T1-1);
a thermoplastic elastomer (B); and
a thermosetting compound (C) other than the resin (A),
wherein, in the resin (A), a parameter β calculated from Equation (β) is 0.20 or more and 3.00 or less,

[Chem.1]

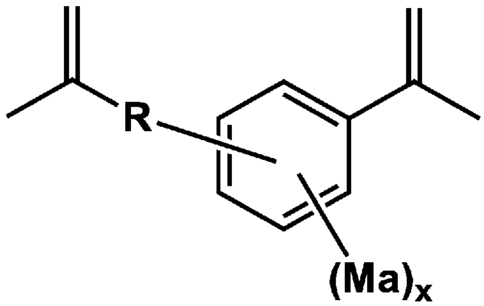

(T1-1)

(where R is a group including a structural unit represented by Formula (Tx), each Ma independently represents a hydrocarbon group having from 1 to 12 carbon atoms, each carbon atom being optionally substituted with a halogen atom, and x is an integer of from 0 to 4.)

[Chem.2]

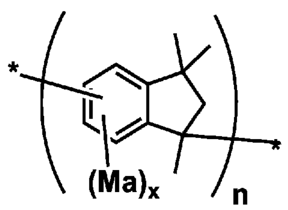

(a)

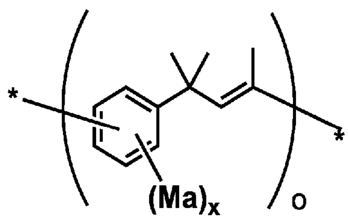

(b)

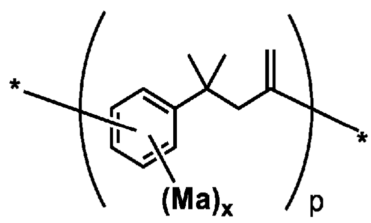

(c)

(Tx)

(where n, o, and p are average numbers of repeating units, n represents a number of more than 0 and 20 or less, o and p each independently represent a number of from 0 to 20, and $1.0 \leq n + o + p \leq 20.0$, each Ma independently represents a hydrocarbon group having from 1 to 12 carbon atoms, each carbon atom being optionally substituted with a halogen atom, x represents an integer of from 0 to 4, and structural units (a), (b), and (c) are each bonded to the structural unit (a), (b), or (c), or an additional group by *, and structural units are optionally randomly bonded.)
[Num.1]

$$\text{PARAMETER}\,\beta = \frac{\{(5.49ppm \text{ to } 4.89ppm) - (4.89ppm \text{ to } 4.45ppm)\} \times 1.5}{(2.31ppm \text{ to } 1.96ppm) - (2.55ppm \text{ to } 2.31ppm)} \quad (\beta)$$

(where expressions in parentheses indicate integral values between corresponding chemical shift values in $^1$H-NMR.)

2. The resin composition according to claim 1, wherein, in the resin (A), a parameter α calculated from Equation (α) is 0.55 or more and 1.00 or less,
[Num.2]

$$\text{PARAMETER}\,\alpha = \frac{(2.55ppm \text{ to } 2.31ppm)}{(6.24ppm \text{ to } 5.91ppm) + (2.98ppm \text{ to } 2.55ppm)/2 + (2.55ppm \text{ to } 2.31ppm)} \quad (\alpha)$$

(where expressions in parentheses indicate integral values between corresponding chemical shift values in $^1$H-NMR.)

3. The resin composition according to claim 1, wherein, in the resin (A), the parameter α calculated from Equation (α) is 0.60 or more and 1.00 or less, and the parameter β calculated from Equation (β) is 0.40 or more and 3.00 or less.

4. The resin composition according to any one of claims 1 to 3, wherein the structural unit represented by Formula (Tx) satisfies $1.1 \leq n + o + p \leq 20.0$.

**5.** The resin composition according to any one of claims 1 to 3, wherein a number average molecular weight of the resin (A) is from 400 to 3000.

**6.** The resin composition according to any one of claims 1 to 3, wherein a weight average molecular weight of the resin (A) is from 500 to 6000.

**7.** The resin composition according to any one of claims 1 to 3, wherein Mw/Mn is a ratio of a weight average molecular weight of the resin (A) to a number average molecular weight of the resin (A), and is from 1.1 to 3.0.

**8.** The resin composition according to any one of claims 1 to 3, wherein the thermoplastic elastomer (B) includes at least one selected from the group consisting of a styrene monomer unit, a butadiene monomer unit, an isoprene monomer unit, a hydrogenated butadiene monomer unit, and a hydrogenated isoprene monomer unit.

**9.** The resin composition according to any one of claims 1 to 3, wherein the thermoplastic elastomer (B) includes a styrene monomer unit, a hydrogenated butadiene monomer unit, and/or a hydrogenated isoprene monomer unit.

**10.** The resin composition according to any one of claims 1 to 3, wherein a number average molecular weight of the thermoplastic elastomer (B) is 2000 or more.

**11.** The resin composition according to any one of claims 1 to 3, wherein the thermoplastic elastomer (B) is included in a proportion of from 2.5 to 50 parts by mass with respect to 100 parts by mass of a resin solid content in the resin composition.

**12.** The resin composition according to any one of claims 1 to 3, wherein the thermosetting compound (C) includes at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, a compound having an indane skeleton having a carbon-carbon unsaturated double bond at a terminal other than the resin (A), an epoxy compound, a phenolic compound, an oxetane compound, a benzoxazine compound, a cyanate ester compound, and a compound having a vinylene group,

[Chem.3]

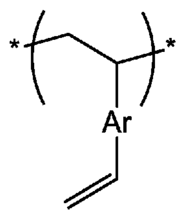

(V)

(where Ar represents an aromatic hydrocarbon linking group; and * represents a bonding position.)

**13.** The resin composition according to any one of claims 1 to 3, wherein the thermosetting compound (C) includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP),

[Chem.4]

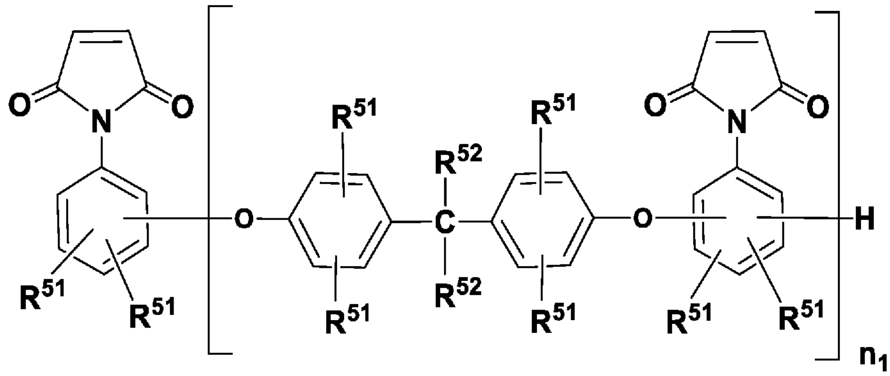

(M0)

(where each $R^{51}$ independently represents a hydrogen atom, an alkyl group having from 1 to 8 carbon atoms, or a phenyl group; and each $R^{52}$ independently represents a hydrogen atom or a methyl group; and $n_1$ represents an integer of 1 or more.)

[Chem.5]

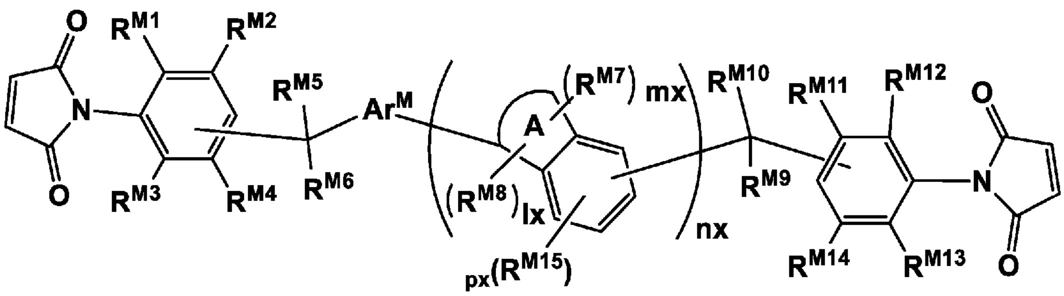

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^{M}$ represents a divalent aromatic group, A is a four- to six-membered alicyclic group, $R^{M7}$ and $R^{M8}$ are each independently an alkyl group, mx is 1 or 2, and lx is 0 or 1, $R^{M9}$ and RM$^{10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from 1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.6]

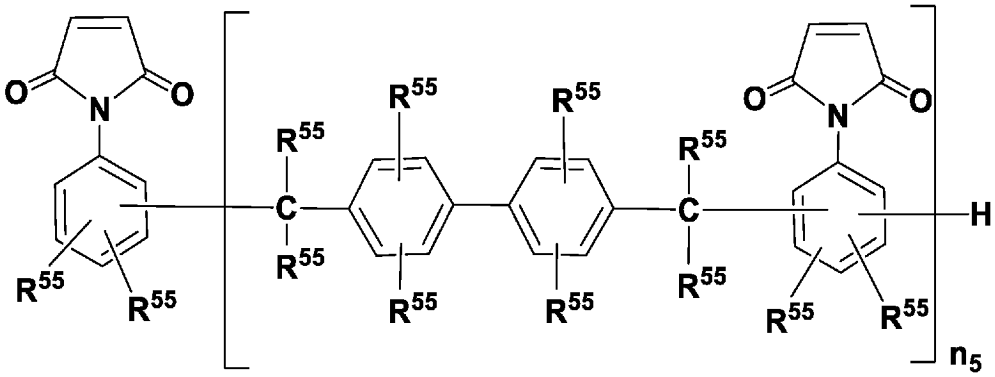

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.7]

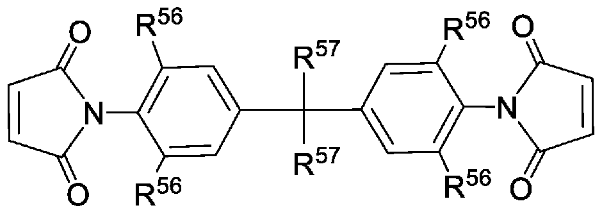

(M4)

(where each $R^{56}$ independently represents a hydrogen atom, a methyl group, or an ethyl group, and each $R^{57}$ independently represents a hydrogen atom or a methyl group.)

[Chem.8]

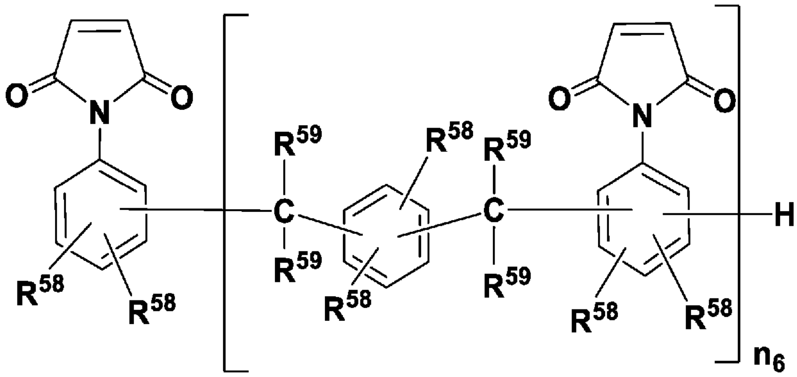

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.9]

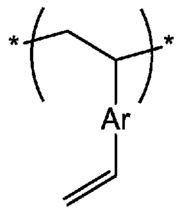

(V)

(where Ar represents an aromatic hydrocarbon linking group, and * represents a bonding position.)

[Chem.10]

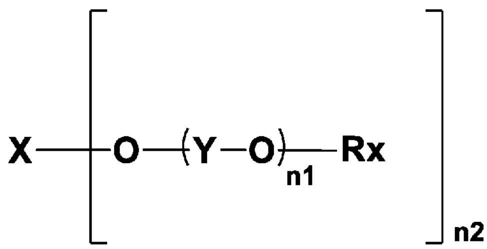

(OP)

(where X represents an aromatic group; $-(Y-O)_{n1}-$ represents a polyphenylene ether structure; n1 represents an integer of from 1 to 100; n2 represents an integer of from 1 to 4, Rx is a group represented by Formula (Rx-1) or Formula (Rx-2).)

[Chem.11]

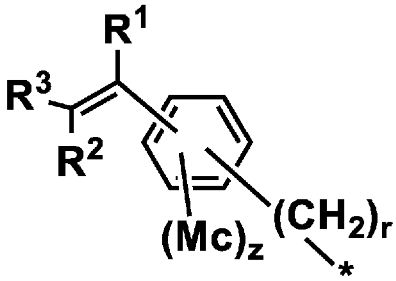
(Rx-1)

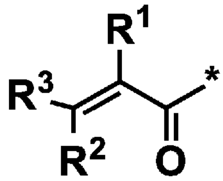
(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

**14.** The resin composition according to any one of claims 1 to 3, wherein from 1 to 90 parts by mass of the resin (A) and from 5 to 90 parts by mass of the thermosetting compound (C) are included with respect to 100 parts by mass of the resin solid content in the resin composition.

**15.** The resin composition according to claim 1, wherein, in the resin (A), the parameter $\alpha$ calculated from the Equation ($\alpha$) is 0.60 or more and 1.00 or less,

the parameter $\beta$ calculated from the Equation ($\beta$) is 0.40 or more and 3.00 or less,
the structural unit represented by the Formula (Tx) satisfies $1.1 \leq n + o + p \leq 20.0$,
a number average molecular weight of the resin (A) is from 400 to 3000,
a weight average molecular weight of the resin (A) is from 500 to 6000,
Mw/Mn is a ratio of the weight average molecular weight of the resin (A) to the number average molecular weight of the resin (A), and is from 1.1 to 3.0,
the thermoplastic elastomer (B) includes a styrene monomer unit,
a hydrogenated butadiene monomer unit, and/or a hydrogenated isoprene monomer unit,
a number average molecular weight of the thermoplastic elastomer (B) is 2000 or more,
the thermoplastic elastomer (B) is included in a proportion of from 2.5 to 50 parts by mass with respect to 100 parts by mass of the resin solid content in the resin composition,
the thermosetting compound (C) includes at least one selected from the group consisting of a maleimide compound, a polymer having a structural unit represented by Formula (V), a polyphenylene ether compound having a carbon-carbon unsaturated double bond at a terminal, a (meth)allyl compound, a (meth)acrylate compound, a compound having an indane skeleton having a carbon-carbon unsaturated double bond at a terminal other than the resin (A), an epoxy compound, a phenolic compound, an oxetane compound, a benzoxazine compound, a cyanate ester compound, and a compound having a vinylene group, and
from 1 to 90 parts by mass of the resin (A) and from 5 to 90 parts by mass of the thermosetting compound (C) are included with respect to 100 parts by mass of the resin solid content in the resin composition,
[Num.3]

$$\text{PARAMETER}\,\alpha = \frac{(2.55ppm \text{ to } 2.31ppm)}{(6.24ppm \text{ to } 5.91ppm) + (2.98ppm \text{ to } 2.55ppm)/2 + (2.55ppm \text{ to } 2.31ppm)} \quad (\alpha)$$

(where expressions in parentheses indicate integral values between corresponding chemical shift values in $^1$H-NMR.)
[Num.4]

$$\text{PARAMETER}\,\beta = \frac{\{(5.49ppm \text{ to } 4.89ppm) - (4.89ppm \text{ to } 4.45ppm)\} \times 1.5}{(2.31ppm \text{ to } 1.96ppm) - (2.55ppm \text{ to } 2.31ppm)} \quad (\beta)$$

(where expressions in parentheses indicate integral values between corresponding chemical shift values in $^1$H-NMR.)

[Chem.12]

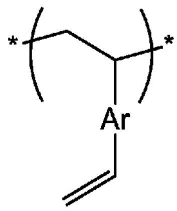

(V)

(where Ar represents an aromatic hydrocarbon linking group; and * represents a bonding position.)

**16.** The resin composition according to claim 15, wherein the thermosetting compound (C) includes at least one selected from the group consisting of a compound represented by Formula (M0), a compound represented by Formula (M1), a compound represented by Formula (M3), a compound represented by Formula (M4), a compound represented by Formula (M5), a polymer having a structural unit represented by Formula (V), and a compound represented by Formula (OP),

[Chem.13]

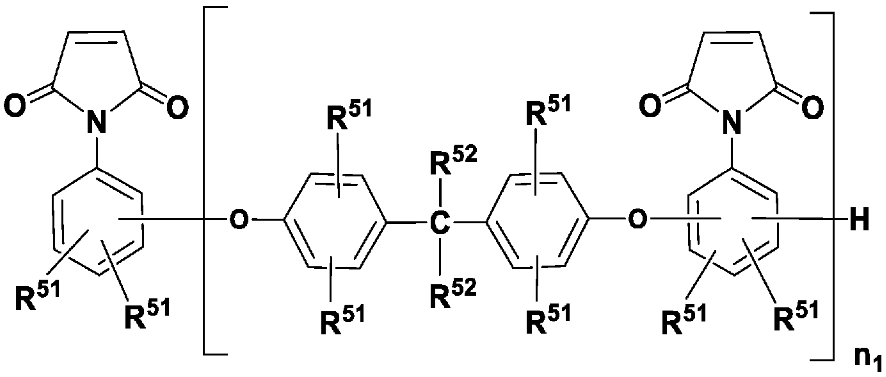

(M0)

(where each $R^{51}$ independently represents a hydrogen atom, an alkyl group having from 1 to 8 carbon atoms, or a phenyl group; each $R^{52}$ independently represents a hydrogen atom or a methyl group; and $n_1$ represents an integer of 1 or more.)

[Chem.14]

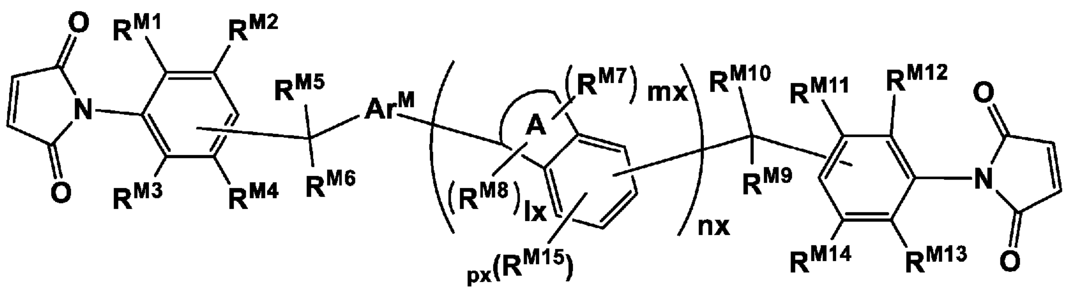

(M1)

(where $R^{M1}$, $R^{M2}$, $R^{M3}$, and $R^{M4}$ each independently represent a hydrogen atom or an organic group, $R^{M5}$ and $R^{M6}$ each independently represent a hydrogen atom or an alkyl group, $Ar^M$ represents a divalent aromatic group, A is a four- to six-membered alicyclic group, $R^{M7}$ and $R^{M8}$ are each independently an alkyl group, mx is 1 or 2, 1x is 0 or 1, $R^{M9}$ and $R^{M10}$ each independently represent a hydrogen atom or an alkyl group, $R^{M11}$, $R^{M12}$, $R^{M13}$, and $R^{M14}$ each independently represent a hydrogen atom or an organic group, each $R^{M15}$ independently represents an alkyl group having from 1 to 10 carbon atoms, an alkyloxy group having from 1 to 10 carbon atoms, an alkylthio group having from

1 to 10 carbon atoms, a cycloalkyl group having from 3 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of from 0 to 3, and nx represents an integer of from 1 to 20.)

[Chem.15]

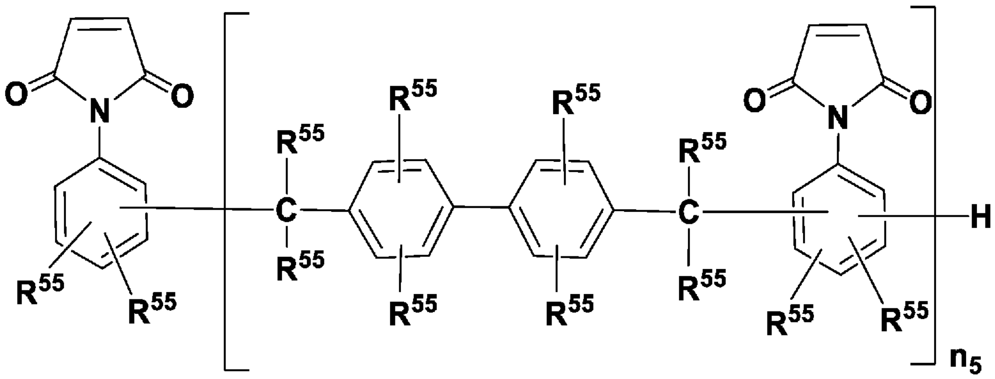

(M3)

(where each $R^{55}$ independently represents a hydrogen atom, an alkyl group having from 1 to 8 carbon atoms, or a phenyl group; and $n_5$ represents an integer of 1 or more and 10 or less.)

[Chem.16]

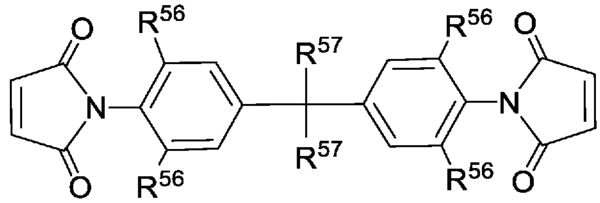

(M4)

(where each $R^{56}$ independently represents a hydrogen atom, a methyl group, or an ethyl group, and each $R^{57}$ independently represents a hydrogen atom or a methyl group.)

[Chem.17]

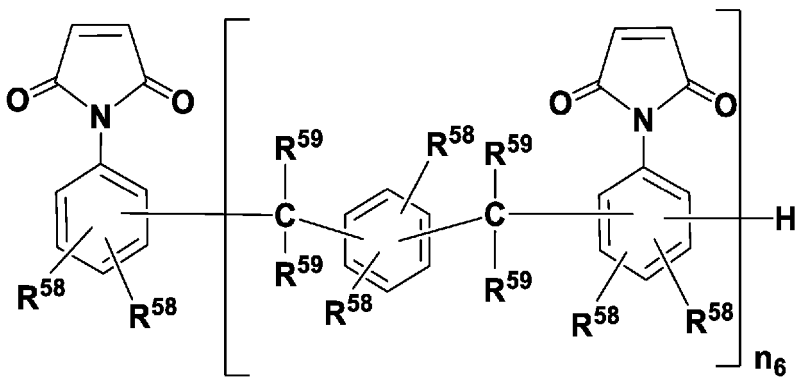

(M5)

(where each $R^{58}$ independently represents a hydrogen atom, an alkyl group having from 1 to 8 carbon atoms, or a phenyl group; each $R^{59}$ independently represents a hydrogen atom or a methyl group; and $n_6$ represents an integer of 1 or more.)

[Chem.18]

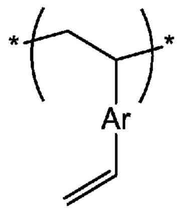

(V)

(where Ar represents an aromatic hydrocarbon linking group, and * represents a bonding position.)

[Chem.19]

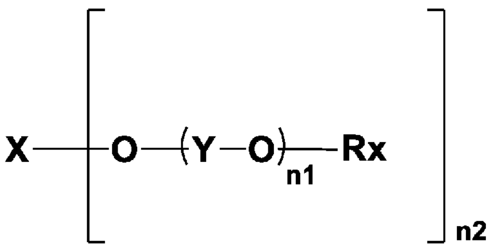

(OP)

(where X represents an aromatic group; $-(Y-O)_{n1}-$ represents a polyphenylene ether structure; n1 represents an integer of from 1 to 100; n2 represents an integer of from 1 to 4, and Rx is a group represented by Formula (Rx-1) or Formula (Rx-2).)

[Chem.20]

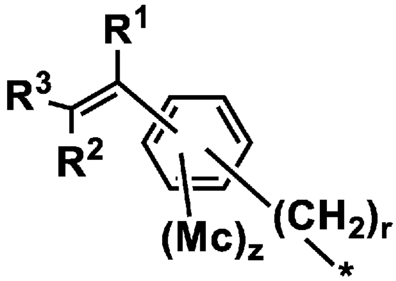

(Rx-1)

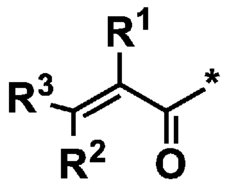

(Rx-2)

(where $R^1$, $R^2$, and $R^3$ each independently represent a hydrogen atom, an alkyl group, an alkenyl group, or an alkynyl group, * is a bonding position for an oxygen atom, each Mc independently represents a hydrocarbon group having from 1 to 12 carbon atoms, z represents an integer of from 0 to 4, and r represents an integer of from 0 to 6.)

**17.** The resin composition according to claim 1, 2, 3, 15, or 16, further comprising a flame retardant.

**18.** The resin composition according to claim 1, 2, 3, 15, or 16, further comprising a filler.

**19.** The resin composition according to claim 18, wherein a content of the filler is from 10 to 1600 parts by mass with respect to 100 parts by mass of the resin solid content in the resin composition.

**20.** The resin composition according to claim 1, 2, 3, 15, or 16, further comprising a curing accelerator.

**21.** The resin composition according to claim 20, wherein a content of the curing accelerator is from 0.1 to 0.8 parts by mass with respect to 100 parts by mass of a resin solid content in the resin composition.

**22.** A cured product of the resin composition described in claim 1, 2, 3, 15, or 16.

**23.** A prepreg comprising a substrate and the resin composition described in claim 1, 2, 3, 15, or 16.

**24.** A metal foil-clad laminate comprising at least one layer formed from the prepreg described in claim 23 and a metal foil disposed on one side or both sides of the layer formed from the prepreg.

**25.** A resin composite sheet comprising:

a support; and
a layer disposed on a surface of the support, the layer being formed from the resin composition described in claim 1, 2, 3, 15, or 16.

**26.** A printed wiring board comprising:

an insulating layer; and
a conductor layer disposed on a surface of the insulating layer,
wherein the insulating layer includes a layer formed from the resin composition described in claim 1, 2, 3, 15, or 16.

**27.** A semiconductor device comprising the printed wiring board described in claim 26.

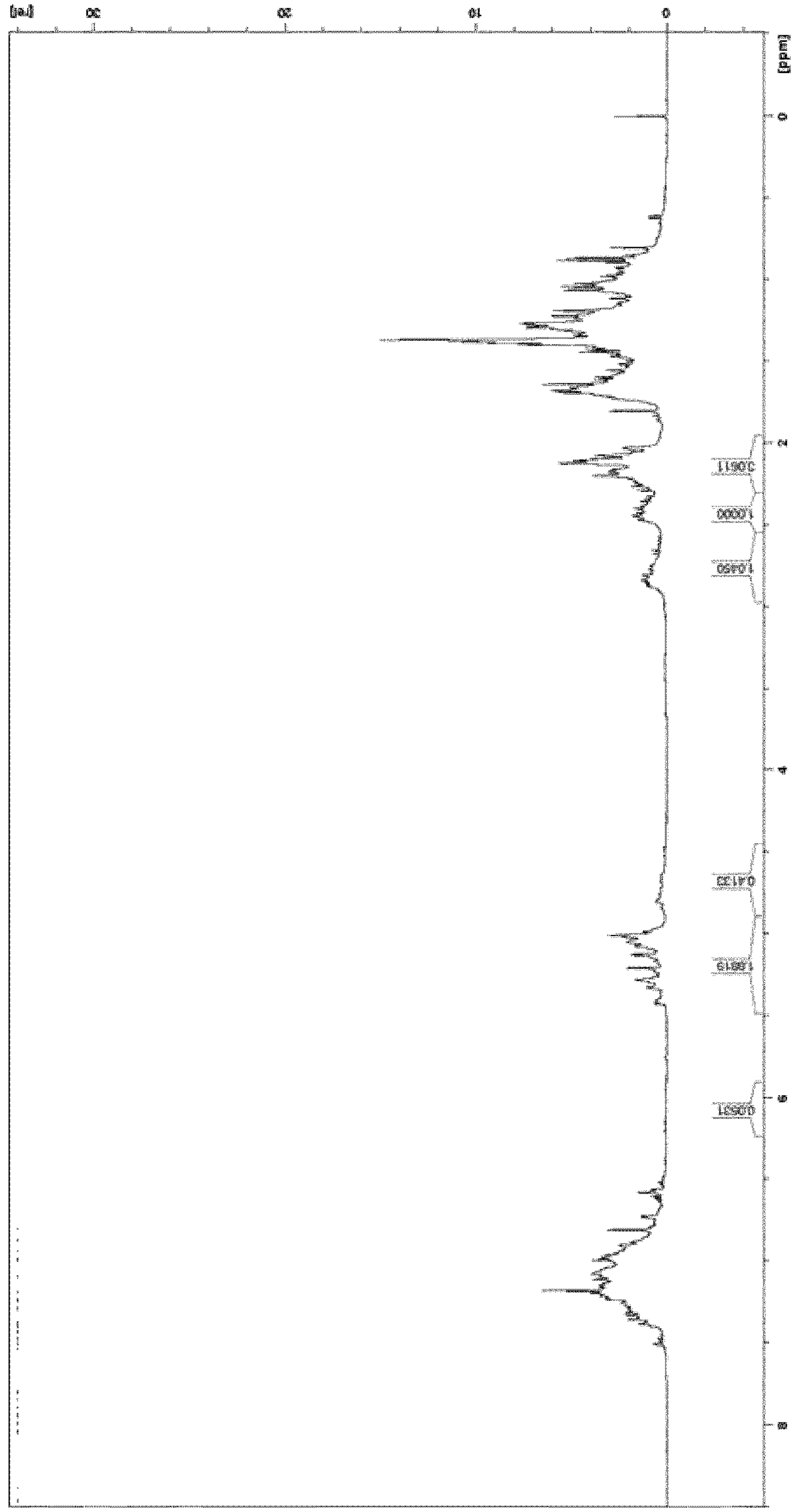

FIG. 1

## INTERNATIONAL SEARCH REPORT

International application No.
**PCT/JP2024/032722**

### A. CLASSIFICATION OF SUBJECT MATTER

***C08L 25/02***(2006.01)i; ***B32B 15/08***(2006.01)i; ***C08F 257/00***(2006.01)i; ***C08F 290/06***(2006.01)i; ***C08F 299/02***(2006.01)i; ***C08G 65/48***(2006.01)i; ***C08J 5/24***(2006.01)i; ***C08L 53/02***(2006.01)i; ***C08L 101/00***(2006.01)i; ***H05K 1/03***(2006.01)i
FI: C08L25/02; C08F290/06; C08F299/02; C08G65/48; B32B15/08 U; H05K1/03 610H; H05K1/03 630H; C08L101/00; C08L53/02; C08F257/00; C08J5/24 CEZ

According to International Patent Classification (IPC) or to both national classification and IPC

### B. FIELDS SEARCHED

Minimum documentation searched (classification system followed by classification symbols)

C08L25/02; B32B15/08; C08F257/00; C08F290/06; C08F299/02; C08G65/48; C08J5/24; C08L53/02; C08L101/00; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-143333 A (NIPPON KAYAKU KABUSHIKI KAISHA) 24 September 2021 (2021-09-24) | 1-27 |
| A | JP 02-219809 A (AKZO NV) 03 September 1990 (1990-09-03) | 1-27 |
| A | JP 03-252441 A (HERCULES INCORPORATED) 11 November 1991 (1991-11-11) | 1-27 |
| A | US 4205160 A (GOODYEAR TIRE & RUBBER) 27 May 1980 (1980-05-27) | 1-27 |
| P, X | WO 2023/176766 A1 (MITSUBISHI GAS CHEMICAL COMPANY, INC.) 21 September 2023 (2023-09-21)<br>claims, paragraphs [0030]-[0074], [0160]-[0178], [0204]-[0205], [0210]-[0211] | 1-27 |

☐ Further documents are listed in the continuation of Box C.　　☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **08 October 2024** | **22 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

**INTERNATIONAL SEARCH REPORT**
**Information on patent family members**

International application No.
**PCT/JP2024/032722**

| Patent document cited in search report | Publication date (day/month/year) | Patent family member(s) | Publication date (day/month/year) |
|---|---|---|---|
| JP 2021-143333 A | 24 September 2021 | (Family: none) | |
| JP 02-219809 A | 03 September 1990 | US 5091479 A<br>EP 374999 A2 | |
| JP 03-252441 A | 11 November 1991 | US 5049615 A<br>EP 432696 A2<br>KR 10-1991-0012047 A | |
| US 4205160 A | 27 May 1980 | (Family: none) | |
| WO 2023/176766 A1 | 21 September 2023 | TW 202346398 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021143333 A
- WO 2023176766 A
- WO 2023176763 A
- WO 2023176765 A
- JP 2023104785 A
- JP 2024007493 A
- JP 2019194312 A
- JP 2022085610 A
- WO 2017126469 A
- WO 2020262577 A
- JP 7160151 B
- JP 2018039995 A
- WO 2017115813 A
- JP 2018168347 A
- JP 2006070136 A
- JP 2006089683 A
- JP 2008248001 A
- JP 2006028111 A
- JP 2018131519 A
- WO 2019138992 A
- WO 2022054303 A
- WO 2022210095 A
- JP 6962507 B
- WO 2023089976 A
- WO 2022234455 A
- WO 2022014599 A
- WO 2021100658 A
- JP 2024086554 A
- JP 2022180443 A
- JP 2022180444 A
- JP 2023009587 W
- JP 2024110099 A
- JP 6951829 B
- WO 2021172317 A
- JP 2021021027 A